# EUROPEAN PATENT APPLICATION

(11) **EP 2 420 476 A1**
(43) Date of publication of application: **22.02.2012**
(21) Application number: 09841869.2
(22) Date of filing: 19.03.2009
(51) Int. Cl.: C01G 43/025

(54) **ACTINOID OXIDE CRYSTAL MANUFACTURING METHOD**

(71) Applicant: Tohoku University, Aoba-ku Sendai-shi Miyagi 980-8577 (JP)
(72) Inventor: YAMAMURA, Tomoo, Miyagi 980-8577 (JP); SHIRASAKI, Kenji, Miyagi 980-8577 (JP); SATOH, Isamu, Miyagi 980-8577 (JP); TOMIYASU, Hiroshi, Miyagi 980-8577 (JP); MORI, Tomonori, Miyagi 980-8577 (JP)
(74) Representative: Behnisch, Werner
(86) International application number: PCT/JP2009/055458
(87) International publication number: WO 2010/106664

(57) **Abstract**

A method for manufacturing an actinide oxide particle having a fluorite crystal structure according to the invention is provided, the method including mixing an actinide solution and an organic material; placing the actinide solution mixed with the organic material under high temperature and high pressure environment; and cooling the actinide solution mixed with the organic material.

## Description

### Technical Field

The present invention relates to a method for manufacturing an actinide oxide crystal having a fluorite crystal structure and relates to the actinide oxide crystal having a fluorite crystal structure itself, which crystal being produced by this method. In particular, the present invention relates to a method for manufacturing actinide oxide crystal having the fluorite crystal structure under a high temperature and high pressure condition in actinide solution, wherein the actinide oxide crystal may be used as fuel in nuclear power generation using nuclear fission phenomena.

### Background Art

Nuclear power generation has been interested as a method for generating electric power which may replace the thermal power generation, since nuclear power generation meets an environmental economic requirement such as the low carbon dioxide emission. Although nuclear power generation may have a high environmental integrity, it has problems such as economy, environmental integrity, integrity resources, and nuclear proliferation resistance.

In one of the conventional preparation method for manufacturing fuel actinide oxides, actinide solution such as uranium solution, plutonium solution (UF₆, U₃O₈, Pu(NO₃)₄) and etc. was prepared, and then, using coprecipitation method, a precipitate may be generated by adding actinide oxalate solution (in the oxalic acid precipitation method), ammonia (in the ADU method), ammonia and carbon dioxide method (in the AUC method), hydrogen peroxide (in the H₂O₂ method) to the prepared actinide solution. The obtained actinide oxides would be subjected with a roasting-and-reduction process to produce actinide oxide crystal, and the actinide oxide may be crushed and granulated to adjust the size of the crystal. Therefore, there should be needed to be combined multi-stage reactions to produce the actinide oxide in this way, and the control of crystal size of the actinide oxide crystal do not have been in the course of chemical reactions but has been carried out in a separate step.

Another conventional preparation method for manufacturing actinide oxide fuel includes, as the solvent evaporation method, heating and denitrating actinide solution by applying microwave directly to crystallize the actinide (in the MH method), spraying an actinide solution onto the fluidized bed to denitrate by the thermal decomposition and crystallize (in the fluidized bed method), crushing and granulating the resulting actinide oxide to adjust the size of the crystals, but the method includes steps that includes multi-step reactions to prepare actinide oxide fuel. That is, control of the size of the actinide oxide crystal may not be performed in a chemical reaction process, but in another process other than chemical reaction processes. In the conventional method, the control of crystalline of actinide oxide fuel has not been made in any chemical reaction processes.

In addition, nuclear power production methods mainly utilizes light-water reactor that uses cooling water, and light water reactors uses uranium dioxide as a fuel recently. However, uranium oxide includes, in addition to uranium dioxide, triuranium octoxide, for example, and hence a process is needed for separating uranium dioxide from a plurality of uranium oxides.

In addition, in the light water reactor, only uranium-235, which is included in only 0.7% of natural uranium (U) is used as fuel. As far as using only the uranium-235 is used in nuclear power plants, it is expected that such resource may be exhausted in these decades. However, if you are able to use uranium-238 that may be the majority of naturally occurring uranium in nuclear power plants, its energy can potentially cause hundreds of years to understand nuclear power.

However, in order to take advantage of nuclear power for a long term stably, uranium as the rest of the fire burning and plutonium (Pu) that were generated in the fire burning should be collected from the spent nuclear fuel used in light water reactors, and need to be recycled in fast breeder reactors. This nuclear fuel recycling may be a key factor for closing this cycle, and the reprocessing technology is one of the important technologies to complete the nuclear fuel cycle.

One of the reprocessing technologies, which is currently commercialized, is the Purex method. The Purex method includes step for melting the spent fuel in nitric acid solution to extract the actinides such as uranium and plutonium. However, when the Purex method is used as a reprocessing method, it may be suitable for processing large amounts of fuel, but the economy are not necessarily better due to the maintenance of complex piping and discharge large amounts of organic radioactive waste. Further, because a process such as process for dissolving in high temperature and high density nitric acid may be included, treatment may be dangerous.

Asano et al., in PROGRESS in NUCLEAR ENERGY VOL. 29, pp. 243-249 (1995), in order to improve the shortcomings of the above-described conventional Purex method, methods that can be curried out in simple engineering processes ware discussed. In such methods, for example, fuel uranium is dissolved in carbonic acid solution to control the production of waste acid, or mild treatment conditions is achieved by treating the solution at room temperature and normal pressure. In this way, for example, uranium and plutonium may be eluted as uranium carbonate and plutonium complex, respectively, and most of the other transuranic waste and nuclide from fission products such as rare earth metal may be precipitated as hydrolyzed species or carbonate species so that dissolution and fission products (FP) separation may be carried out at the same time.

Further, Asano et al. in NUCL. TECHNOL. VOL. 120, pp. 198-210 (1997), found that when spent nuclear fuel of nuclear power generation is dissolved in carbonic acid solution, many species of fission products such as rare earth metal such as lanthanum, cerium, lutetium, scandium, and yttrium, platinum group metal such as ruthenium, rhodium, palladium, osmium, iridium, and platinum, and alkaline earth metal such as calcium, strontium and barium may be deposited as hydroxide precipitate or carbonate, and may be dissolved in solution by forming a specific actinide carbonate complexe when actinide such as uranium is adjusted to the pentavalent or hexavalent oxidation state. However, it was found that alkali metal such as cesium, rubidium, and sodium can be dissolved in solution, similar to the case of actinide. That is, there may be no known method for separating actinide oxide from spent nuclear fuel of nuclear power generation.

In WO2004/007350 it is disclosed a method for manufacturing metal oxide particles using supercritical hydrothermal synthesis, which has been developed and evolved by Ajiri et al., because fluid properties such as ionic product, dielectric constant, diffusion rate, thermal conductivity have significant changes under supercritical or subcritical conditions of water, a shape and a size of metal oxide particle would be controlled easily by controlling the reaction pathways and kinetics. Further, the supercritical or subcritical conditions may be characterized by a large thermal conductivity compared to the gas phase, thereby resulting in the very larger diffusion coefficient when compared to the liquid phase. Therefore, it is possible to achieve an uniform reaction condition in the reactor, and it would be expected that an increase of the size distribution of the particles and variation in the shape of the particles which may be caused by the temperature gradient, pressure gradient, the concentration variation, would be prevented.
In a hydrothermal reaction, when a metal is indicated by a symbol M, the hydrothermal reaction represented as:

M (NO₃)ₓ + xH₂O → M (OH)ₓ + xHNO₃ (1)

M (OH)ₓ → MO_{x/2} + (x / 2) H₂O (2)

may proceed.
According to the method of manufacturing metal oxide particle disclosed in W02004/007350, it is possible to synthesize a fine particle having 1 to 1000 nm of a particle size by reacting water, at least one water-soluble metal nitrates, and ammonia or ammonium salts under supercritical or subcritical conditions of water in a reactor, or preferably in a continuous reactor. In particular, fine particles are those of metal oxide, and metal that can be used for the synthesis of metal oxide includes actinide.

Furthermore, according to the method of manufacturing metal oxide particles disclosed in W02004/007350, size, shape, physical characteristics of particles to be synthesized, and the synthesis rate can be controlled by adding alkaline solution of potassium hydroxide or an acidic solution such as sulfuric acid into a mixture of reaction components before or during the synthesis of metal oxide particles. In addition, a reducing agent such as hydrogen or an oxidizing agent such as oxygen and hydrogen peroxide can be added into a mixture of reaction components before or during the synthesis of metal oxide particle.

Further, Japanese Patent No. 3047110 and the corresponding U.S. Patent No. 5480630 and U.S. Patent No. 5635154 disclose a method of manufacturing metal oxide particles from a metal salt.

In the above publications, a method for manufacturing metal oxide particles is disclosed, in which method, an aqueous solution of metal salts may be processed under the supercritical or subcritical water conditions, i.e., the temperature of over 200 degree and the pressure more than 160kg/cm3, and the metal oxide fine particles may be produced by decomposition of metal salts.
Furthermore, in the above mentioned method, the reaction conditions may be changed by adding an alkaline aqueous solution including ammonia, sodium hydroxide, potassium hydroxide, or inorganic phosphoric acid such as sulfuric acid, nitric acid, hydrochloric acid, carbonic acid, phosphoric acid or other aqueous acid solution including organic acids such as lactic acid including formic acid, acetic acid, citric acid, oxalic acid, lactic acid into metal salt aqueous solution, so that metal oxide particles with uniform particle size and shape can be obtained. Further, the concentration of material, introducing a reducing or oxidizing gas, reaction temperature and reaction pressure can be considered as reaction conditions.

In addition, Japanese Patent No. JP 3663408 discloses a method and apparatus for manufacturing fine particles using a high temperature and pressure water.

In the above mentioned publication mentioned above, a method for manufacturing a fine particle using a high temperature and high pressure water is disclosed, wherein water may be heated and pressurized by heating and pressurizing means into the high temperature and high pressure water that may be in a supercritical or subcritical state, and this high temperature and high pressure water may be joined with fluid material at a mixing portion to guide to a reactor, and before the fluid material is mixed with the high temperature and high pressure water, the fluid material may be cooled to a temperature lower than the critical temperature of water.

The above method, the fluid material may be cooled to a temperature lower than the critical temperature of water, that is, 374 degree Celsius, before the fluid material is mixed with the high temperature and high pressure water. Thus, because water included in the fluid material may not become supercritical water, the fluid material and the fluid material may be mixed with the supercritical or subcritical high temperature and high pressure water, the fluid material may be heated by contacting with a heat included in the high temperature and high pressure water quickly such that a desired chemical reaction may be initiated and progressed.

In addition, when the fluid material is cooled to a temperature lower than the solid precipitation temperature of the mixture of the fluid material and the high temperature and high pressure water before the fluid material is mixed with the high temperature and high pressure water it may be possible to prevent the solid precipitation of a raw material in the fluid material from occurring. In particular, when metal salts such as sulfate, hydrochloride, nitrate, acetate and the like is used as the fluid material, a metal oxide can be obtained. After the fluid material may be mixed with high temperature and high pressure water, the fluid material would be heated to initiate and progress a desired chemical reaction, and a core material is generated and grow to a fine particle.

### Disclosure of the Invention

### Problems to be solved by the Invention

In a fuel pellet used for nuclear fission power generation, it is preferable that it is made of a specific type of actinide oxide particle, and the particle size and shape of actinide oxide are aligned. However, if any one of the conventional methods for manufacturing a metal particle as described above is applied to the manufacture of actinide oxide particle, there is a problem in which controlling of the type of crystalline actinide oxide particle and shape or size of particle in a chemical reaction cannot have been made.

Furthermore, in general, actinide atom can take a variety of oxidation number, and multiple oxides can be formed accordingly. However, when any one of the conventional methods for manufacturing metal particle as described above is applied to manufacture of actinide oxide particle, no method for selecting a desired oxide from the multiple oxides in a chemical reaction is known.

For example, uranium dioxide (UO₂) uranium trioxide (UO₃) triuranium octoxide (U₃O₈), uranium peroxide (UO₄.H₂O) is present as uranium oxide. Uranium (U) can be trivalent or divalent uranium ion U³⁺, U⁴⁺, or pentavalent or hexavalent uranium ion U^{V}O₂⁺, or U^{VI}O₂²⁺ may be present as the hexavalent uranium ion ion. However, U³⁺ of them is unstable to generate hydrogen by reducing the water, and U^{V}O₂⁺ is also unstable because disproportionation into U⁴⁺ and U^{VI}O₂²⁺ may be progressed;

2U^{V}O₂⁺ +4 H⁺ → U⁴⁺ + U^{VI}O₂²⁺ +2 H₂O (3).

Form these U⁴⁺ and UO₂²⁺, U₃O₈ and UO₂ may be generated;

U⁴⁺ +4 H₂O → U (OH)₄ +4 H⁺ (4)

U (OH)₄ → UO₂ +2 H₂O (5)

UO₂²⁺ +2 H₂O → UO₂ (OH)₂ +2 H⁺ (6)

UO₂²⁺ + H₂O → UO₃.H₂O +4 H⁺ (7)

3UO₂ (OH)₂ → U₃O₈ +3 H₂O (8)

3UO₃.H2O → U₃O₈ +3 H₂O (9)

In fact, Sato et al. in J. Nucl. Sci. Technol. Vol. 37p. 1003 (2000) reported that in a supercritical ethanol being 250 degree Celsius and 40MPa of high pressure and temperature ethanol, mixture of uranium dioxide (UO₂ and triuranium octoxide (U₃O₈) may be produced.

Actinide oxides used in power generation using nuclear fission is uranium dioxide (UO₂). But when any one of the conventional methods for manufacturing metal particles as described above is applied to an actinide oxide, there may need to select a desired oxide from multiple oxides such as uranium dioxide (UO₂), triuranium octoxide (U₃O₈) , but such method is not known.

Uranium dioxide has a characteristic that it has a fluorite type crystal structure, and may be distinguished other uranium oxides by this characteristic. This fact may suggest that, while oxide formation reaction is proceed selectively controlling the crystal form, it may be able to separate the uranium dioxide from various uranium oxides. However, such methods are not yet known.

In the manufacturing method of metal oxide particles described in JP WO2004/007350, no method for selecting a desired actinide oxide from multiple oxides of an actinide.

In the method for manufacturing metal oxide particles described in WO2004/007350, no embodiment in which the shape of the metal oxide particle by adding acidic or alkaline solution such as sulfuric acid and potassium hydroxide to a mixture of reaction components may be changed is disclosed. That is, there is a problem in which crystalline as well as particle size of a metal oxide particle or a metal oxide crystal cannot be controlled. Moreover, when manufacturing an uranium oxide as a metal oxide, no method for manufacturing only uranium dioxide is disclosed. In addition, if the production of actinide oxide such as uranium dioxide as a metal oxide, it has not been disclosed how to adjust an actinide-oxygen ratio. In particular, when uranium dioxide is manufactured, and no method by which the uranium-oxygen ratio (U/O ratio) is adjusted to about 2.04 for fuel production have not been disclosed.

Further, in a method disclosed in Japanese Patent No. 3047110 and corresponding U.S. Patent No. 5480630 and U.S. Patent No. 5635154, no embodiment for manufacturing method of fine particle using high temperature and high pressure water is disclosed in which shape of metal oxide particle may be changed depending on a hydroxide solution such as alkaline solution or an acidic solution such as sulfuric acid and potassium which may be added into the mixture of the reaction components. That is, there is a problem in which crystalline as well as size of metal oxide particle cannot be controlled. This means that when actinide oxide is manufactured, it is difficult to manufacture selectively a particular actinide oxide. Moreover, if an actinide oxide is manufactured as a metal oxide, it have not been disclosed how the actinide-oxygen ratio may be controlled.

Further, the method described in Japanese Patent Publication No. 3663408, there is a problem in which it is difficult to control not only crystalline but also size of crystalline metal oxides.

Accordingly, an object of the present invention is to solve the above problems to provide a method and apparatus for generating crystal of an actinide oxide having a fluorite crystal structure and a predetermined size and shape. Another object of the present invention is to provide the crystal of the actinide oxide having the fluorite crystal structure and a predetermined size and a predetermined shape using the method and apparatus mentioned above. Furthermore, an object of the invention is to provide a method and apparatus for manufacturing crystal of actinide oxide as nuclear fuel for nuclear fission power generation, wherein the crystal of the actinide oxide has the fluorite crystal structure and the predetermined size and shape, and to provide the crystal of the actinide oxide has the fluorite crystal structure and the predetermined size and shape using the method and the apparatus.

### Means for Solving the Problems

In order to solve the problems mentioned above, an embodiment of a method for manufacturing a crystal of an actinide oxide particle includes steps of: mixing an actinide solution and an organic material; and placing the actinide solution mixed with the organic material under high temperature and high pressure environment.

In order to solve the problems mentioned above, an embodiment of a method for manufacturing a crystal of an actinide oxide particle that has a predetermined size and a predetermined shape and has a fluorite crystal structure includes steps of: mixing an actinide solution and an organic material; and placing the actinide solution mixed with the organic material under high temperature and high pressure environment.

In order to solve the problems mentioned above, an embodiment of a method for manufacturing a crystal of an actinide oxide particle that is used as fuel for nuclear fission in nuclear power generation, and has a predetermined size and a predetermined shape and hasa fluorite crystal structure includes steps of: mixing an actinide solution and an organic material; and placing the actinide solution mixed with the organic material under high temperature and high pressure environment.

### Brief Description of the Drawings

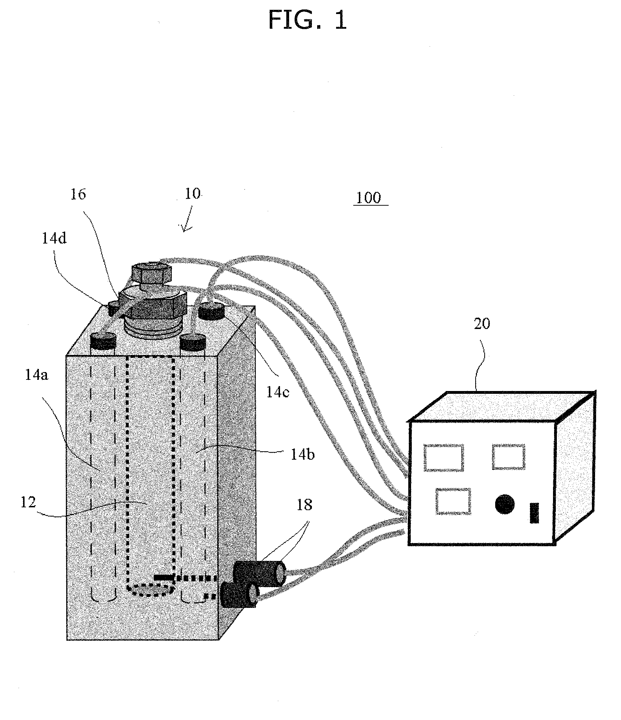

Fig. 1 is a schematic diagram illustrating a apparatus including a reactor (autoclave), and temperature controller that is used in a method according to first embodiment of the present invention for manufacturing a crystal of an actinide oxide particle that has a predetermined size and a predetermined shape and has a fluorite crystal structure;

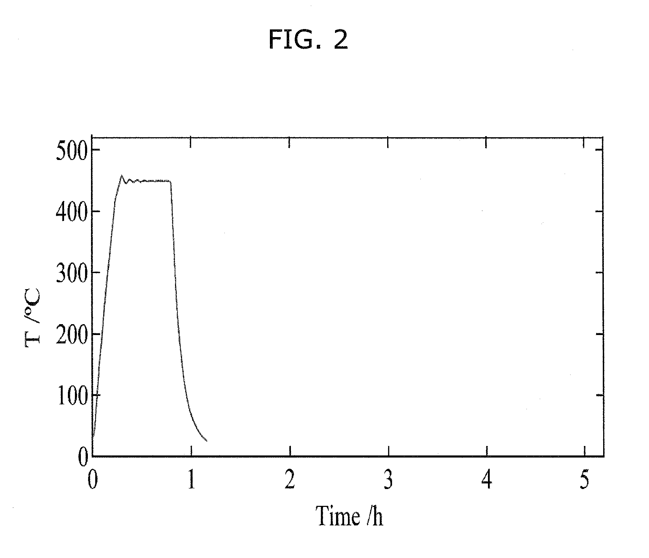

Fig. 2 is a diagram illustrating time variation of temperature when 3mL of the actinide solution is housed to a cell 12 having 10mL capacity shown in Figure 1 and a temperature in the cell is controlled using a temperature controller;

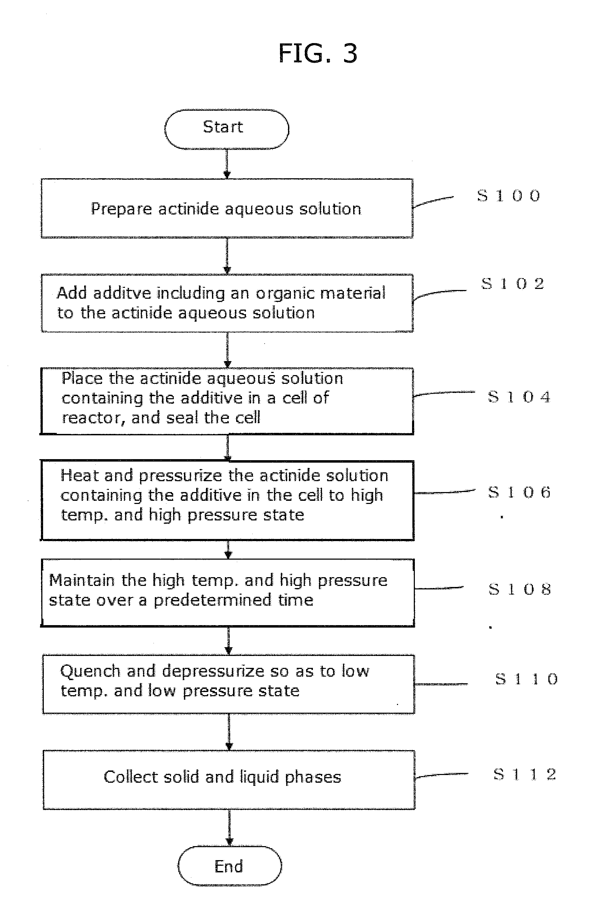

Fig. 3 is a flowchart of the method of the first embodiment according to the present invention;

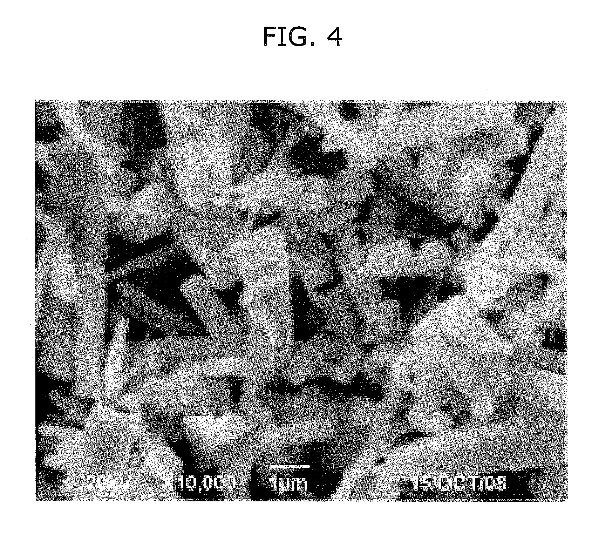

Fig. 4 is a diagram illustrating a photo taken with the Scanning Electron Microscope (SEM), in the method of the first embodiment according to the present invention, illustrating a rectangular shaped crystal is obtained by adding methanol to uranyl nitrate solution and placing the uranyl nitrate solution with methanol in the autoclave in which the temperature is at 450 degrees Celsius for 30 minutes;

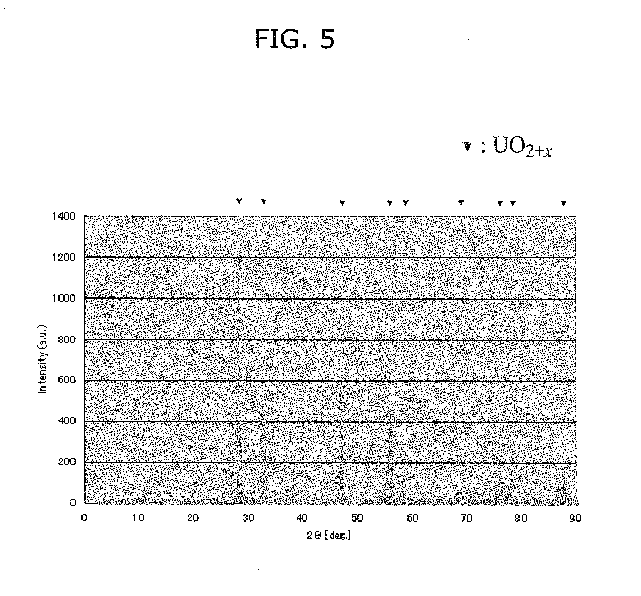

Fig. 5 is a diagram illustrating a result from the X-ray diffraction method, in the method of the first embodiment according to the present invention, illustrating that the crystal obtained by adding methanol to uranyl nitrate solution and placing the uranyl nitrate solution with methanol in the autoclave in which the temperature is at 450 degrees Celsius for 30 minutes, shown in the photo in Fig. 4, is uranium dioxide being a crystal having the fluorite crystal structure;

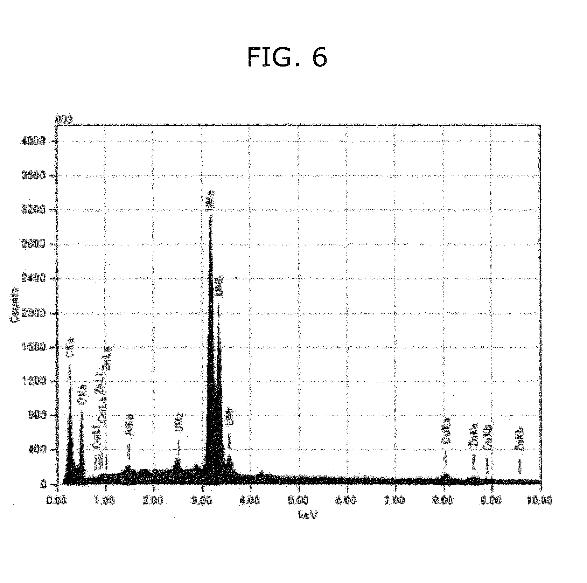

Fig. 6 is a diagram illustrating a result from the Energy Dispersive x-ray Spectroscopy (EDS) method, in the method of the first embodiment according to the present invention, illustrating that the crystal obtained by adding methanol to uranyl nitrate solution and placing the uranyl nitrate solution with methanol in the autoclave in which the temperature is at 450 degrees Celsius for 30 minutes, shown in the photo in Fig. 4, contains uranium and oxygen, and also contains few impurities;

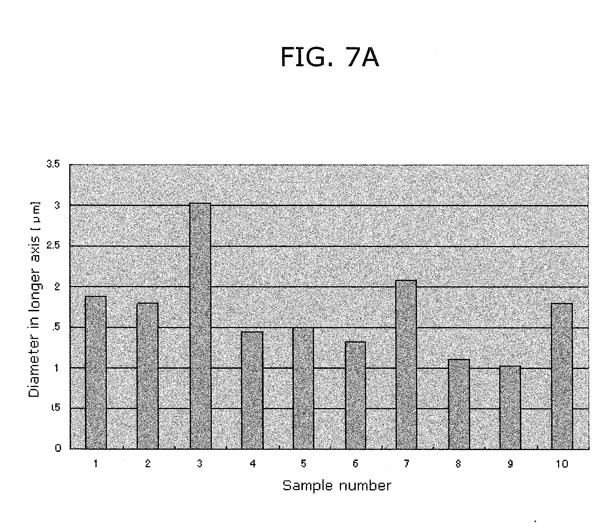

Fig. 7A is a diagram illustrating that, in the method of the first embodiment according to the present invention, 10 sampled particles which are obtained by adding methanol to uranyl nitrate solution and placing the uranyl nitrate solution with methanol in the autoclave in which the temperature is at 450 degrees Celsius for 30 minutes, shown in the photo in Fig. 4, have nearly an average constant diameter being 1.51µm in a longer axis;

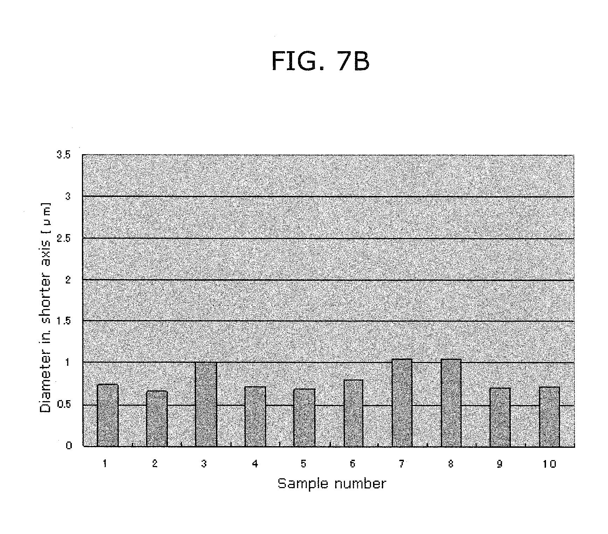

Fig. 7B is a diagram illustrating that, in the method of the first embodiment according to the present invention, 10 sampled particles which are obtained by adding methanol to uranyl nitrate solution and placing the uranyl nitrate solution with methanol in the autoclave in which the temperature is at 450 degrees Celsius for 30 minutes, shown in the photo in Fig. 4, have a nearly constant average diameter being 0.59 µm in a shorter axis;

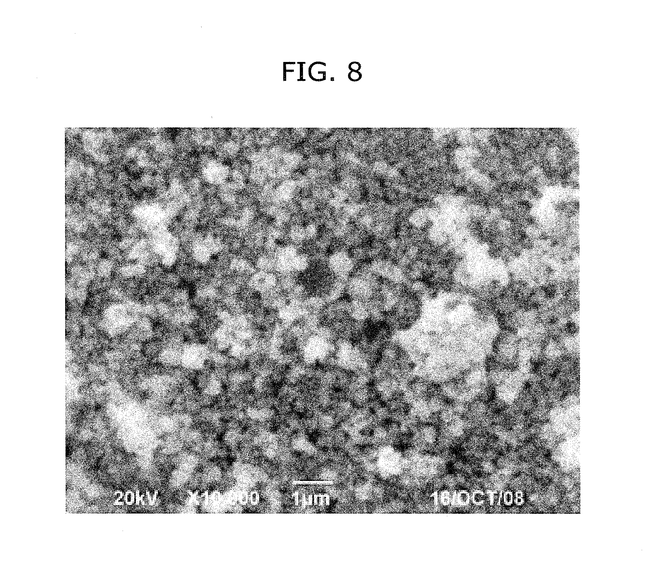

Fig. 8 is a diagram illustrating a photo taken with the scanning electron microscope (SEM), in the method of the first embodiment according to the present invention, illustrating a sphere shaped crystal is obtained by adding hexylaldehyde to uranyl nitrate solution and placing the uranyl nitrate solution with methanol in the autoclave in which the temperature is at 450 degrees Celsius for 30 methanol minutes;

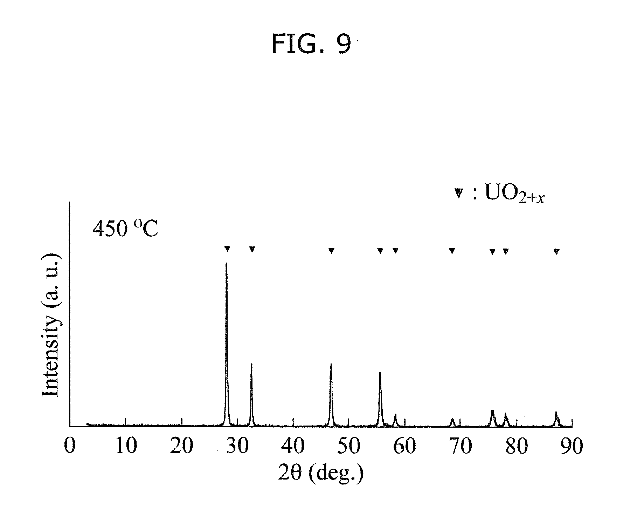

Fig. 9 is a diagram illustrating a result from the X-ray diffraction method, in the method of the first embodiment according to the present invention, illustrating the crystal obtained by adding hexylaldehyde to uranyl nitrate solution and placing the uranyl nitrate solution with hexylaldehyde in the autoclave in which the temperature is at 450 degrees Celsius for 30 minutes, shown in the photo in Fig. 8, contains uranium and oxygen, and also contains few impurities;

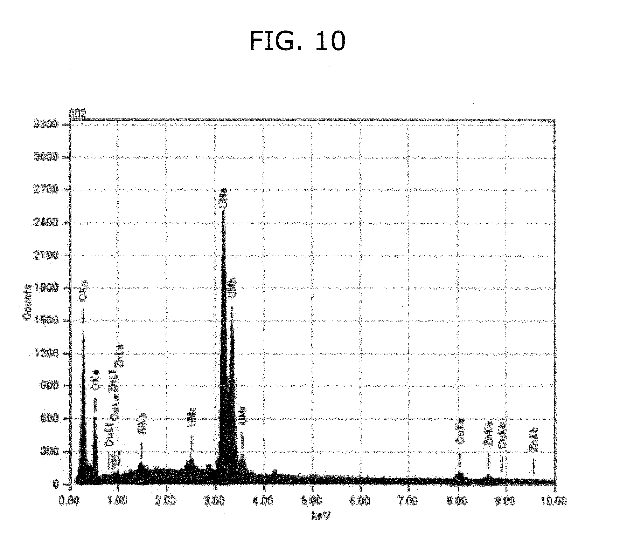

Fig. 10 is a diagram illustrating a result from the Energy Dispersive x-ray Spectroscopy (EDS) method, in the method of the first embodiment according to the present invention, illustrating that the crystal obtained by adding hexylaldehyde to uranyl nitrate solution and placing the uranyl nitrate solution with hexylaldehyde in the autoclave in which the temperature is at 450 degrees Celsius for 30 minutes, shown in the photo in Fig. 8, is uranium dioxide being a crystal having a fluorite crystal structure;

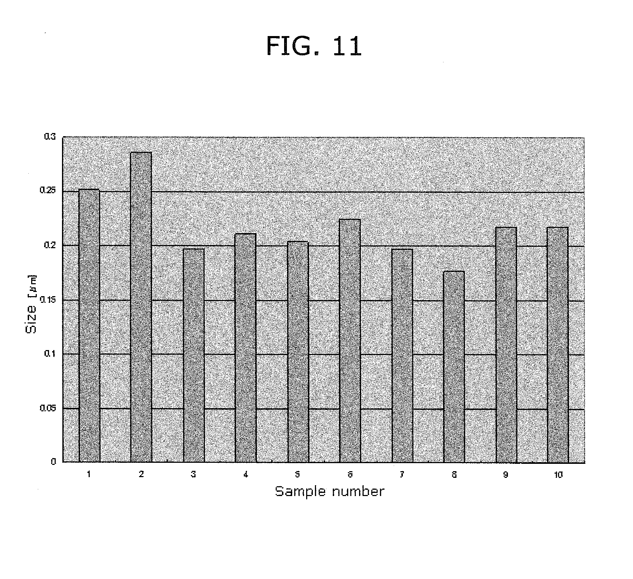

Fig. 11 is a diagram illustrating that, in the method of the first embodiment according to the present invention, 10 sampled particles which are obtained by adding hexylaldehyde to uranyl nitrate solution and placing the uranyl nitrate solution with hexylaldehyde in the autoclave in which the temperature is at 450 degrees Celsius for 30 minutes, shown in the photo in Fig. 8, have of nearly an average constant diameter being 0.22µm;

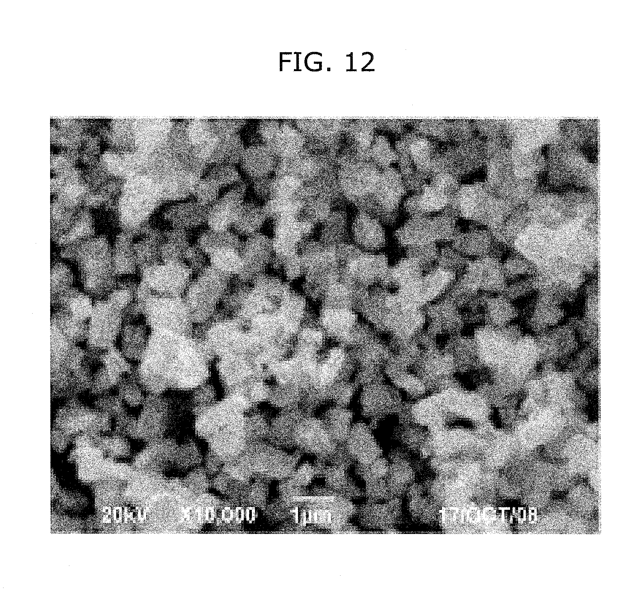

Fig. 12 is a diagram illustrating a photo taken with the Scanning Electron Microscope (SEM), in the method of the first embodiment according to the present invention, illustrating a rectangular shaped crystal is obtained by adding ethanol and hexylamine to an uranyl nitrate solution and placing the uranyl nitrate solution with ethanol and hexylamine in the autoclave in which the temperature is at 450 degrees Celsius for 30 minutes;

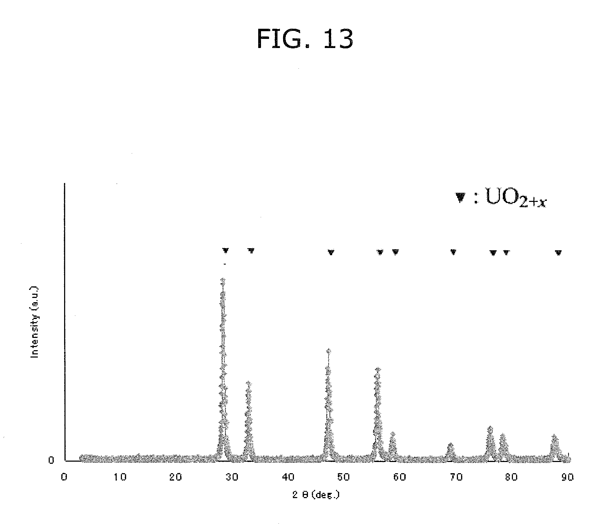

Fig. 13 is a diagram illustrating a result from the X-ray diffraction method, in the method of the first embodiment according to the present invention, illustrating the crystal obtained by adding ethanol and hexylamine to uranyl nitrate solution and placing the uranyl nitrate solution with ethanol and hexylamine in the autoclave in which the temperature is at 450 degrees Celsius for 30 minutes, shown in the photo in Fig. 12, contains uranium and oxygen, and also contains few impurities;

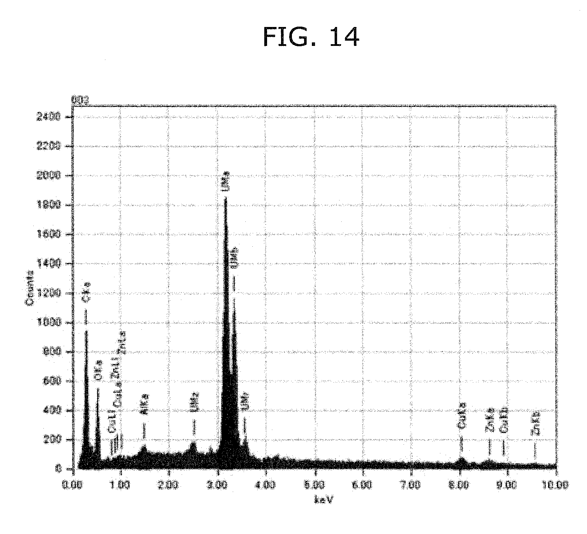

Fig. 14 is a diagram illustrating a result from the Energy Dispersive x-ray Spectroscopy (EDS) method, in the method of the first embodiment according to the present invention, illustrating that the crystal obtained by adding ethanol and hexylamine to uranyl nitrate solution and placing the uranyl nitrate solution with ethanol and hexylamine in the autoclave in which the temperature is at 450 degrees Celsius for 30 minutes, shown in the photo in Fig. 12, is uranium dioxide being a crystal having a fluorite structure;

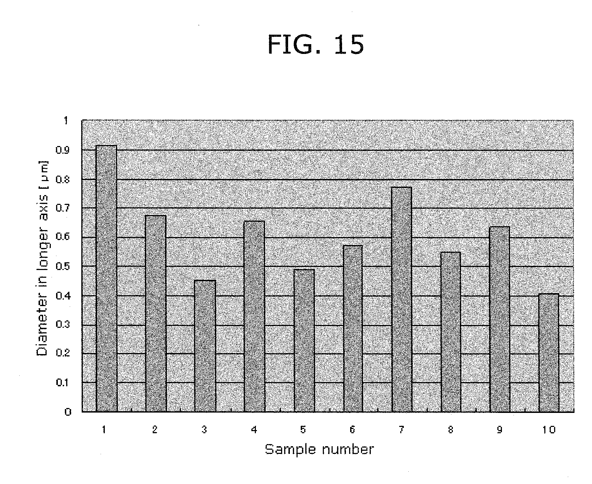

Fig. 15 is a diagram illustrating that, in the method of the first embodiment according to the present invention, 10 sampled particles which are obtained by adding ethanol and hexylamine to uranyl nitrate solution and placing the uranyl nitrate solution with ammonium carbonate and 2-propanol in the autoclave in which the temperature is at 450 degrees Celsius for 30 minutes, shown in the photo in Fig. 12, have nearly an average constant diameter of 0.58µm;

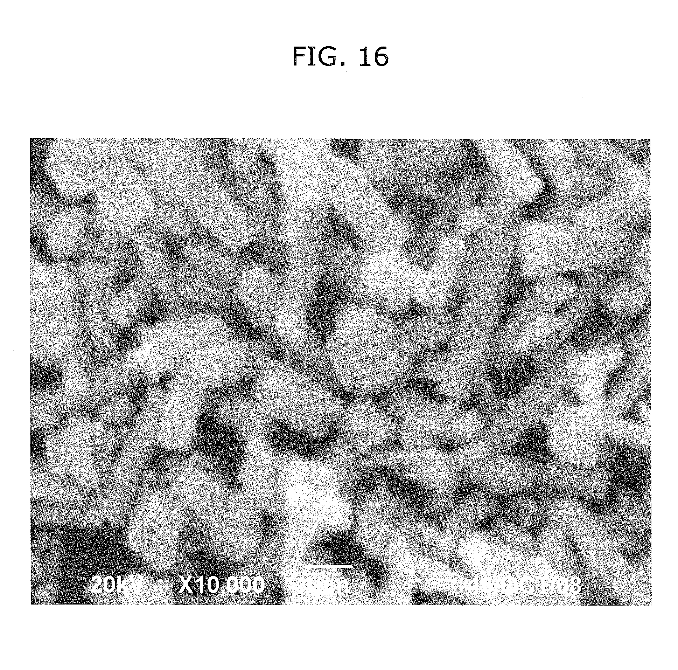

Fig. 16 is a diagram illustrating a photo taken with the scanning electron microscope (SEM), in the method of the first embodiment according to the present invention, illustrating a rectangular shaped crystal is obtained by adding ammonium carbonate and 2-propanol to uranyl nitrate solution and placing the uranyl nitrate solution with ammonium carbonate and 2-propanol in the autoclave in which the temperature is at 450 degrees Celsius for 30 minutes;

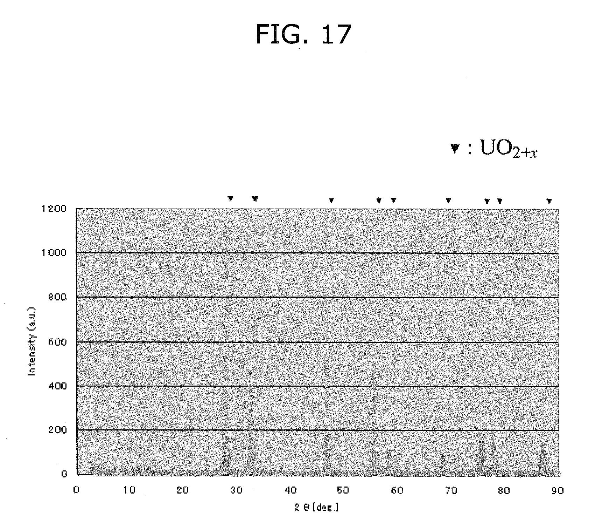

Fig. 17 is a diagram illustrating a result from the X-ray diffraction method, in the method of the first embodiment according to the present invention, illustrating the crystal obtained by adding ammonium carbonate and 2-propanol to uranyl nitrate solution and placing the uranyl nitrate solution with ammonium carbonate and 2-propanol in the autoclave in which the temperature is at 450 degrees Celsius for 30 minutes, shown in the photo in Fig. 16, contains uranium and oxygen, and also contains few impurities;

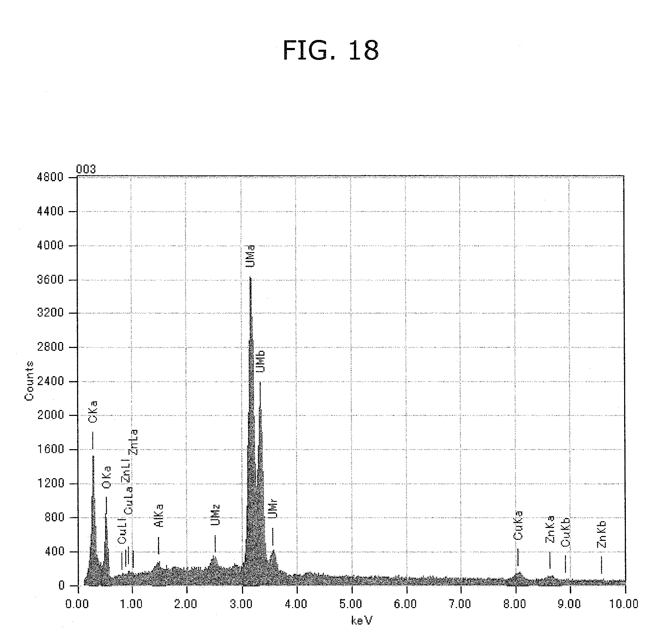

Fig. 18 is a diagram illustrating a result from the Energy Dispersive x-ray Spectroscopy (EDS) method, in the method of the first embodiment according to the present invention, illustrating that the crystal obtained by adding ammonium carbonate and 2-propanol to an uranyl nitrate solution and placing the uranyl nitrate solution with ammonium carbonate and 2-propanol in the autoclave in which the temperature is at 450 degrees Celsius for 30 minutes, shown in the photo in Fig. 16, is uranium dioxide being a crystal having a fluorite structure;

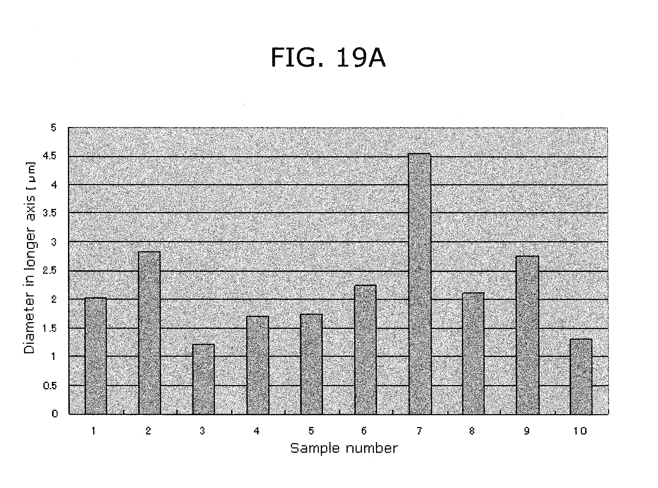

Fig. 19A is a diagram illustrating that, in the method of the first embodiment according to the present invention, 10 sampled particles which are obtained by adding ammonium carbonate and 2-propanol to an uranyl nitrate solution and placing the uranyl nitrate solution with ammonium carbonate and 2-propanol in the autoclave in which the temperature is at 450 degrees Celsius for 30 minutes, shown in the photo in Fig. 16, have nearly an average constant diameter being 2.25µm in a longer axis;

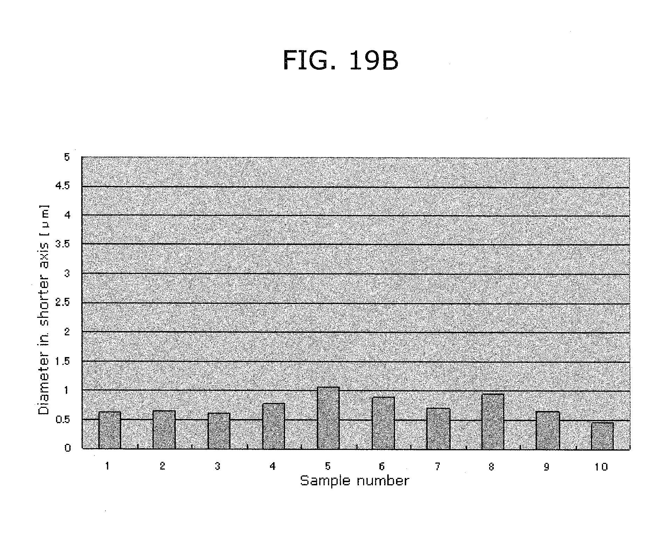

Fig. 19B is a diagram illustrating that, in the method of the first embodiment according to the present invention, 10 sampled particles which are obtained by adding ammonium carbonate and 2-propanol to an uranyl nitrate solution and placing the uranyl nitrate solution with ammonium carbonate and 2-propanol in the autoclave in which the temperature is at 450 degrees Celsius for 30 minutes, shown in the photo in Fig. 16, have a nearly constant average diameter being 0.74µm in a shorter axis;

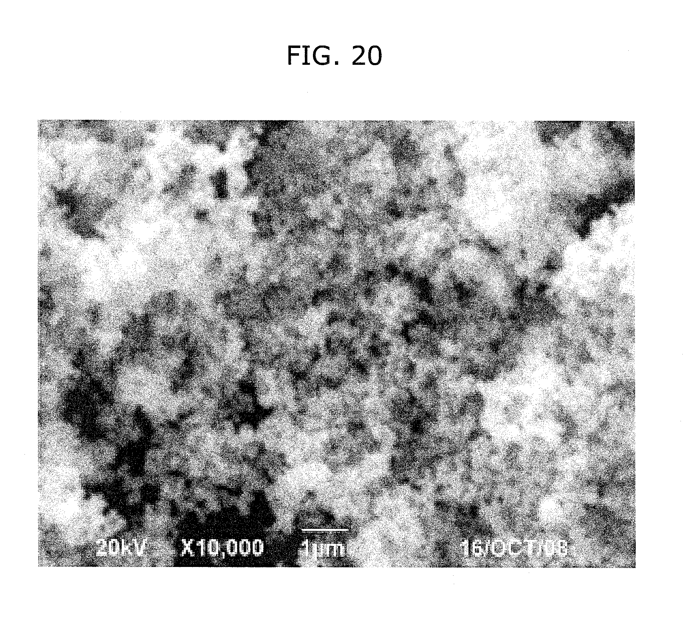

Fig. 20 is a diagram illustrating a photo taken with the scanning electron microscope (SEM), in the method of the first embodiment according to the present invention, illustrating a sphere shaped crystal is obtained by adding ammonium carbonate and propionaldehyde to an uranyl nitrate solution and placing the uranyl nitrate solution with ammonium carbonate and propionaldehyde in the autoclave in which the temperature is at 450 degrees Celsius for 30 minutes;

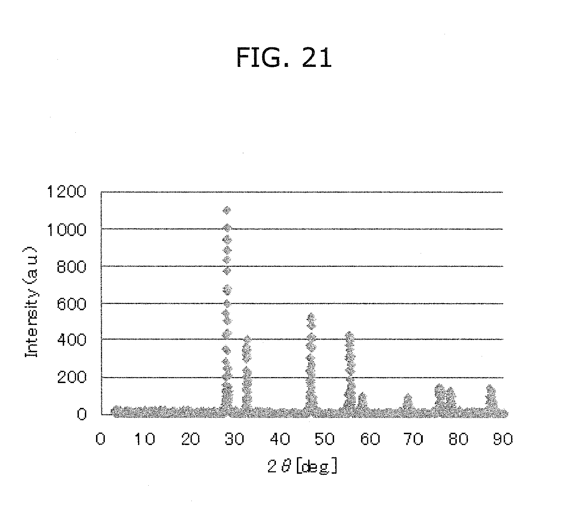

Fig. 21 is a diagram illustrating a result from the X-ray diffraction method, in the method of the first embodiment according to the present invention, illustrating the crystal obtained by adding ammonium carbonate and propionaldehyde to uranyl nitrate solution and placing the uranyl nitrate solution with ammonium carbonate and propionaldehyde in the autoclave in which the temperature is at 450 degrees Celsius for 30 minutes, shown in the photo in Fig. 20, contains uranium and oxygen, and also contains few impurities;

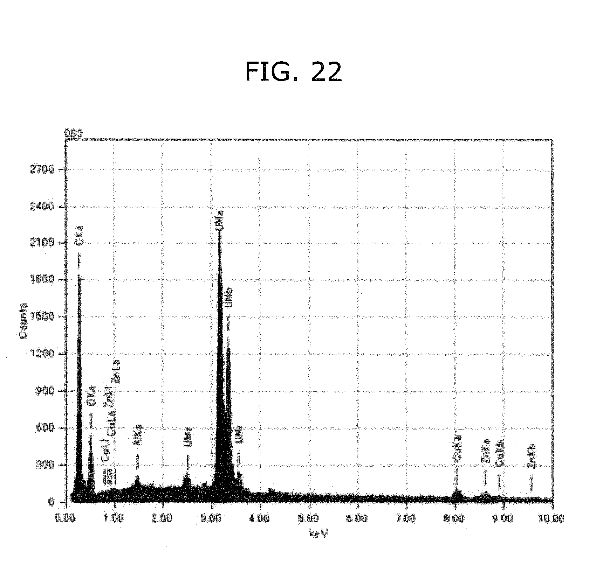

Fig. 22 is a diagram illustrating a result from the Energy Dispersive x-ray Spectroscopy (EDS) method, in the method of the first embodiment according to the present invention, illustrating that the crystal obtained by adding ammonium carbonate and propionaldehyde to uranyl nitrate solution and placing the uranyl nitrate solution with ammonium carbonate and propionaldehyde in the autoclave in which the temperature is at 450 degrees Celsius for 30 minutes, shown in the photo in Fig. 20, is uranium dioxide being a crystal having a fluorite structure;

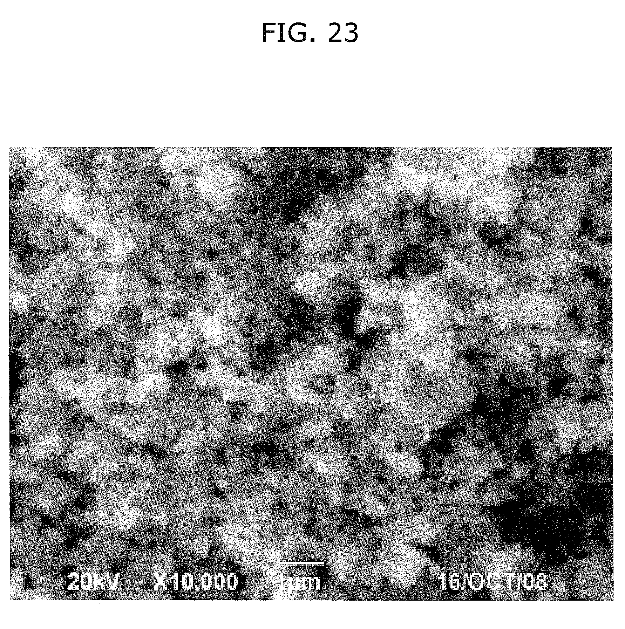

Fig. 23 is a diagram illustrating a photo taken with the scanning electron microscope (SEM), in the method of the first embodiment according to the present invention, illustrating a sphere shaped crystal is obtained by adding ammonium carbonate and glucose to uranyl nitrate solution and placing the uranyl nitrate solution with ammonium carbonate and glucose in the autoclave in which the temperature is at 450 degrees Celsius for 30 minutes;

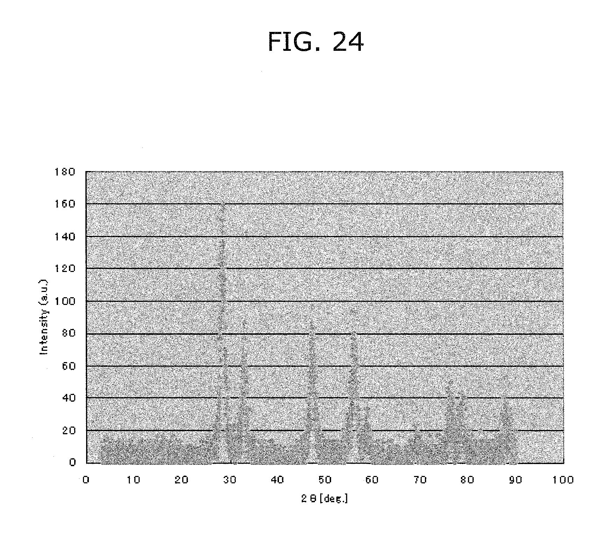

Fig. 24 is a diagram illustrating a result from the X-ray diffraction method, in the method of the first embodiment according to the present invention, illustrating the crystal obtained by adding ammonium carbonate and glucose to uranyl nitrate solution and placing the uranyl nitrate solution with ammonium carbonate and glucose in the autoclave in which the temperature is at 450 degrees Celsius for 30 minutes, shown in the photo in Fig. 23, contains uranium and oxygen, and also contains few impurities;

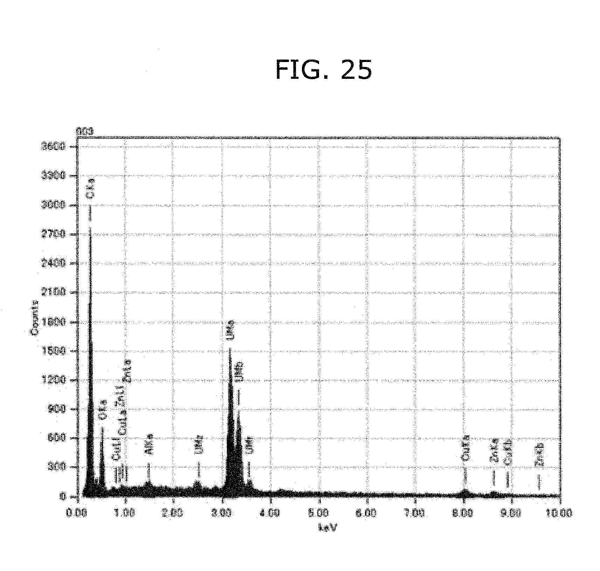

Fig. 25 is a diagram illustrating a result from the Energy Dispersive x-ray Spectroscopy (EDS) method, in the method of the first embodiment according to the present invention, illustrating that the crystal obtained by adding ammonium carbonate and glucose to uranyl nitrate solution and placing the uranyl nitrate solution with ammonium carbonate and glucose in the autoclave in which the temperature is at 450 degrees Celsius for 30 minutes, shown in the photo in Fig. 23, is uranium dioxide being a crystal having a fluorite structure;

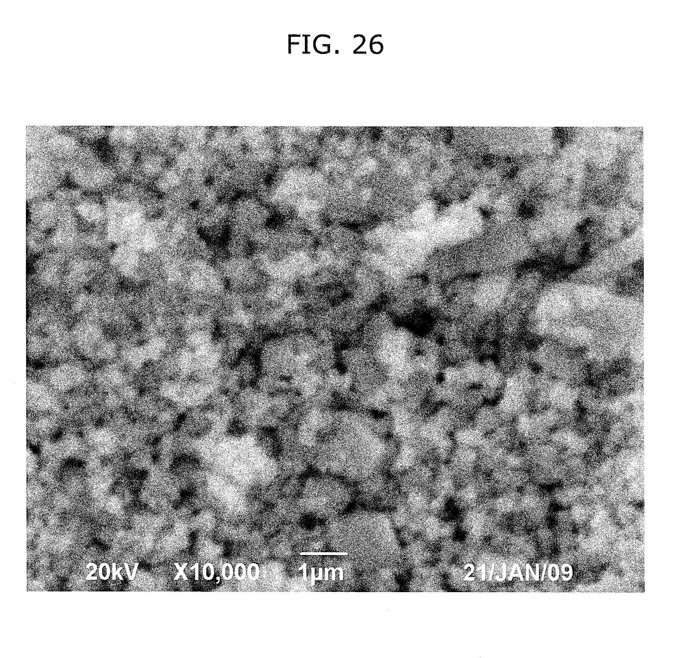

Fig. 26 is a diagram illustrating a photo taken with the scanning electron microscope (SEM), in the method of the first embodiment according to the present invention, illustrating a rectangular shaped crystal is obtained by adding ethanol and hexylamine to uranyl nitrate solution and placing the uranyl nitrate solution with ethanol and hexylamine in the autoclave in which the temperature is at 390 degrees Celsius for 30 minutes;

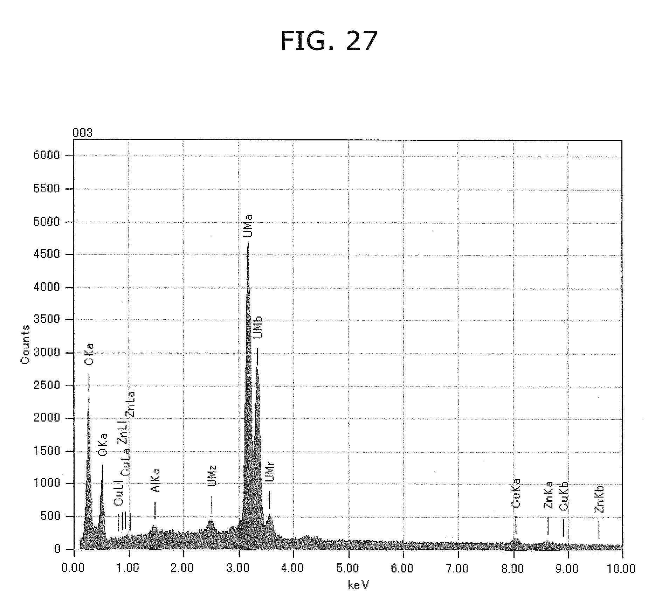

Fig. 27 is a diagram illustrating a result from the X-ray diffraction method, in the method of the first embodiment according to the present invention, illustrating the crystal obtained by adding ethanol and hexylamine to uranyl nitrate solution and placing the uranyl nitrate solution with ethanol and hexylamine in the autoclave in which the temperature is at 390 degrees Celsius for 30 minutes contains uranium and oxygen, and also contains few impurities;

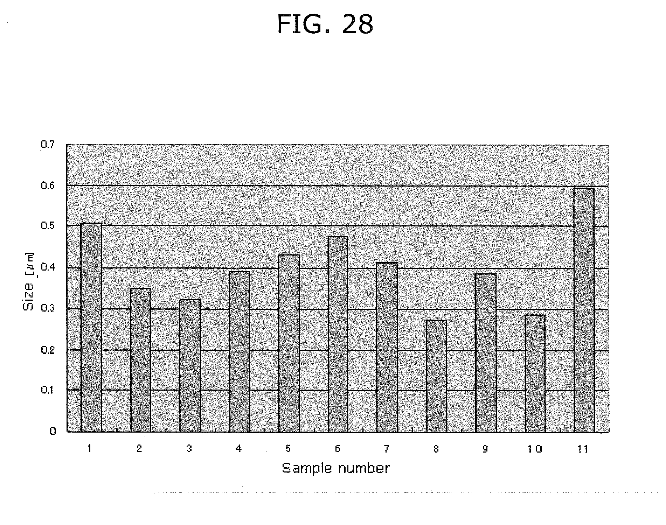

Fig. 28 is a diagram illustrating that, in the method of the first embodiment according to the present invention, 10 sampled particles which are obtained by adding ethanol and hexylamine to uranyl nitrate solution and placing the uranyl nitrate solution with ammonium carbonate and 2-propanol in the autoclave in which the temperature is at 390 degrees Celsius for 30 minutes, shown in the photo in Fig. 26, have nearly an average constant diameter of 0.58µm;

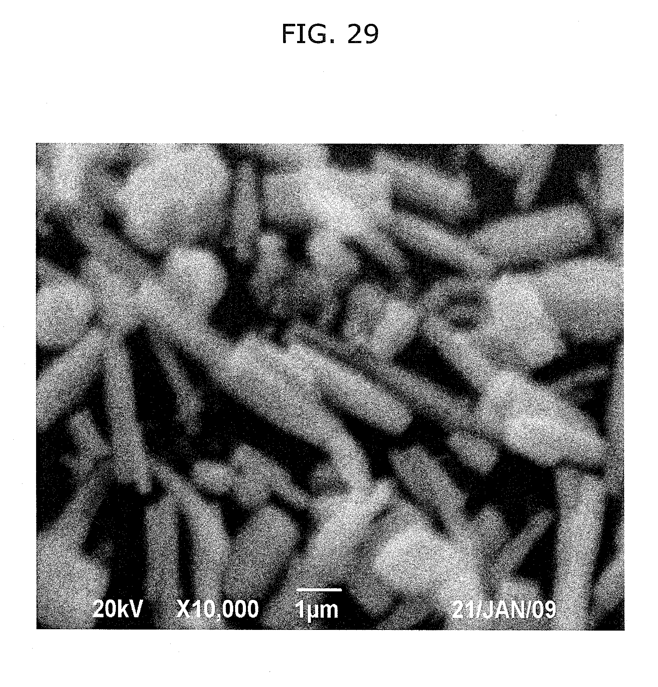

Fig. 29 is a diagram illustrating a photo taken with the scanning electron microscope (SEM), in the method of the first embodiment according to the present invention, illustrating a rectangular shaped crystal is obtained by adding ammonium carbonate and 2-propanol to uranyl nitrate solution and placing the uranyl nitrate solution with ammonium carbonate and 2-propanol in the autoclave in which the temperature is at 390 degrees Celsius for 30 minutes;

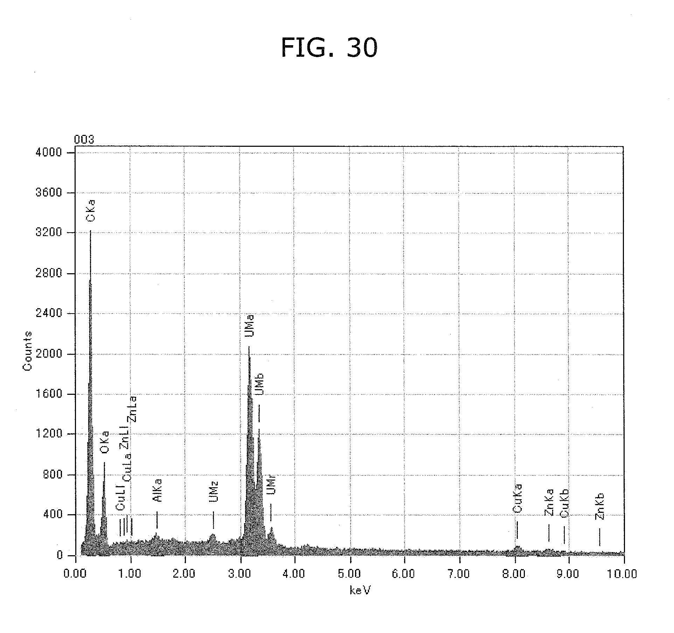

Fig. 30 is a diagram illustrating a result from the X-ray diffraction method, in the method of the first embodiment according to the present invention, illustrating the crystal obtained by adding ammonium carbonate and 2-propanol to uranyl nitrate solution and placing the uranyl nitrate solution with ammonium carbonate and 2-propanol in the autoclave in which the temperature is at 390 degrees Celsius for 30 minutes, shown in the photo in Fig. 29, contains uranium and oxygen, and also contains few impurities;

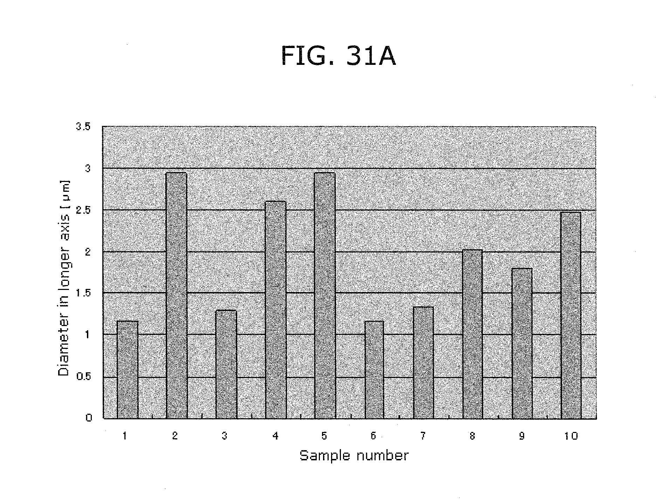

Fig. 31A is a diagram illustrating that, in the method of the first embodiment according to the present invention, 10 sampled particles which are obtained by adding ammonium carbonate and 2-propanol to uranyl nitrate solution and placing the uranyl nitrate solution with ammonium carbonate and 2-propanol in the autoclave in which the temperature is at 390 degrees Celsius for 30 minutes, shown in the photo in Fig. 29, have nearly an average constant diameter being 1.97µm in a longer axis;

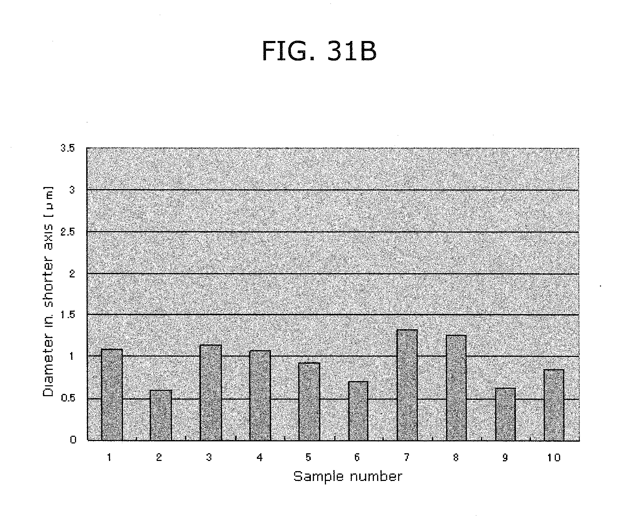

Fig. 31B is a diagram illustrating that, in the method of the first embodiment according to the present invention, 10 sampled particles which are obtained by adding ammonium carbonate and 2-propanol to an uranyl nitrate solution and placing the uranyl nitrate solution with ammonium carbonate and 2-propanol in the autoclave in which the temperature is at 390 degrees Celsius for 30 minutes, shown in the photo in Fig. 29, have a nearly constant average diameter being 0.96µm in a shorter axis;

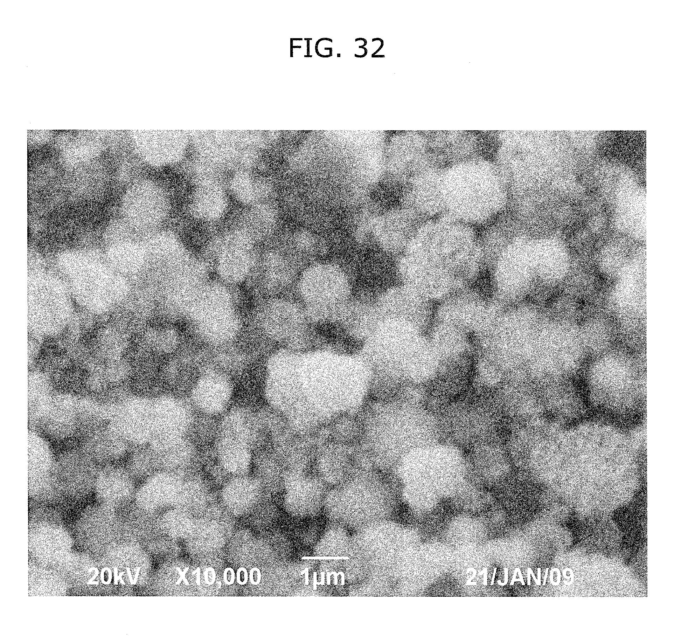

Fig. 32 is a diagram illustrating a photo taken with the scanning electron microscope (SEM), in the method of the first embodiment according to the present invention, illustrating a sphere shaped crystal is obtained by adding propionaldehyde to uranyl nitrate solution containing tetravalent uranium and placing the uranyl nitrate solution containing tetravalent uranium and propionaldehyde in the autoclave in which the temperature is at 300 degrees Celsius for 30 minutes;

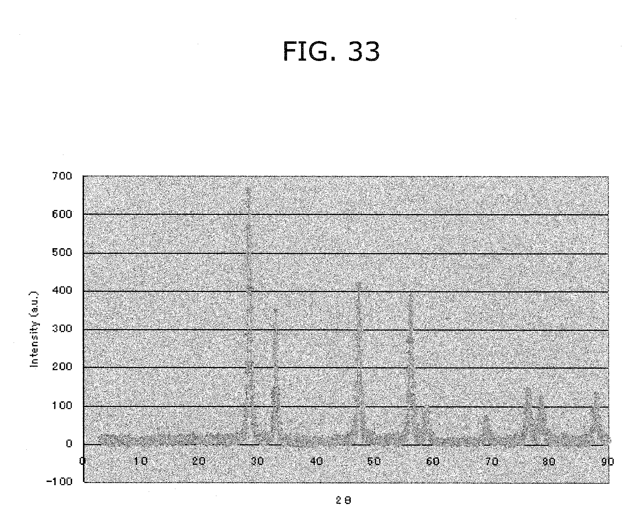

Fig. 33 is a diagram illustrating a result from the X-ray diffraction method, in the method of the first embodiment according to the present invention, illustrating the crystal obtained by adding propionaldehyde to uranyl nitrate solution containing tetravalent uranium and placing the uranyl nitrate solution containing tetravalent uranium and propionaldehyde in the autoclave in which the temperature is at 300 degrees Celsius for 30 minutes, shown in the photo in Fig. 32, contains uranium and oxygen, and also contains few impurities;

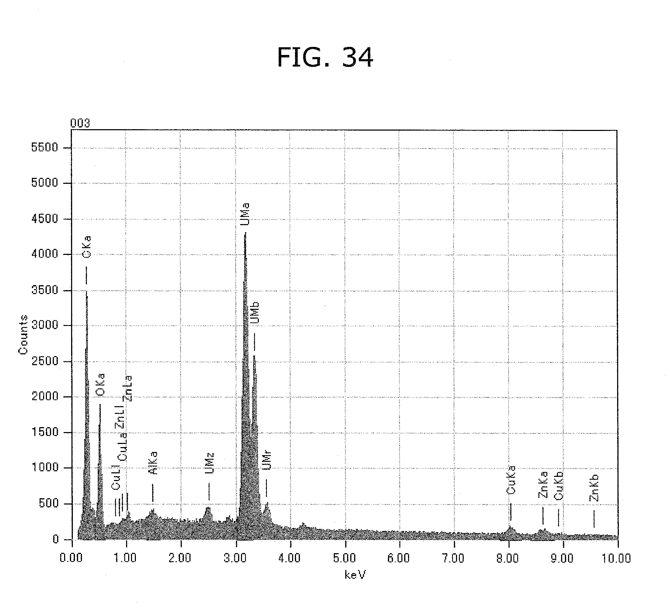

Fig. 34 is a diagram illustrating a result from the Energy Dispersive x-ray Spectroscopy (EDS) method, in the method of the first embodiment according to the present invention, illustrating that the crystal obtained by adding propionaldehyde to uranyl nitrate solution containing tetravalent uranium and placing the uranyl nitrate solution containing tetravalent uranium and propionaldehyde in the autoclave in which the temperature is at 300 degrees Celsius for 30 minutes, shown in the photo in Fig. 32, is uranium dioxide being a crystal having a fluorite structure;

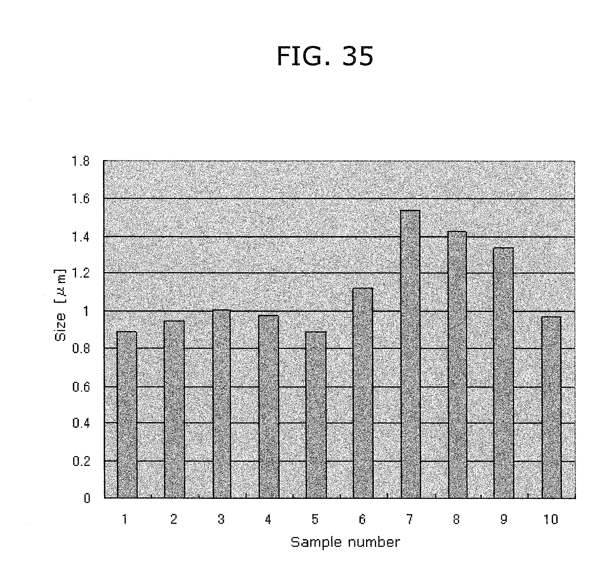

Fig. 35 is a diagram illustrating that, in the method of the first embodiment according to the present invention, 10 sampled particles which are obtained by adding propionaldehyde to uranyl nitrate solution containing tetravalent uranium and placing the uranyl nitrate solution containing tetravalent uranium and propionaldehyde in the autoclave in which the temperature is at 300 degrees Celsius for 30 minutes, shown in the photo in Fig. 29, have a nearly constant average diameter being 1.07µm;

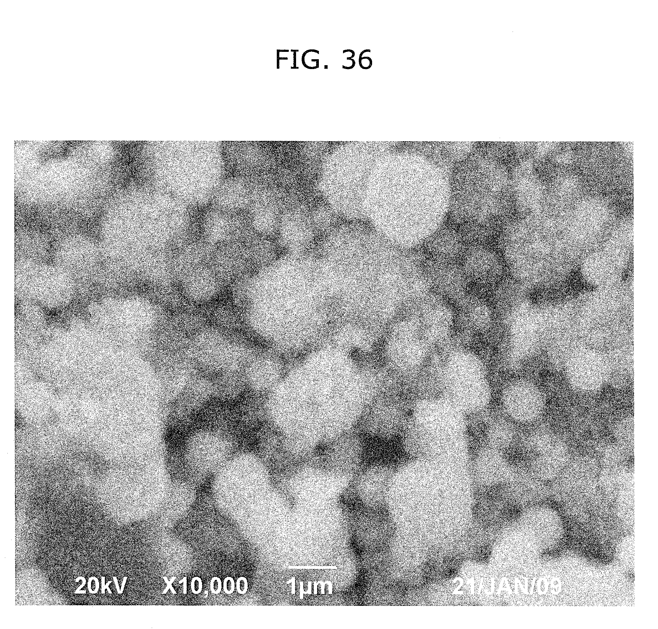

Fig. 36 is a diagram illustrating a photo taken with the scanning electron microscope (SEM), in the method of the first embodiment according to the present invention, illustrating a sphere shaped crystal is obtained by adding propionaldehyde to uranyl nitrate solution containing tetravalent uranium and placing the uranyl nitrate solution containing tetravalent uranium and propionaldehyde in the autoclave in which the temperature is at 200 degrees Celsius for 30 minutes;

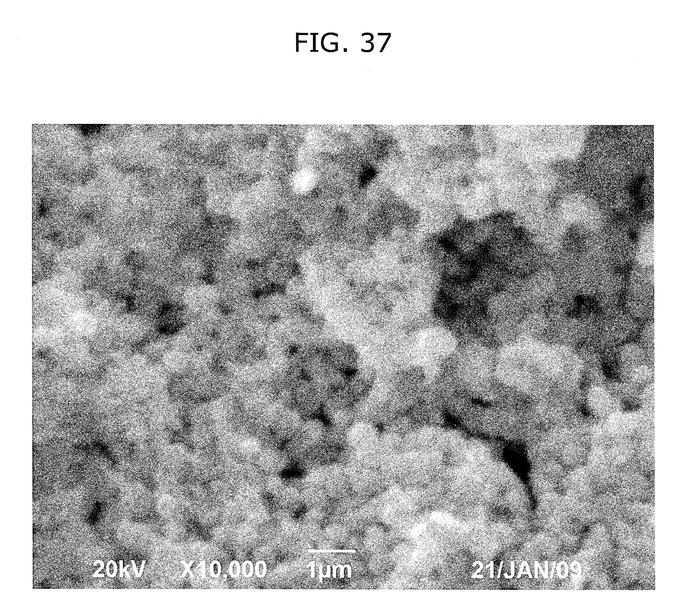

Fig. 37 is a diagram illustrating a photo taken with the scanning electron microscope (SEM), in the method of the first embodiment according to the present invention, illustrating a sphere shaped crystal is obtained by adding propionaldehyde to uranyl nitrate solution containing tetravalent uranium and placing the uranyl nitrate solution containing tetravalent uranium and propionaldehyde in the autoclave in which the temperature is at 100 degrees Celsius for 30 minutes;

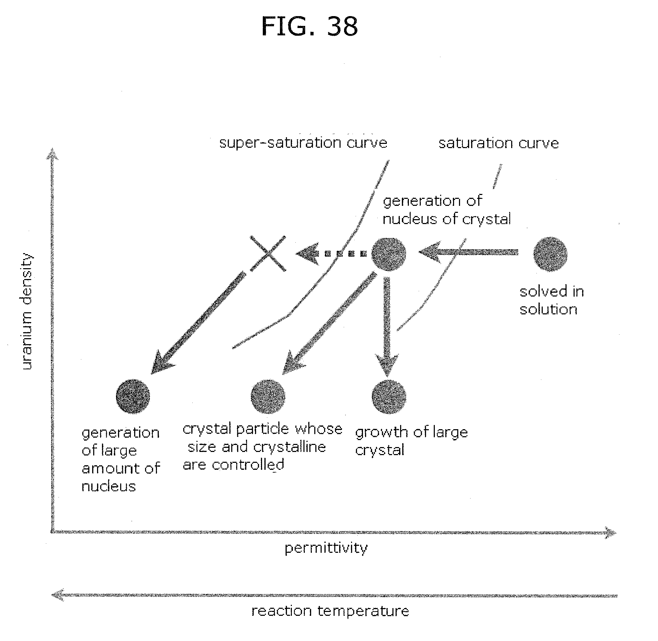

Fig. 38 is a diagram explaining a abstract of the principle in which, in a method for manufacturing an actinide oxide particle having a fluorite crystal structure and having a predetermined shape and a predetermined size, a crystal of actinide oxide having the predetermined shape and size;

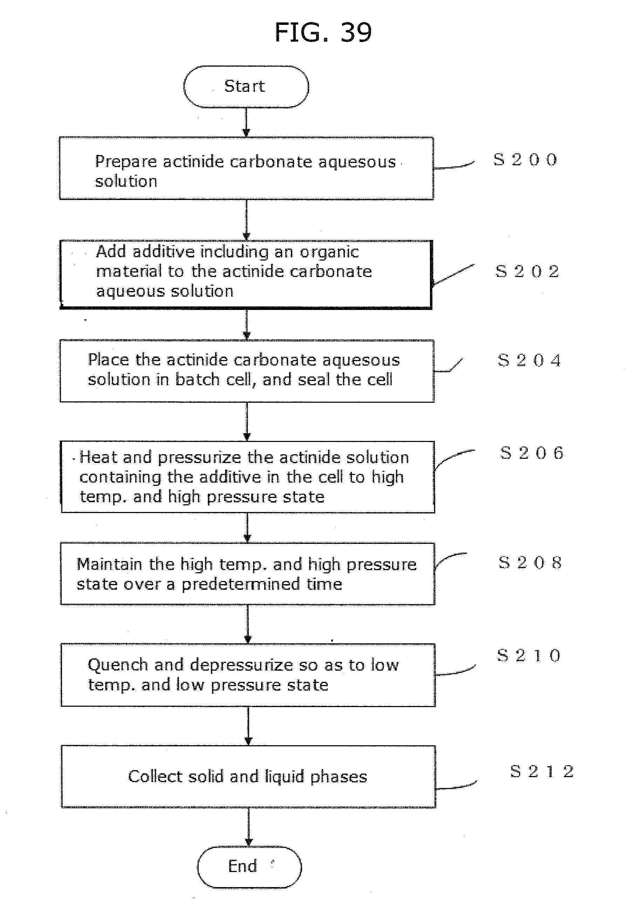

Fig. 39 is a diagram illustrating a flowchart of a method according to a second embodiment of the present invention for separating a fission product, the method including mixing an organic material and actinide solution containing impurities that are not precipitated as carbonate precipitation or hydroxide salt in hydroxide aqueous solution, and placing the actinide solution with the organic material under high temperature and high pressure environment to retrieve a crystal of actinide oxide as solid phase;

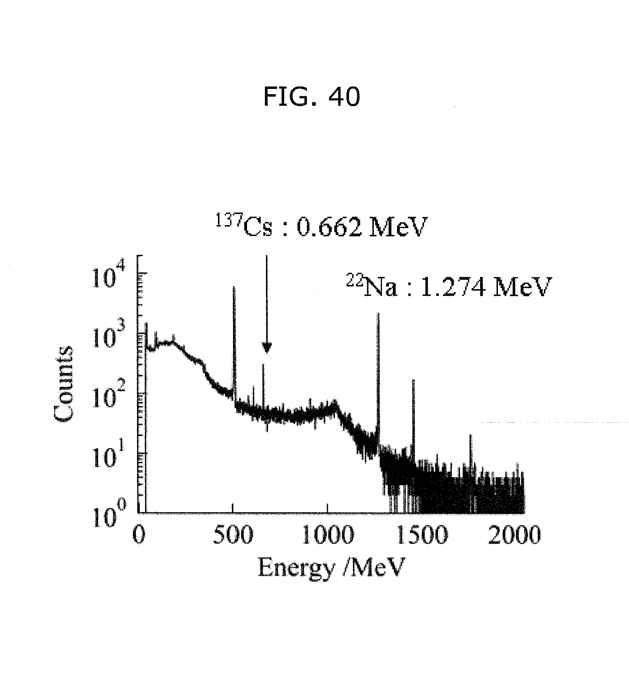

Fig. 40 is a diagram illustrating a result of measuring y-rays of crystal of actinide oxide retrieved as the solid phase by a Ge detector, in a method for separating a fission product, the method including mixing an organic material and actinide solution containing impurities that are not precipitated as carbonate precipitation or hydroxide salt in hydroxide aqueous solution, and placing the actinide solution with the organic material under high temperature and high pressure environment to retrieve a crystal of actinide oxide as solid phase;

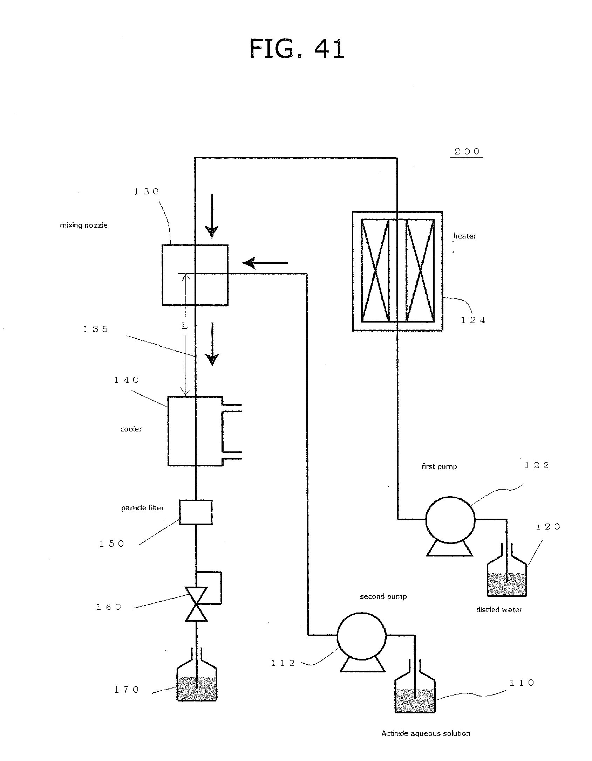

Fig. 41 is a diagram illustrating a flow-type apparatus that is used in a method for manufacturing an actinide oxide particle having a fluorite crystal structure and having a predetermined shape and a predetermined size, a crystal of actinide oxide having the predetermined shape and size;

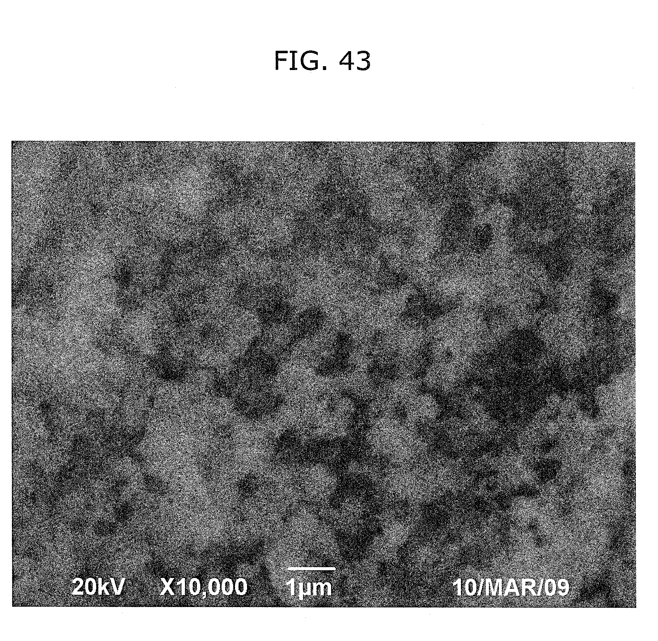

Fig. 43 is a diagram illustrating a flowchart in a method according to a third embodiment of the present invention;

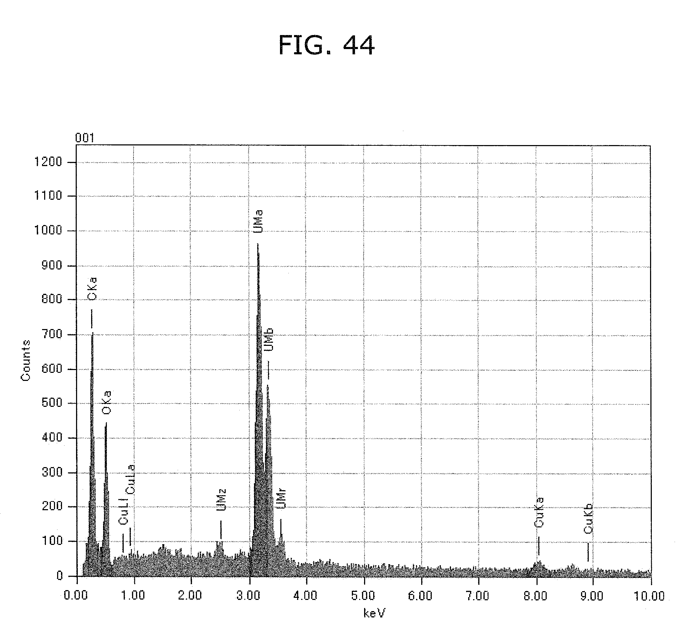

Fig. 44 is a diagram illustrating a photo taken with the scanning electron microscope (SEM), in the method of the third embodiment according to the present invention, illustrating that fine particles can be manufactured by mixing supercritical water and a solution in which propionaldehyde is added to uranium solution containing tetravalent uranium to progress a hydrothermal reaction over about 3.5 seconds;

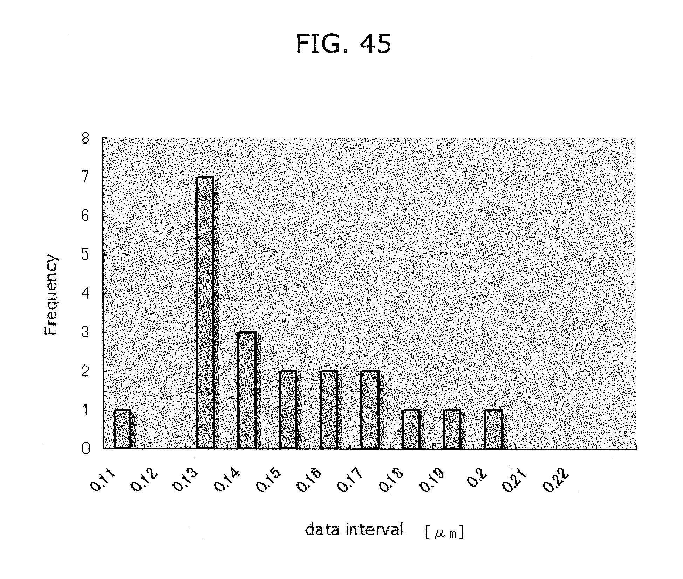

Fig. 45 is a diagram illustrating a result from the energy dispersive x-ray spectroscopy method, in the method of the third embodiment according to the present invention, illustrating the crystal obtained by a mixing supercritical water and a solution in which propionaldehyde is added to uranium solution containing tetravalent uranium to progress a hydrothermal reaction over about 3.5 seconds, shown in the photo in Fig. 43, contains uranium and oxygen, and also contains few impurities;

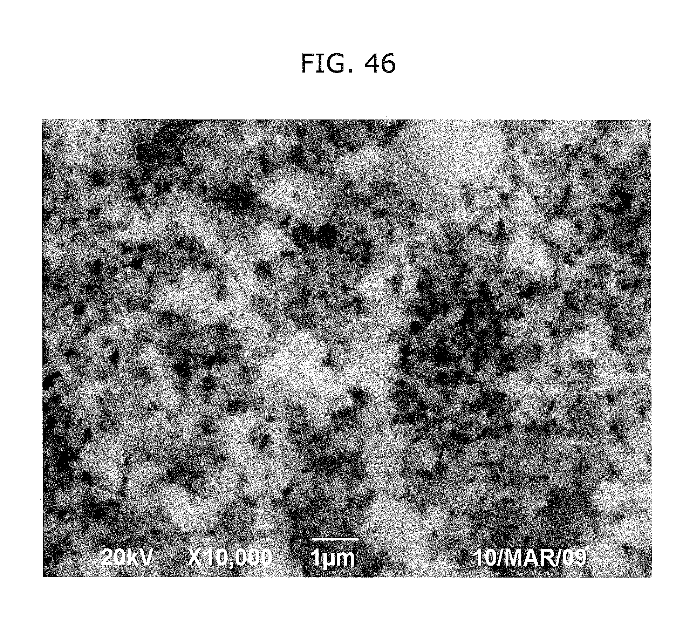

Fig. 46 is a diagram illustrating a photo taken with the scanning electron microscope (SEM), in the method of the third embodiment according to the present invention, illustrating that fine particles can be manufactured by mixing supercritical water and a solution in which propionaldehyde is added to uranium solution containing tetravalent uranium to progress a hydrothermal reaction over about 20 seconds;

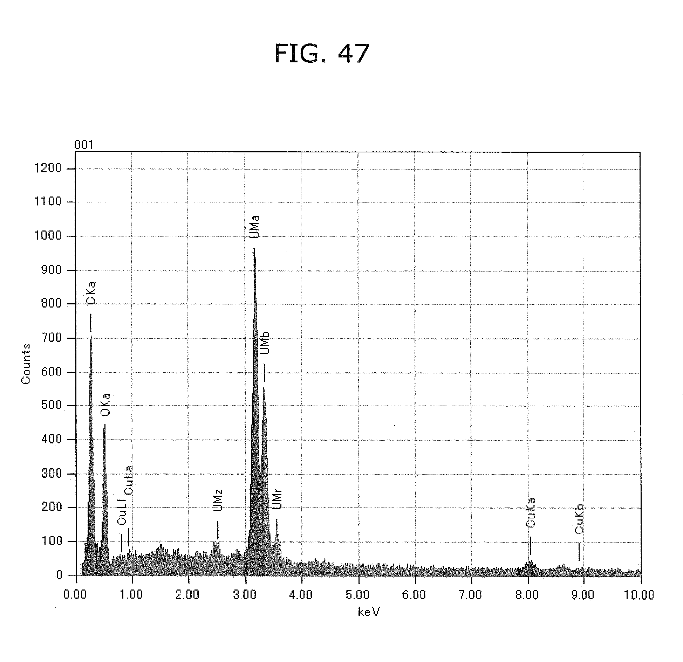

Fig. 47 is a diagram illustrating a result from the energy dispersive x-ray spectroscopy method, in the method of the third embodiment according to the present invention, illustrating the crystal obtained by a mixing supercritical water and a solution in which propionaldehyde is added to uranium solution containing tetravalent uranium to progress a hydrothermal reaction over about 20 seconds, shown in the photo in Fig. 46, contains uranium and oxygen, and also contains few impurities;

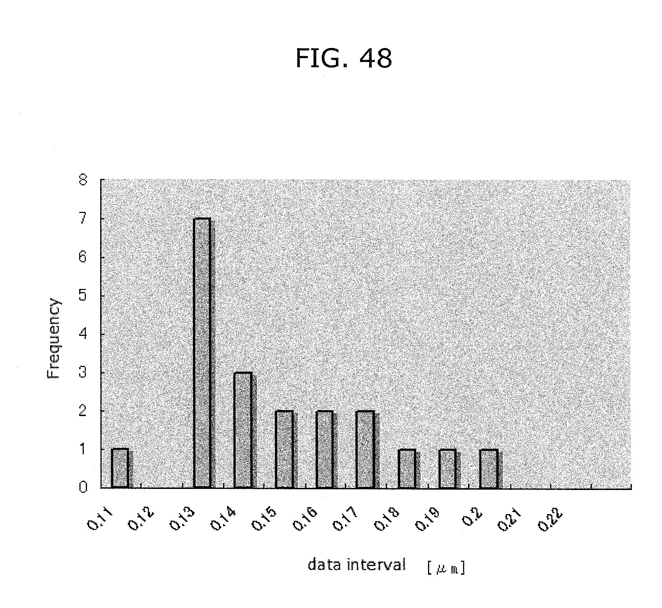

Fig. 48 is a diagram illustrating that, in the method of the third embodiment according to the present invention, particles which are obtained by a mixing supercritical water and a solution in which propionaldehyde is added to uranium solution containing tetravalent uranium to progress a hydrothermal reaction over about 20 seconds, shown in the photo in Fig. 46, have a nearly constant average diameter being 0.15µm;

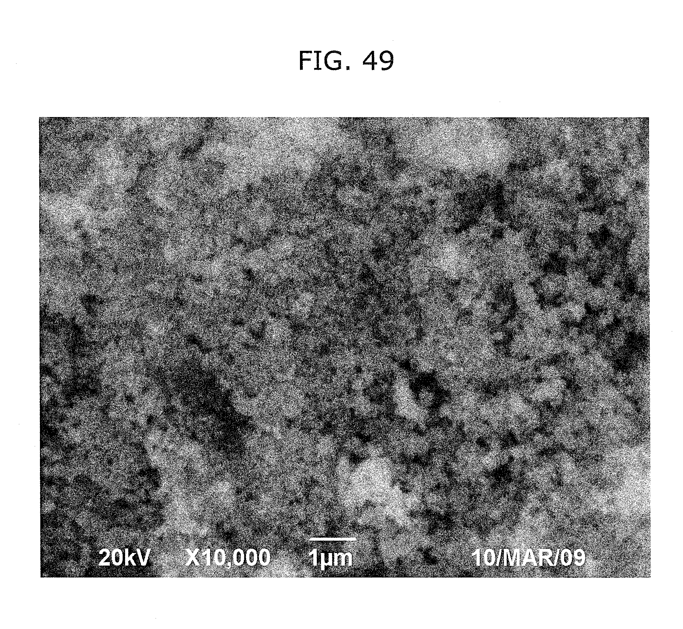

Fig. 49 is a diagram illustrating a photo taken with the scanning electron microscope (SEM), in the method of the third embodiment according to the present invention, illustrating that fine particles can be manufactured by mixing supercritical water and a solution in which propionaldehyde is added to uranium solution containing tetravalent uranium to progress a hydrothermal reaction over about 33 seconds;

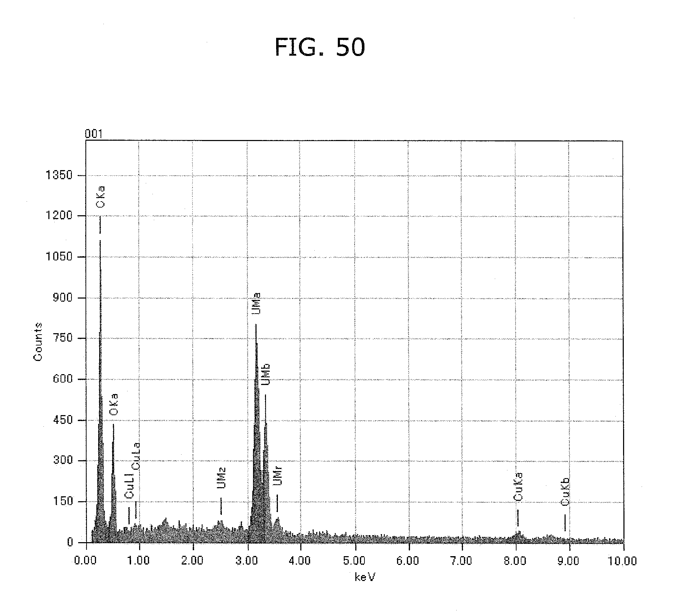

Fig. 50 is a diagram illustrating a result from the energy dispersive x-ray spectroscopy method, in the method of the third embodiment according to the present invention, illustrating the crystal obtained by a mixing supercritical water and a solution in which propionaldehyde is added to uranium solution containing tetravalent uranium to progress a hydrothermal reaction over about 33 seconds, shown in the photo in Fig. 49, contains uranium and oxygen, and also contains few impurities;

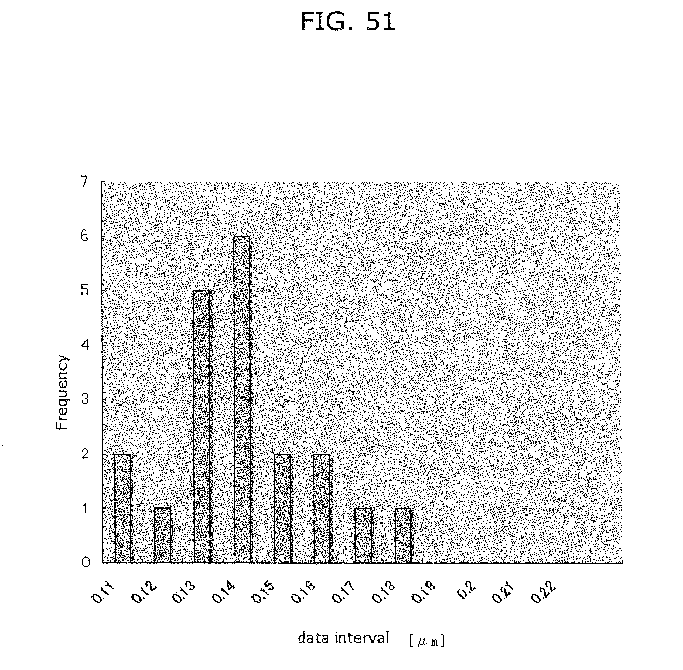

Fig. 51 is a diagram illustrating that, in the method of the third embodiment according to the present invention, particles which are obtained by a mixing supercritical water and a solution in which propionaldehyde is added to uranium solution containing tetravalent uranium to progress a hydrothermal reaction over about 33 seconds, shown in the photo in Fig. 49, have a nearly constant average diameter being 0.15µm;

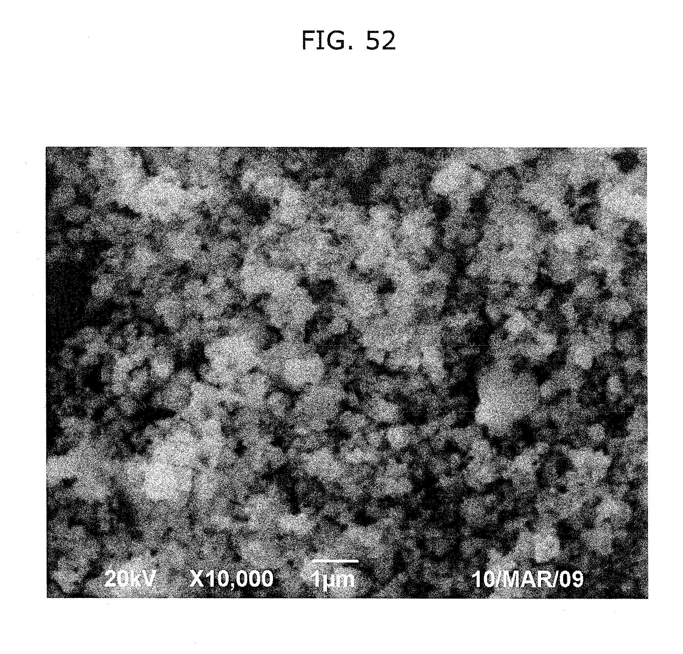

Fig. 52 is a diagram illustrating a photo taken with the scanning electron microscope (SEM), in the method of the third embodiment according to the present invention, illustrating that fine particles can be manufactured by mixing supercritical water and a solution in which propionaldehyde is added to uranium solution containing tetravalent uranium to progress a hydrothermal reaction over about 65 seconds;

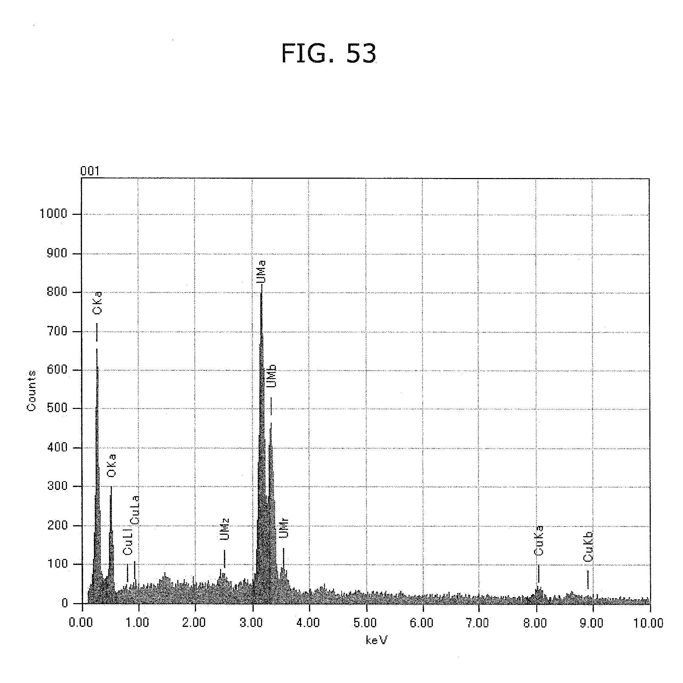

Fig. 53 is a diagram illustrating a result from the energy dispersive x-ray spectroscopy method, in the method of the third embodiment according to the present invention, illustrating the crystal obtained by a mixing supercritical water and a solution in which propionaldehyde is added to uranium solution containing tetravalent uranium to progress a hydrothermal reaction over about 65 seconds, shown in the photo in Fig. 52, contains uranium and oxygen, and also contains few impurities;

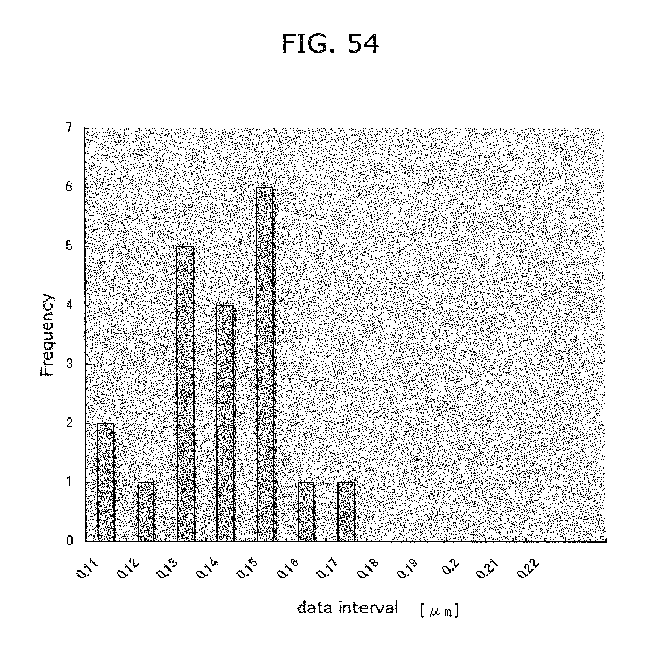

Fig. 54 is a diagram illustrating that, in the method of the third embodiment according to the present invention, particles which are obtained by a mixing supercritical water and a solution in which propionaldehyde is added to uranium solution containing tetravalent uranium to progress a hydrothermal reaction over about 65 seconds, shown in the photo in Fig. 52, have a nearly constant average diameter being 0.14µm;

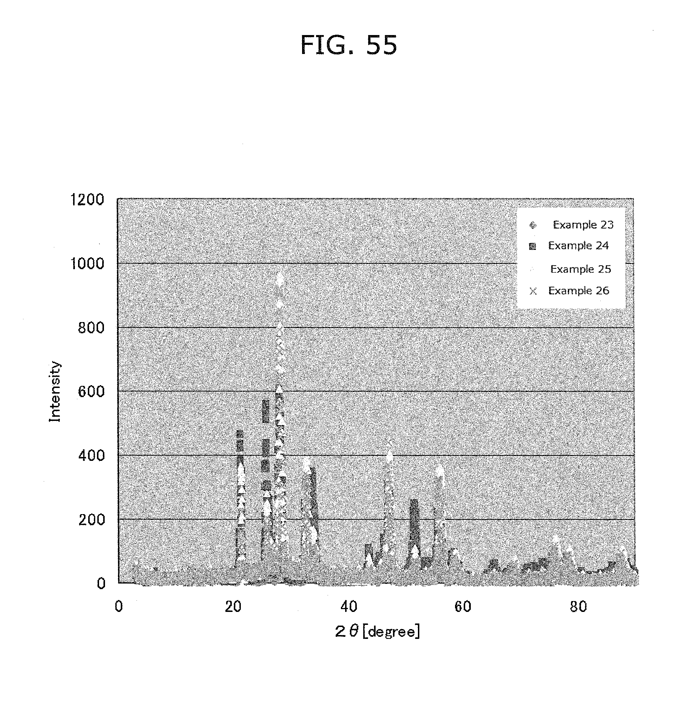

Fig. 55 is a diagram illustrating a result obtained by the X-ray diffraction method, in the method of the third embodiment according to the present invention, illustrating that particles which are obtained by a mixing supercritical water and solution in which propionaldehyde is added to uranium solution containing tetravalent uranium, include uranium dioxide and triuranium octoxide, and more than 90% of the products is actinide dioxide when an operation time of the hydrothermal reaction exceed to 65 seconds; and

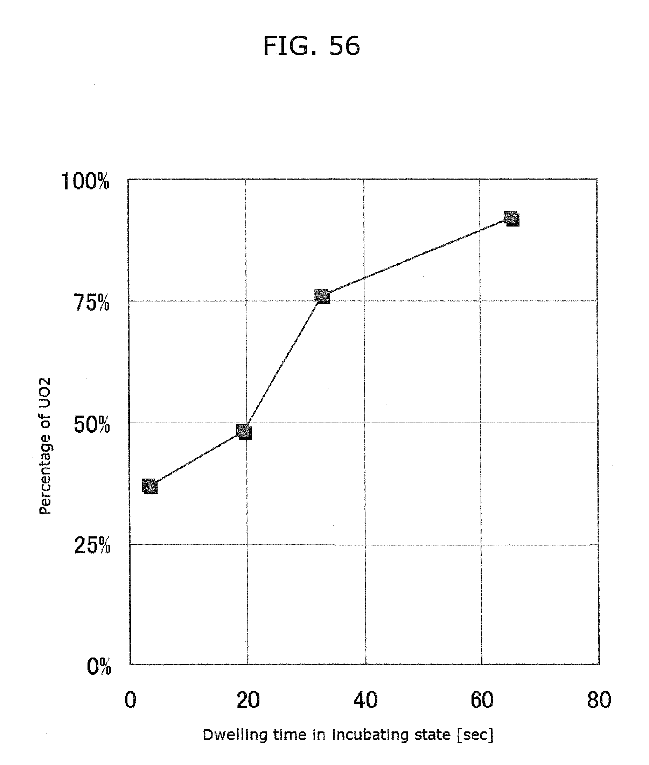

Fig. 56 is a diagram illustrating, in the method of the third embodiment according to the present invention, a percentage of uranium dioxide over the operation time of the hydrothermal reaction in uranium oxide particles which are obtained by mixing supercritical water and a solution in which propionaldehyde is added to uranium solution containing tetravalent uranium.

### Description of Embodiments

### (General Description)

To achieve the above object, according to one embodiment of a method for manufacturing an actinide oxide particle having a fluorite crystal structure according to the invention, includes mixing an actinide solution and an organic material; placing the actinide solution mixed with the organic material under high temperature and high pressure environment; and cooling the actinide solution mixed with the organic material.

The term "actinide" refers, in general, one of 15 elements including actinium, thorium, protactinium, uranium, neptunium, plutonium, americium, curium, berkelium, californium, einsteinium, fermium, mendelevium, nobelium, and lawrencium. In particular, the term "actinide" refers actinide, thorium, uranium, neptunium, plutonium, americium, and curium which may be used in nuclear power generation utilizing nuclear fission.

Organic material, as discussed below, may work as a reducing agent, an additive agent or a surface modifier.
The reducing agents are reagents that are used to promote the progress of chemical reactions including a reduction reaction that reduces the oxidation number of an atom.
The additive agent are used in a chemical reaction process so as to select or control the chemical properties such as chemical composition, chemical structure of the reaction product, and/or select or control the physical properties such as outer shape, size of the reaction product. The additive also contains a reducing agent. However, the reduction reaction is called a reducing agent rather than the additive reagents when the intended use of the reagent is limited to the promotion of the chemical reaction.

In the high temperature and high pressure water, because, while a solubility for the solute in general may be high, a smaller dielectric constant may lead to lower solubility of metal oxides, it is possible to produce the metal oxide particles.

Also, in high temperature and high pressure water, there is a characteristic feature in which the thermal conductivity is large in comparison with the gas phase, and the diffusion coefficient can be quite large in comparison with the liquid phase. Therefore, it is possible to achieve an uniform reaction condition in the reactor so that it would be expected that increase of the size distribution of the particles and variation in the shape of the particles which may be caused by the temperature gradient, pressure gradient, the concentration variation, and etc, may be prevented

In general, it is possible that actinide may have oxidation number different from 4. For example, when actinide is uranium, there are uranium trioxide, triuranium octoxide, for example, in addition to uranium dioxide.
In general, actinide such as thorium, protactinium, uranium, neptunium, plutonium, americium, curium can form actinide dioxide having a fluorite crystal structure. Accordingly, in the present application, "actinide oxide having a fluorite crystal structure" may include the actinide dioxide.

However, a hydrothermal synthesis reaction may proceed in actinide aqueous solution by mixing an organic material into the actinide aqueous solution and placing the actinide solution containing the organic material under high temperature and high pressure environment, so that crystal of actinide oxide having a fluorite crystal structure can be selectively manufactured.

In another embodiment of a method for manufacturing an actinide oxide particle having a fluorite crystal structure according to the present invention, the method including mixing actinide solution and an organic material; placing the actinide solution mixed with the organic material under high temperature and high pressure environment; and cooling the actinide solution mixed with the organic material, wherein the actinide oxide particle has the fluorite crystal structure and has at least one of a predetermined size and a predetermined shape.

Under high temperature and high pressure environment, an uniform field is provided such that a hydrothermal reaction proceeds in the actinide aqueous solution containing the organic material and crystals of metal oxide having uniform size may be manifactured.

In this document, a "shape" of crystal of actinide oxide or actinide oxide particle may include spherical shape, cubic shape, or rectangular shape.
The shape of the crystal of the actinide oxide or the actinide oxide particle can be controlled by organic material added to the actinide aqueous solution.

When the hydrothermal reaction described above is progressed in the actinide solution containing organic material, size and/or shape of product, that is, the crystal of the actinide oxide can be controlled because the organic material may work as surface modifier.
That is, the organic material can be chemically bonded to the surface of the nucleus of the oxide actinide, wherein the nucleus may be produced as the outcome of the nucleation process in actinide aqueous solution, and the size and the shape of the crystal of the actinide oxide can be controlled in crystal growth process occurring subsequent to nucleation process.
Of course, the size and the shape of the crystal of the actinide oxide that are generated as a result of the hydrothermal reaction may depend on not only the type of the organic material to be added, but also other conditions such as the acidity of the aqueous actinides (e.g., value of pH).

According to such a method, it is possible to selectively manufacture the crystal of actinide oxide or the actinide oxide particle having the fluorite crystal structure according to the present invention, the method including mixing the actinide solution and an organic material; placing the actinide solution mixed with the organic material under high temperature and high pressure environment to progress the hydrothermal reaction while the organic material may work as an additive agent or a surface modifier during the hydrothermal reaction; and cooling the actinide solution mixed with the organic material, wherein the actinide oxide particle having the fluorite crystal structure has at least one of a predetermined size and a predetermined shape.

According to another embodiment of a method for manufacturing an actinide oxide particle having a fluorite crystal structure according to the invention, the method including mixing actinide solution and an organic material; placing the actinide solution mixed with the organic material under high temperature and high pressure environment; and cooling the actinide solution mixed with the organic material, wherein the crystal of the actinide oxide is used as nuclear fission fuel for nuclear power generation.

That is, in this document, "actinide oxide" may be used in power generation using nuclear fission. In particular, actinide oxides may be used as not only a fuel, but also used to product control rods for nuclear fission of nuclear fuel.

According to such a method, it is possible to produce actinide oxide that may be used as fuel for nuclear power easily.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein the actinide solution mixed with the organic material is mixed with a high temperature and high pressure water to place the actinide solution mixed with the organic material under high temperature and high pressure environment.

According to such a method, it is possible to selectively and continuously manufacture crystals of actinide oxide or actinide oxide particles having the fluorite crystal structure according to the present invention, the method including mixing the actinide solution and an organic material; mixing high temperature and high pressure fluid and the actinide solution such that the actinide solution containing the organic material can be placed under high temperature and high pressure environment quickly, wherein each of the crystals of actinide oxide or the actinide oxide particles may have not only the fluorite crystal structure and at least one of a predetermined size and a predetermined shape, but also a predetermined distribution of the crystals or the particles.

In this document, "high temperature and high pressure fluid" mentioned above may refer to fluid having a high temperature and high pressure condition. The fluid may include water, alcohols such as methanol or ethanol, ammonia, and etc..

According to other embodiment of a method for manufacturing crystal of actinide oxide having a fluorite crystal structure according to the invention, the method including mixing actinide solution and an organic material; placing the actinide solution mixed with the organic material under high temperature and high pressure environment; and cooling the actinide solution mixed with the organic material, wherein the actinide solution includes impurities, and the crystal of the actinide oxide is retrieved in solid phase.

According to such a method, by utilizing the difference between solubilities of the actinide oxide and the impurities in the high temperature and high pressure fluid, the crystal of the actinide oxide having a predetermined shape and a predetermined size, and having the fluorite crystal structure can be retrieved and the impurities such as alkali metal can be still dissolved in the solution.

Therefore, according to this embodiment, alkali metal can be separated from a solution that is obtained by separating rare earth metals, platinum group metals, and alkaline earth metals from spent nuclear fuel of nuclear power generation.

Therefore, according to this embodiment, the spent nuclear fuel can be separated from the fission products of nuclear power generation.

According to other embodiment of a method for manufacturing actinide oxide particle having a fluorite crystal structure according to the invention, the method including mixing actinide solution and an organic material; placing the actinide solution mixed with the organic material under high temperature and high pressure environment; and cooling the actinide solution mixed containing the organic material, wherein the actinide solution is one of thorium aqueous solution, uranium aqueous solution, neptunium aqueous solution, plutonium aqueous solution, americium aqueous solution, curium aqueous solution or a mixture thereof.

Thus, "actinide oxide crystal having a fluorite crystal structure" may include thorium dioxide, protactinium dioxide, uranium dioxide, neptunium dioxide, plutonium dioxide, americium dioxide, and curium dioxide.

According to such a method, it is possible to selectively manufacture the crystal of thorium dioxide, protactinium dioxide, uranium dioxide, neptunium dioxide, plutonium dioxide, americium dioxide, and curium dioxide having the fluorite crystal structure according to the present invention, the method including mixing the actinide solution and the organic material; placing the actinide solution mixed with the organic material under high temperature and high pressure environment to progress the hydrothermal reaction; and cooling the actinide solution mixed with the organic material.

According to other embodiment of a method for manufacturing an actinide oxide particle having a fluorite crystal structure according to the invention, the method including mixing actinide solution and an organic material; placing the actinide solution mixed with the organic material under high temperature and high pressure environment; and cooling the actinide solution mixed with the organic material, wherein the organic material is selected from an alcohol derivative, an aldehyde derivative, a carboxylic acid derivative, an amine derivative, an amino acid derivative, an imine derivative, an amide derivative, a nitrile derivative, and a suger derivative.

According to such methods, these organic materials can serve as a reducing agent in an actinide aqueous solution. For example, when, in a solution containing one or more of these organic materials, the oxidation number of the actinide is larger than 4, and actinide oxide MO^{z-} (z=1 for pentavalent actinides, and z=2 for hexavalent actinoids) is formed, and the reduction reaction expressed as:

MO₂A_{z} -> MA₄ (10)

can proceed prior to occurring the hydrothermal reaction. The reduction reaction represented by chemical reaction equation (10) reduces the oxidation number of the actinide larger than 4 into 4, and subsequently the hydrothermal reaction would proceed.

According to other embodiment of a method for manufacturing actinide oxide particle having a fluorite crystal structure according to the invention, the method including mixing actinide solution and an organic material; placing the actinide solution mixed with the organic material under high temperature and high pressure environment; and cooling the actinide solution mixed with the organic material, wherein the shape of the crystals of the actinide oxide depends on the organic material.

According to such a method, the organic material can be chemically bonded to the surface of the nucleus of the oxide actinide, wherein the nucleus may be generated as the outcome of the nucleation process in the actinide aqueous solution, and the size and shape of the crystal of actinide oxide can be controlled in the crystal growth process occurring subsequent to the nucleation process.

According to such a method, it is possible to selectively manufacture the crystal of the actinide oxide or actinide oxide particles having the fluorite crystal structure according to the present invention, the method including mixing the actinide solution and the organic material; mixing the high temperature and high pressure fluid and the actinide solution such that the actinide solution containing the organic material can be placed under high temperature and high pressure environment quickly, wherein each of the crystals of the actinide oxide or the actinide oxide particles may have not only the fluorite crystal structure has at least one of a predetermined size and a predetermined shape, but also a predetermined distribution of the crystals or the particles.

According to other embodiment of a method for manufacturing crystal of the actinide oxide or actinide oxide particle having a fluorite crystal structure according to the invention, the method including mixing actinide solution and an organic material; placing the actinide solution mixed with the organic material under high temperature and high pressure environment; and cooling the actinide solution mixed with the organic material, wherein the size of the crystal of the crystal of the actinide oxide or the actinide oxide particle is of a fine particle or a superfine particle being in micrometer order.

In this document, "size" of the actinide oxide crystal may be sized to define the particle or ultrafine particle.
In general, a "fine particle" refers to particles of grain size from 1 to 1000 micrometers. A "superfine particle" refers to particles having grain size from 1 to 1000 nanometers.
In particular, the present document, a "predetermined size," may refer to the value of the order of 1 to 100 micrometers. It is known that actinide oxide particles having this size, particularly uranium dioxide particles, may be suitable as fuel for power generation using nuclear fission.
The size of the crystal of actinide oxide may be controlled by organic material added to actinide solution. In addition, it may be controlled by the temperature of the actinide solution containing the organic material. For example, temperature change in a heating process in which the temperature is increased from room temperature to high temperature to realize a high temperature and high pressure condition, or in a cooling and depressurizing process in which temperature and pressure are decreased from a high temperature and high pressure condition to a normal condition, would be relevant to control of the size of the crystal of the actinide oxide.

According to other embodiment of a method for manufacturing an actinide oxide particle having a fluorite crystal structure according to the invention, the method including mixing actinide solution and an organic material; placing the actinide solution mixed with the organic material under high temperature and high pressure environment; and cooling the actinide solution mixed with the organic material, wherein actinide in an actinide aqueous solution is pentavalent or hexavalent, and the actinide aqueous solution containing the carbonate.

According to this method, actinide in actinide aqueous solution forms actinide carbonate complex or actinide carbonate salt.

When a metal carbonate aqueous solution containing actinide carbonate complex or actinide carbonate salt and the oxidation number of the actinide is 4, letting M an actinide, the hydrothermal reaction process including hydrolysis (11), the oxide reaction (12) and dehydration (13);

MCO₃ +4 H₂O ↔ M (OH)₄ +4 HA (11)

M (OH)₄ ↔ MOy -(OH)_{2(1-y)} ↔ MO₂.2H₂O (12)

MO₂.2H₂O ↔ MO₂ (13)

may proceed.

Further, when the oxidation number of the actinide is larger than 4, and actinide-oxide MO^{z-} (z=1 for pentavalent actinides, and z=2 for hexavalent actinoids) is formed, the reduction reaction expressed as:

MO₂CO₃ -> M (CO₃)₂ (14)

can proceed prior to occurring the reduction reaction represented by chemical reaction equations (11)-(13). In general, the reduction reaction represented as chemical reaction equation (11) may proceed at a temperature at which the hydrothermal synthesis reaction (8)-(10) may proceed.

That is, when actinide oxide particle having a predetermined size and a predetermined shape and having a fluorite crystal structure is manufactured from actinide solution by the reduction reaction represented as chemical reaction equation (14) and the hydrothermal synthesis reaction represented as chemical reaction equations (11)-(13), a "high temperature and high pressure condition" may refer to higher temperature and higher pressure condition than the case where crystal of the actinide oxide is manufactured only by the hydrothermal synthesis reactions (11)-(13).

According to this embodiment, the hydrothermal synthesis reaction represented as chemical reaction equations (11)-(13) or chemical reaction equations (11)-(14) may proceed while the organic material may work as an additive agent or a surface modifier during the hydrothermal reaction, so that it is possible to selectively manufacture an crystal of actinide oxide or an actinide oxide particle having the fluorite crystal structure and having a predetermined size and a predetermined shape.

Also, in the conventional manner, when spent fuel of nuclear power generation is dissolved in carbonate aqueous solution, many fission products such as rare earth metal, platinum group metal, alkaline earth metal and etc., may be precipitated as hydroxide precipitation or carbonate precipitation, and when the actinide is prepared to be pentavalent or hexavalent, a specific carbonate complex corresponding to the actinide is formed and dissolved in the actinide solution, and alkali metal such as sodium, cesium, rubidium, and etc., may also be dissolved similar to the actinide.
However, by utilizing the difference between solubilities of the actinide oxide and alkali metal in the high temperature and high pressure fluid, crystal of the actinide oxide having a predetermined shape and a predetermined size, and having a fluorite crystal structure can be retrieved while alkali metal can be still dissolved in the solution.

According to such a method, by utilizing the difference between solubilities of the actinide oxide and alkali metal in the high temperature and high pressure fluid, the crystal of the actinide oxide having the predetermined shape and the predetermined size, and having the fluorite crystal structure can be retrieved while alkali metal can be still dissolved in the solution.

Therefore, according to this embodiment, it is possible to separate alkali metal form aqueous solution in which rare earth metal, platinum group metal, alkaline earth metal and/or etc. have been separated from spent nuclear fuel for nuclear power generation, so that fission product (FP) separation can be performed efficiently.

According to other embodiment of a method for manufacturing an actinide oxide particle having a fluorite crystal structure according to the invention, the method including mixing actinide solution and an organic material; placing the actinide solution mixed with the organic material under high temperature and high pressure environment; and cooling the actinide solution mixed with the organic material, wherein the actinide in the actinide solution is actinide or actinide complexes having a positive oxidation number larger than 4, and a hydrothermal synthesis reaction of the actinide oxide proceeds by placing the actinide solution mixed with the organic material.

When the oxidation number of the actinide is 4, letting M be actinide and A be anions such as NO³⁻, CO₃²⁻, hydrothermal reaction including the hydrolysis reaction (14), the oxide reaction (15) and the dehydration reaction (16);

MA₄ +4 H₂O ↔ M (OH)₄ +4 HA (14)

M (OH)₄ ↔ MO_{y} (OH)_{2(1-y)} ↔ MO₂.2H₂O (15)

MO₂.2H₂O ↔ MO₂ (16)

may proceed. Conversely, in this embodiment, a "high temperature and high pressure" can be defined as a temperature and a pressure at which the hydrothermal reaction including the hydrolysis reaction (14), the oxide reaction (15) and the dehydration reaction (16) can proceed. A typical temperature at which the hydrothermal reaction can proceed may be of 100-300 degrees Celsius.

In the case where the actinide oxidation number is of tetravalent instead of tetravalent, a hydrothermal synthesis reaction represented by:

MA₃ +3 H₂O ↔ M (OH)₃ +3 HA (17)

2M (OH)₃ ↔ 2MO_{y} (OH)_{3(1-y)} ↔ M₂O₃.3H₂O (18)

M₂O₃.3H₂O ↔ M₂O₃ (19)

may proceed instead of the hydrothermal synthesis reaction represented by the chemical reaction equations (14)-(16). In this case, a "high temperature and high pressure" can be defined as a temperature and a pressure at which the hydrothermal reaction including hydrolysis reaction (17), the oxide reaction (18) and the dehydration reaction (19) can proceed. A typical temperature at which the hydrothermal reaction can proceed may be of 100-300 degrees Celsius.

According to this embodiment, the hydrothermal synthesis reaction represented as the chemical reaction equations (14)-(16) or the chemical reaction equations (17)-(19) may proceed while the organic material may work as an additive agent or a surface modifier during the hydrothermal reaction, so that it is possible to selectively manufacture the crystal of actinide oxide or the actinide oxide particle having the fluorite crystal structure and having the predetermined size and the predetermined shape.

According to other embodiment of a method for manufacturing actinide oxide particle having a fluorite crystal structure according to the invention, the method including mixing actinide solution and an organic material; placing the actinide solution mixed with the organic material under high temperature and high pressure environment; and cooling the actinide solution mixed with the organic material, wherein the actinide in the actinide solution is actinide or actinide complexes having a positive oxidation number larger than 4, and a reduction reaction of the actinide oxide and a following hydrothermal synthesis reaction of the actinide oxide proceed by placing the actinide solution mixed with the organic material.

If the oxidation number of actinide oxide is greater than 4, in addition to the hydrothermal synthesis reaction represented as the chemical reaction equations (14)-(16) or a hydrothermal synthesis reaction represented as the chemical reaction equations (17)-(19), a process for reducing the actinide to tetravalent actinide may be needed.
For example, when actinide has the number of oxidation greater than 4 and actinide oxide MO^{z-} (z=1 for pentavalent actinide, and z=2 for hexavalent actinoid) are formed in aqueous solution,, a reduction reaction represented by;

MO₂A_{z} → MA₄ (20)

may be needed to proceed prior to the hydrothermal synthesis reaction represented as the chemical reaction equations (14)-(16) or the hydrothermal synthesis reaction represented as the chemical reaction equations (17)-(19). In general, the reduction reaction represented by the chemical reaction equation (20) can proceed at a temperature higher than the temperature at which a hydrothermal synthesis reaction can proceed. A temperature higher than 360 degrees Celsius can be illustrated as a temperature at which the reduction reaction represented by the chemical reaction equation (20) can proceed.
Therefore, when the reduction reaction represented by the chemical reaction equation (20) and the hydrothermal synthesis reaction represented as the chemical reaction equations (14)-(16) or the chemical reaction equations (17)-(19) can proceed to manufacture actinide oxide particle having a fluorite crystal structure
Therefore, when an actinide oxide particle having a predetermined size and a predetermined shape and having a fluorite crystal structure is manufactured from a actinide solution by the reduction reaction represented as chemical reaction equation (20) and the hydrothermal synthesis reaction represented as the chemical reaction equations (14)-(16) or the chemical reaction equations (17)-(19), a "high temperature and high pressure condition" may refer to higher temperature and/or higher pressure condition than a case a crystal of actinide oxide is manufactured only by the hydrothermal synthesis reaction (14)-(16).

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein the hydrothermal synthesis reaction of the actinide oxide proceeds at a temperature higher than or equal to 100 degrees Celsius.

According to this embodiment, the hydrothermal synthesis reaction represented as the chemical reaction equations (14)-(16) or the chemical reaction equations (17)-(19) should be progressed by mixing an actinide solution and an organic material and adjusting the temperature of the actinide solution with the organic material to a temperature higher than or equal to 100 degrees Celsius.
It may be preferable that the hydrothermal synthesis reaction represented as the chemical reaction equations (14)-(16) or the chemical reaction equations (17)-(19) should be progressed by pacing the actinide solution with the organic material in an autoclave, and adjusting the temperature in the autoclave to a temperature higher than or equal to 100 degrees Celsius. It is possible to selectively manufacture an crystal of actinide oxide or an actinide oxide particle having the fluorite crystal structure and having a predetermined size and a predetermined shape not only by placing the actinide solution with the organic material in an autoclave and adjusting the temperature in the autoclave to a temperature higher than or equal to 100 degrees Celsius, but also by placing the actinide solution with the organic material under a high temperature and high pressure environment which may depend on the volume of the autoclave and the volume of the solution to ensure that the hydrothermal reaction may proceed.

Preferably, as described below, a temperature of an actinide solution may be adjusted to be higher than or equal to 100 degrees Celsius by mixing the actinide solution with an organic material with a high temperature and high pressure water.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein the hydrothermal synthesis reaction of the actinide oxide proceeds at a temperature higher than or equal to 200 degrees Celsius.

According to this embodiment, the hydrothermal synthesis reaction represented as the chemical reaction equations (14)-(16) or the chemical reaction equations (17)-(19) should be progressed by mixing an actinide solution and an organic material and adjusting the temperature of the actinide solution with the organic material to a temperature higher than or equal to 200 degrees Celsius.
As a specific method, as described above, it is possible to utilize one of a method in which the actinide solution would be placed in a autoclave, a method in which the actinide solution would be mixed with a high temperature and high pressure water, and the like.

According to this embodiment, the hydrothermal synthesis reaction represented as the chemical reaction equations mentioned above should be progressed by mixing an actinide solution and an organic material and adjusting the temperature of the actinide solution with the organic material to a temperature higher than or equal to 200 degrees Celsius.
It may be preferable that the hydrothermal synthesis reaction represented as the chemical reaction equations (14)-(16) or the chemical reaction equations (17)-(19) should be progressed by pacing the actinide solution with the organic material in an autoclave, and adjusting the temperature in the autoclave to a temperature higher than or equal to 200 degrees Celsius. It is possible to selectively manufacture an crystal of actinide oxide or an actinide oxide particle having the fluorite crystal structure and having a predetermined size and a predetermined shape not only by placing the actinide solution with the organic material in an autoclave and adjusting the temperature in the autoclave to a temperature higher than or equal to 200 degrees Celsius, but also by placing the actinide solution with the organic material under a high temperature and high pressure environment which may depend on the volume of the autoclave and the volume of the solution to ensure that the hydrothermal reaction may proceed.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein a reaction time during which a hydrothermal reaction proceeds is longer than or equal to 1 minute.

For example, it is possible to progress hydrothermal synthesis reaction of uranium dioxide (UO2) having fluorite crystal structure to manufacture an uranium oxide by mixing an organic material with uranium solution and placing the uranium solution with the organic material if a reaction time during which a hydrothermal reaction proceeds is longer than or equal to 1 minute.

According to this embodiment, the hydrothermal synthesis reaction represented as the chemical reaction equations (14)-(16) mentioned above should be progressed while the organic material may work as an additive agent or a surface modifier during the hydrothermal reaction by mixing an actinide solution and an organic material and placing the uranium solution with the organic material over a reaction time shorter than or equal to 30 minutes, so that it is possible to selectively manufacture an crystal of actinide oxide or an actinide oxide particle having the fluorite crystal structure and having a predetermined size and a predetermined shape.

If the oxidation number of actinide oxide is greater than 4, in addition to a hydrothermal synthesis reaction represented as chemical reaction equations (14)-(16) or a hydrothermal synthesis reaction represented as chemical reaction equations (17)-(19), it is needed that the reduction reaction represented by the chemical equation (20) should proceed.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein a hydrothermal synthesis reaction for producing an actinide oxide may proceed by placing the actinide solution with the organic material in an autoclave and increasing the temperature in the autoclave to a predetermined value to place the actinide solution with the organic material under a high temperature and high pressure condition.

According to this embodiment, the hydrothermal synthesis reaction represented as the chemical reaction equations (14)-(16) should be progressed by placing the actinide solution with the organic material in an autoclave and adjusting the temperature in the autoclave to a temperature higher than or equal to 100 degrees Celsius.
It is possible to selectively manufacture an crystal of actinide oxide or an actinide oxide particle having the fluorite crystal structure and having a predetermined size and a predetermined shape not only by placing the actinide solution with the organic material in an autoclave and adjusting the temperature in the autoclave to a temperature higher than or equal to 100 degrees Celsius, but also by placing the actinide solution with the organic material under a high temperature and high pressure environment which may depend on the volume of the autoclave and the volume of the solution to ensure that the hydrothermal reaction may proceed.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein the hydrothermal synthesis reaction of the actinide oxide and the reduction reaction of the actinide oxide proceed under a high temperature and high pressure environment in which water is in supercritical or subcritical condition.

In general, a matter may be in solid, liquid, and gaseous state, called the three states of matter, depending on a temperature and pressure condition. The maximum temperature and pressure at which phase transition may occur between liquid phase and solid phase is called as a gas-liquid critical point of a substance or critical point. A supercritical state may be achieved beyond the critical point. When the gas in the supercritical state is compressed, it is not possible to reach liquid phase by definition of the supercritical state, but to obtain a fluid having a large density. For example, the critical temperature of water is 347 degrees Celsius and the critical pressure is 22.1MPa, and water may not be condensed and but may be a supercritical water.
Supercritical fluid includes features:
(1) very large hydrothermal reaction rate,
(2) low dielectric constant, and
(3) small ion product.
In general, as the dielectric constant becomes lower, the hydrothermal reaction can proceed more easily if the temperature is the same. Further, the solubility of actinide oxides in supercritical fluids is very low due to a low dielectric constant. That is, the hydrothermal reaction in supercritical fluid is rapidly progressing, a high degree of supersaturation can be obtained while the solubility of actinide oxide is the product of hydrothermal synthesis is low. A high degree of supersaturation means that, the nucleation rate may be high and, it may be a place suitable for the synthesis of actinide oxide particles in supercritical fluids.

And the subcritical fluid is located in a phase diagram of a substance between the liquid and supercritical state. Subcritical fluid includes feature:
(4) large ion product.
This feature, i.e, a large ion product, leads to a tendency that the hydrothermal reaction may proceed easily.

Under a condition where water is supercritical or subcritical, dissociation of water is significantly increased such as water acts as a strong acid to an aqueous solution of a metal salt, the metathesis reaction of the metal salt or hydrolysis reaction of metal salt may proceed very readily. In addition, under the subcritical or supercritical conditions, fluid properties such as the ionic product, the dielectric constant, the diffusion rate, the thermal conductivity may change significantly, and it is possible to easily control the size and/or the shape of the metal oxide particle may be controlled by controlling the reaction pathways and kinetics. In addition, under the subcritical or supercritical conditions, because the thermal conductivity may be large compared to the gas phase, it is possible that the diffusion coefficient can become to be quite large when compared to the liquid phase. Therefore, it is possible to realize an uniform reaction condition in the reactor, and it is possible to suppress the broadening of the distribution and the variations of the distribution of particle shape and size due to the temperature gradient, pressure gradient, the variations in concentration.

According to this embodiment, the hydrothermal synthesis reaction represented as the chemical reaction equations (14)-(16) mentioned above can be progressed under a high temperature and high pressure environment in which water is supercritical or subcritical while the organic material may work as an additive agent or a surface modifier during the hydrothermal reaction, so that it is possible to selectively manufacture an crystal of actinide oxide or an actinide oxide particle having the fluorite crystal structure and having a predetermined size and a predetermined shape.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, further including mixing a high temperature and high pressure fluid that is obtained by pressurizing and heating a fluid and a solution that is obtained by mixing an actinide aqueous solution and an organic material and heating the actinide aqueous solution with the organic material.

According to such a method, the actinide aqueous solution with the organic material can be heated by mixing with the high temperature and high pressure water. Further, if the oxidation number of actinide oxide is smaller than or equal to 4, the hydrothermal synthesis reaction represented as chemical reaction equations (14)-(16) or chemical reaction equations (17)-(19) may proceed while the organic material may work as an additive agent or a surface modifier during the hydrothermal reaction, or if the oxidation number of actinide oxide is greater than 4, in addition to a hydrothermal synthesis reaction represented as chemical reaction equations (14)-(16), it is needed that the reduction reaction represented by the chemical equation (20) should proceed.

Furthermore, according to such a method, when an actinide aqueous solution containing an organic material and high temperatures and pressure water are continuously supplied, crystals of actinide oxide having a fluorite crystal structure can be continuously manufactured.

Furthermore, according to such a method, it is possible to manufacture crystals of actinide oxide having a fluorite crystal structure and having a predetermined size and/or a predetermined shape by controlling hydrothermal synthesis conditions such as the temperature and the pressure of a high temperature and high pressure water and fluid conditions such as flow amount, flow rate.

Therefore, according to this embodiment, hydrothermal reaction proceeded by adding an organic material into the aqueous actinide solution in which the actinide is tetravalent and placing the actinide solution with the organic material under a high temperature and high pressure environment while the organic material may work as an additive agent or a surface modifier during the hydrothermal reaction, so that it is possible to selectively manufacture an crystal of actinide oxide or an actinide oxide particle having the fluorite crystal structure and having a predetermined size and a predetermined shape.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, further including mixing a supercritical or subcritical fluid that is obtained by pressurizing and heating a fluid and a solution that is obtained by mixing an actinide aqueous solution and an organic material and heating the actinide aqueous solution with the organic material.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein when mixing a supercritical or subcritical fluid that is obtained by pressurizing and heating a fluid and a solution that is obtained by mixing an actinide aqueous solution and an organic material and heating the actinide aqueous solution with the organic material, angle between a first vector and a second vector is an obtuse angle, wherein the first vector is a fluid velocity vector of the high temperature and high pressure fluid and the second vector is a fluid velocity vector of an actinide aqueous solution with the organic material that is obtained by pressurizing and heating the actinide aqueous solution with the organic material.

The sentence "angle between a first vector and a second vector is an obtuse angle, wherein the first vector is a fluid velocity vector of the high temperature and high pressure fluid and the second vector is a fluid velocity vector of an actinide aqueous solution with the organic material that is obtained by pressurizing and heating the actinide aqueous solution with the organic material" may have a following means. That is, since the high temperature and high-pressure water and actinide solution containing the organic material may be mixed, the first vector and the second vector, wherein the first vector is a fluid velocity vector of the high temperature and high pressure fluid and the second vector is a fluid velocity vector of an actinide aqueous solution with the organic material that is obtained by pressurizing and heating the actinide aqueous solution with the organic material, may define a plane on which the angle between the first vector and the second vector can be defined. When this angle is in a range from 90 degrees to 180 degrees, this angle is called as an obtuse angle.

When water is used as a high temperature and pressures fluid, the density of high temperature and high pressure fluid may be, for example, about 350kg/m3 and the density of actinide aqueous solution may be, for example, bout 1000kg/m3. Although the inventors of the present invention have been founded that these two fluids frequently form a turbulent state so as to prevent these two fluids mixing, it is possible to mix the high temperature and high pressure water and the actinide aqueous solution surely because laminar flow may be formed instead of turbulence.

According to such a method, when the high temperature and high pressure water and the actinide aqueous solution is mixed, the Reynolds number of the resulting fluid may not be increased so that turbulence may not be formed. Therefore, the high temperature and high pressure water and the actinide aqueous solution is mixed such that the hydrothermal synthesis reaction represented as the chemical reaction equations (14)-(16) can be progressed continuously, so that it is possible to selectively and continuously manufacture an crystal of actinide oxide or an actinide oxide particle having the fluorite crystal structure and having a predetermined size and a predetermined shape.

According to other embodiment of a method for manufacturing an actinide oxide particle, wherein the shape of the actinide oxide crystal is one of sphere, cube, rectangular including a plate, oval, polyhedron, bell shaped.

According to such a method, the shape of the actinide oxide is controlled in a crystal growth process followed by the nucleation process in an actinide solution containing an organic material, it is possible to selectively and continuously manufacture an crystal of actinide oxide or an actinide oxide particle having the fluorite crystal structure and having a predetermined size and a predetermined shape while being unaffected by a condition where the hydrothermal synthesis reaction represented as the chemical reaction equations (14)-(16) is progressed.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein the actinide solution contains an impurity, and the crystal of the actinide oxide particle is taken out as a solid crystal.

The term "impurity" may refer to alkali metals such as cesium, rubidium, sodium and etc... In particular, the impurity may refer to fission products other than rare earth metals such as lanthanum, cerium, lutetium, scandium, and yttrium, and platinum group metals such as ruthenium, rhodium, palladium, osmium, iridium, and platinum, alkaline earth metals such as calcium, strontium and barium, which may be dissolved in carbonate aqueous solution and precipitated as hydroxide salt or carbonate salt among the nuclei of the nucleus split during the nuclear fission of the fuel in nuclear power generation.

It has been known that, when spent nuclear fuel of nuclear power is dissolved in a carbonic acid solution, many species of fission products such as rare earths such as lanthanum, cerium, lutetium, scandium, and yttrium, platinum group metals such as ruthenium, rhodium, palladium, osmium, iridium, and platinum, and alkaline earth metals such as calcium, strontium and barium may be deposited as hydroxide precipitate or carbonate, and may be dissolved in solution by forming a specific actinide carbonate complexes when actinides such as uranium are adjusted to the pentavalent or hexavalent oxidation state. However, it has been known that, alkali metals such as cesium, rubidium, and sodium can be dissolved in solution, similar to the case of actinide.

However, according to this embodiment, by utilizing the difference between solubilities of the actinide oxide and alkali metals in the high temperature and high pressure fluid, crystal of the actinide oxide having a predetermined shape and predetermined size, and having a fluorite crystal structure can be retrieved and alkali metal can be still dissolved in the solution.

The term "alkali metal" may be exemplified as one of cesium, rubidium, and sodium or mixture thereof.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein a value of decontamination factor (DF) that is defined a value obtained by dividing a first radioactivity of an aqueous solution that is obtained by mixing the actinide solution that includes the impurity and the organic material before placing the aqueous solution under the high temperature and high pressure environment, by a second radioactivity of a solid phase in the aqueous solution after placing the aqueous solution under the high temperature and high pressure environment, depend on a temperature at which the aqueous solution that is obtained by mixing the actinide solution that includes the impurity and the organic material is placed.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein an actinide atom-oxygen ratio in the actinide oxide particle is a predetermined value.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein an actinide or actinide complex in the actinide solution is uranium ion or uranium complex, and uranium dioxide to be manufactured has an uranium atom-to-oxygen ratio of approximately 2.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein uranium dioxide to be manufactured has an uranium atom-to-oxygen ratio of approximately 2.04.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein an actinide or actinide complex in the actinide solution is cerium ion or cerium complex, and the generated actinide oxide is cerium dioxide.

Referring to the drawings, embodiments of a method and apparatus for manufacturing actinide oxide crystals or actinide oxide particles having a fluorite crystal structure will be described in detail. However, the present invention are not limited to the embodiments below.

### (First Embodiment)

Referring to Figs. 1-47, a embodiment of a method and apparatus for manufacturing actinide oxide crystals or actinide oxide particles having a fluorite crystal structure will be explained.
In the present embodiment, a method for manufacturing uranium dioxide from uranyl solution and cerium dioxide from cerium aqueous solution is provided.

### (General description of the first embodiment).

Fig. 1 is a schematic diagram illustrating a apparatus 100 for manufacturing actinide oxide crystals or actinide oxide particles having a fluorite crystal structure.

The reaction apparatus 100 includes an autoclave (a reactor) 10 and a temperature controller 20. The reactor 10 includes a cell 12, a heating rods 14a, 14b, 14c, 14d, a cover plate 16, and a thermocouple 18.

The autoclave or the reactor 10 is made of one of nickel, manganese, carbon, Hastelloy that are formed from an alloy of iron and chromium. Outline of the reactor 10 is substantially rectangular, and includes a substantially square top and bottom and substantially rectangular sides. The cell 12 is formed from the top of the reactor 10 to the inside of the reactor 10. That is, the cell 12 includes an opening n the top of the reactor 10. In addition, the opening of the top of the cell 12 of the reactor 10 can be sealed by lid plate 16 airprooofly. The diameter of the cells 12 is 14mm, and the depth is 70mm. The capacity of the cell 12 of the reactor 10 is 10mL.

The four heating rods, 14a, 14b, 14c, 14d, are arranged to surround the cells 12. The four heating rods, 14a, 14b, 14c, 14d are connected to the temperature controller 20 to regulate the temperature inside the cell 12. These heating rods 14a, 14b, 14c, 14d, for example, can be heated to 450 □.

One end of the thermocouple 18 is disposed in a space inside the cell 12, and another end of the heating rods 14a, 14b, 14c, has been in contact with one of the heating rods 14a, 14b, 14c, 14d. In this arrangement, electric current is generated depending on the temperature difference between the temperature in the cell 12 and one of the heating rods 14a, 14b, 14c, 14d. The temperature control unit 20 detects the difference between the temperature in the cell 12 and the one of the heating rods 14a, 14b, 14c, 14d.

The temperature controller 20 controls the one of the four heating rods 14a, 14b, 14c, 14d to adjust the temperature in the cell 12 to a value input from outside.

After a liquid is injected into the cell 12 and then the cell 12 is sealed by the cover plate 16 airproofly, the temperature of the liquid can be increased by increasing the temperature of the four heating rods 14a, 14b, 14c, 14d to a high temperature region. When the liquid is evaporated as the temperature of the liquid becomes hot such that steam is generated, it is possible to increase the partial pressure of the liquid by the vapor. That is, a liquid contained in the cell 12 can be placed under a high temperature and high pressure environment.

Fig. 2 is a diagram illustrating time variation of temperature when the actinide solution of 3mL is housed to the cell 12 having 10mL capacity shown in Figure 1 and a temperature in the cell 12 is controlled using the temperature controller 20.
As shown in Fig. 2, the temperature controller 20 of this embodiment can control to rise the temperature in the cell 12 from the room temperature to 450 degrees Celsius within 10-20 minutes.

Fig. 3 is a flowchart of the method of the first embodiment according to the present invention.

First, at S100, 2.7mL of an actinides aqueous solution is prepared. Specifically, water is added to 0.5mmol of an uranium aqueous solution or a cerium aqueous solution containing cerium or uranium to prepare 2.7mL of the uranium aqueous solution or the cerium aqueous solution. Then the process proceeds to S102.

At S102, an organic material is added to the actinide aqueous solution prepared at S100 to prepare 3mL of the uranium aqueous solution or the cerium aqueous solution containing the organic material. The organic material may be selected from alcohols, aldehydes, carboxylic acids, amines, amino acids, imines, amides, nitriles, and sugers. Specifically, in this embodiment, ethanol, ethanol, 2-propanol, propionaldehyde, glucose and etc. can be exemplified. Then the process proceeds to S104.

At S104, the actinide aqueous solution containing the organic material is housed in the cell 12 of the reactor 100 shown in Fig. 1, and the opening of the cell 12 is covered by the cover plate 16 to seal the cell 12. Then the process proceeds to S106.

At S106, the actinide aqueous solution containing the organic material is heated and pressurized to change it to a high temperature and high pressure state. Specifically, the temperature controller 20 of the reaction apparatus 100 controls the heating rods, 14a, 14b, 14c, 14d to have, for example, 450 degrees Celsius of the temperature so that the aqueous solution in the cell 12 becomes to be hot. When the aqueous solution is evaporated as the temperature of the aqueous solution becomes hot such that steam is generated and the steam applies pressure on a interface between the aqueous solution and the vapor, it is possible to increase the partial pressure of the aqueous solution by the vapor. Then the process proceeds to S108.

At S108, the state reached at the S106 is maintained for a predetermined time, for example, 30 minutes. Then the process proceeds to S110.

At S110, the temperature of the reactor 10 is cooled quickly and the pressure of the reactor 10 is lowered such that the condition in the cell 12 becomes to be a low temperature and low pressure condition. A room temperature and atmospheric condition may be exemplified as the low temperature and low pressure condition. Then the process proceeds to S112.

At S112, the solid and liquid phases are collected, respectively. Uranium dioxide or cerium dioxide is deposited on the solid phase.

That is, a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, includes;
(1) preparing the actinide solution;
(2) mixing an additive that includes the organic material into the actinide solution;
(3) adding water into the actinide solution including the additive to generate an additive-included actinide solution;
(4) placing the additive-included actinide solution in an autoclave;
(5) increasing the temperature in the autoclave in which the additive-included actinide solution is placed to a predetermined value;
(6) quenching the temperature in the autoclave in which the additive-included actinide solution is placed to a room temperature;
(7) collecting a solid phase in the additive-included actinide solution; and
(8) drying the collected solid phase under reduced pressure to retrieve a the crystal of the actinide oxide.
According to such a method, it is possible to selectively manufacture an crystal of actinide oxide or an actinide oxide particle having the fluorite crystal structure according to the present invention, the method including placing the actinide solution mixed with the organic material under high temperature, wherein the actinide oxide particle having a fluorite crystal structure has at least one of a predetermined size and a predetermined shape.

### (Example 1)

Referring to Figs. 4 to 7B, an example of the method for manufacturing uranium dioxide particles having a rectangular parallelepiped shape, according to a first embodiment of the present invention will be explained.

In this example, at S100, 2mmol of ammonium carbonate is added to uranyl nitrate containing 0.5mmol of uranium, and distilled water is further added to the mixture of the ammonium carbonate and the uranyl nitrate to prepare 2.7mL of an uranyl nitrate aqueous solution. Then at S102, 0.3mL of methanol is added to prepare 3mL of the aqueous solution. At S104, this aqueous solution is housed in the cell, and the cell is sealed by covering the opening of the cell of the reactor 100. Then, at S106, the temperature controller 20 of the reaction apparatus 100 controls the heating rods, 14a, 14b, 14c, 14d to have 450 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.

Fig. 4 is a diagram illustrating a photo taken with the scanning electron microscope (SEM), in the method of the first embodiment according to the present invention, illustrating a rectangular shaped crystal is obtained by adding methanol to an uranyl nitrate solution and placing the uranyl nitrate solution with methanol in the autoclave in which the temperature is at 450 degrees Celsius for 30 minutes.

More specifically, the photo in Fig. 4 is obtained by taking the dried solid collected at S112 with an electron microscope. Magnification of the electron microscopy is 10,000.
It can be seen that in this example, the particles having a rectangular parallelepiped shape can be obtained.

Fig. 5 is a diagram illustrating an analytical result of the dried solid collected at S112 using the X-ray diffraction method. It can be seen that in this example, the particles having a fluorite crystal structure can be obtained. Further, uranium dioxide shown in Fig. 4 has approximately 2.04 of the uranium atom-to-oxygen ratio.

Fig. 6 is a diagram illustrating an analytical result of the dried solid collected at S112 obtained by using an energy dispersive X-ray apparatus. It can be seen that uranium dioxide shown in Fig. 4 contains uranium and oxygen, and also contains few impurities.

Fig. 7A and Fig. 7B are diagrams illustrating that 10 sampled particles randomly selected from the particles shown in Fig. 4 have nearly an average constant diameter of 1.51µm in a longer axis and have a nearly constant average diameter of 0.59µm in a shorter axis, respectively.

### (Example 2)

Referring to Figs. 8 to 11, an example of the method for manufacturing uranium dioxide particles having a spherical shape, according to a first embodiment of the present invention will be explained.

In this example, at S100, 2mmol of hexyl aldehyde is added to uranyl nitrate containing 0.5mmol of uranium, and distilled water is further added to the mixture of the ammonium carbonate and the uranyl nitrate to prepare 2.7mL of an uranyl nitrate aqueous solution. Then at S102, 0.3mL of methanolis added to prepare 3mL of the aqueous solution. At S104, this aqueous solution is housed in the cell, and the cell is sealed by covering the opening of the cell of the reactor 100. Then, at S106, the temperature controller 20 of the reaction apparatus 100 controls the heating rods, 14a, 14b, 14c, 14d to have 450 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.

Fig. 8 is a diagram illustrating a photo taken with the scanning electron microscope (SEM), in the method of the first embodiment according to the present invention, illustrating a sphere shaped crystal is obtained by adding hexyl aldehyde to an uranyl nitrate solution and placing the uranyl nitrate solution with methanol in the autoclave in which the temperature is at 450 degrees Celsius for 30 methanol minutes.

More specifically, the photo in Fig. 4 is obtained by taking the dried solid collected at S112 with an electron microscope. Magnification of the electron microscopy is 10,000.
It can be seen that in this example, the particles having a spherical shape can be obtained.

Fig. 9 is a diagram illustrating an analytical result of the dried solid collected at S112 using the X-ray diffraction method. It can be seen that in this example, the crystals shown in Fig. 8 is particles of uranium dioxide having a fluorite crystal structure. Further, uranium dioxide shown in Fig. 8 has approximately 2.04 of the uranium atom-to-oxygen ratio.

Fig. 10 is a diagram illustrating an analytical result of the dried solid collected at S112 obtained by using an energy dispersive X-ray equipment. contains uranium and oxygen, and also contains few impurities. It can be seen that uranium dioxide shown in Fig. 8 contains uranium and oxygen, and also contains few impurities.

Fig. 11 is diagrams illustrating that 10 sampled particles randomly selected from the particles shown in Fig. 8 have nearly an average constant diameter of 0.22µm.

### (Example 3)

Referring to Figs. 12 to 15, an example of the method for manufacturing uranium dioxide particles having a cubical shape, according to a first embodiment of the present invention will be explained.

In this example, at S100, 2mmol of hexylamine is added to uranyl nitrate containing 0.5mmol of uranium, and distilled water is further added to the mixture of the ammonium carbonate and the uranyl nitrate to prepare 2.7mL of an uranyl nitrate aqueous solution. Then at S102, 0.3mL of methanolis added to prepare 3mL of the aqueous solution. At S104, this aqueous solution is housed in the cell, and the cell is sealed by covering the opening of the cell of the reactor 100. Then, at S106, the temperature controller 20 of the reaction apparatus 100 controls the heating rods, 14a, 14b, 14c, 14d to have 450 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.

Fig. 12 is a diagram illustrating a photo taken with the scanning electron microscope (SEM), in the method of the first embodiment according to the present invention, illustrating a sphere shaped crystal is obtained by adding hexylamine to an uranyl nitrate solution and placing the uranyl nitrate solution with methanol in the autoclave in which the temperature is at 450 degrees Celsius for 30 methanol minutes.

More specifically, the photo in Fig. 4 is obtained by taking the dried solid collected at S112 with an electron microscope. Magnification of the electron microscopy is 10,000.
It can be seen that in this example, the particles having a cubical shape can be obtained.

Fig. 13 is a diagram illustrating an analytical result of the dried solid collected at S112 using the X-ray diffraction method. It can be seen that in this example, the crystals shown in Fig. 12 is particles of uranium dioxide having a fluorite crystal structure. Further, uranium dioxide shown in Fig. 12 has approximately 2.04 of the uranium atom-to-oxygen ratio.

Fig. 14 is a diagram illustrating an analytical result of the dried solid collected at S112 obtained by using an energy dispersive X-ray equipment. contains uranium and oxygen, and also contains few impurities. It can be seen that uranium dioxide shown in Fig. 12 contains uranium and oxygen, and also contains few impurities.

Fig. 15 is diagrams illustrating that 10 sampled particles randomly selected from the particles shown in Fig. 12 have nearly an average constant diameter of 0.58µm.

### (Example 4)

Referring to Figs. 16 to 19B, an example of the method for manufacturing uranium dioxide particles having a rectangular parallelepiped shape, according to a first embodiment of the present invention will be explained.

In this example, at S100, 2mmol of ammonium carbonate is added to uranyl nitrate containing 0.5mmol of uranium, and distilled water is further added to the mixture of the ammonium carbonate and the uranyl nitrate to prepare 2.7mL of an uranyl nitrate aqueous solution. Then at S102, 0.3mL of 2-propanol is added to prepare 3mL of the aqueous solution. At S104, this aqueous solution is housed in the cell, and the cell is sealed by covering the opening of the cell of the reactor 100. Then, at S106, the temperature controller 20 of the reaction apparatus 100 controls the heating rods, 14a, 14b, 14c, 14d to have 450 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.

Fig. 16 is a diagram illustrating a photo taken with the scanning electron microscope (SEM), in the method of the first embodiment according to the present invention, illustrating a rectangular shaped crystal is obtained by adding methanol to an uranyl nitrate solution and placing the uranyl nitrate solution with 2-propanol in the autoclave in which the temperature is at 450 degrees Celsius for 30 minutes.

More specifically, the photo in Fig. 16 is obtained by taking the dried solid collected at S112 with an electron microscope. Magnification of the electron microscopy is 10,000.
It can be seen that in this example, the particles having a rectangular parallelepiped shape can be obtained.

Fig. 17 is a diagram illustrating an analytical result of the dried solid collected at S112 using the X-ray diffraction method. It can be seen that in this example, the crystals shown in Fig. 16 is particles of uranium dioxide having a fluorite crystal structure. Further, uranium dioxide shown in Fig. 16 has approximately 2.04 of the uranium atom-to-oxygen ratio.

Fig. 18 is a diagram illustrating an analytical result of the dried solid collected at S112 obtained by using an energy dispersive X-ray equipment. It can be seen that uranium dioxide shown in Fig. 16 contains uranium and oxygen, and also contains few impurities.

Fig. 19A and Fig. 19B are diagrams illustrating that 10 sampled particles randomly selected from the particles shown in Fig. 16 have nearly an average constant diameter of 2.25µm in a longer axis and have a nearly constant average diameter of 0.74µm in a shorter axis, respectively.

### (Example 5 to 8)

As to examples 5 to 8, crystals of uranium dioxide is manufactured using methods similar to examples 1 to 4 described above, and analytical results are obtained using electron microscopy, energy dispersive X-ray apparatus, and x-ray diffraction apparatusr. Only the results will be shown below

In the example 5, 2mmol of ammonium carbonate is added to uranyl nitrate containing 0.5mmol of uranium, and distilled water is further added to the mixture of the ammonium carbonate and the uranyl nitrate to prepare 2.7mL of an uranyl nitrate aqueous solution. Then 0.3mL of propionaldehyde is added to prepare 3mL of the aqueous solution. This aqueous solution is housed in the cell, and the cell is sealed by covering the opening of the cell of the reactor 100. Then, the temperature controller 20 of the reaction apparatus 100 controls the heating rods, 14a, 14b, 14c, 14d to have 450 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.
The collected solid phase are analyzed using electron microscopy, energy dispersive X-ray apparatus, and x- ray diffractometer and it can be seen that the collected solid phase are crystals of uranium dioxide having a rectangular parallelepiped shape and 10 sampled particles randomly selected from the crystals have nearly an average constant diameter of 0.22µm.

In the example 6, 2mmol of ammonium carbonate is added to uranyl nitrate containing 0.5mmol of uranium, and distilled water is further added to the mixture of the ammonium carbonate and the uranyl nitrate to prepare 2.7mL of an uranyl nitrate aqueous solution. Then 0.3mL of methanol is added to prepare 3mL of the aqueous solution. This aqueous solution is housed in the cell, and the cell is sealed by covering the opening of the cell of the reactor 100. Then, the temperature controller 20 of the reaction apparatus 100 controls the heating rods, 14a, 14b, 14c, 14d to have 450 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.
The collected solid phase are analyzed using electron microscopy, energy dispersive X-ray apparatus, and x- ray diffractometer and it can be seen that the collected solid phase are crystals of uranium dioxide having a rectangular parallelepiped shape and 10 sampled particles randomly selected from the crystals have nearly an average constant diameter of 1.70µm in a longer axis and have a nearly constant average diameter of 0.81µm in a shorter axis, respectively.

In the example 7, 2mmol of guanidine carbonate is added to uranyl nitrate containing 0.5mmol of uranium, and distilled water is further added to the mixture of the ammonium carbonate and the uranyl nitrate to prepare 2.7mL of an uranyl nitrate aqueous solution. Then 0.3mL of methanol is added to prepare 3mL of the aqueous solution. This aqueous solution is housed in the cell, and the cell is sealed by covering the opening of the cell of the reactor 100. Then, the temperature controller 20 of the reaction apparatus 100 controls the heating rods, 14a, 14b, 14c, 14d to have 450 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.
The collected solid phase are analyzed using electron microscopy, energy dispersive X-ray apparatus, and x- ray diffraction apparatus and it can be seen that the collected solid phase are crystals of uranium dioxide having a rectangular parallelepiped shape and 10 sampled particles randomly selected from the crystals have nearly an average constant diameter of 1.63µm in a longer axis and have a nearly constant average diameter of 0.88µm in a shorter axis, respectively. Further, manufactured particles of uranium dioxide have approximately 2.04 of the uranium atom-to-oxygen ratio.

Fig. 20 is a diagram illustrating a photo taken with the scanning electron microscope (SEM), in the method of the first embodiment according to the present invention, illustrating a sphere shaped crystal is obtained by adding ammonium carbonate and propionaldehyde to an uranyl nitrate solution and placing the uranyl nitrate solution with ammonium carbonate and propionaldehyde in the autoclave in which the temperature is at 450 degrees Celsius for 30 minutes.
It can be seen from this figure that particles manufactured in this example have spherical shape.

Fig. 21 is a result obtained by analyzing the crystal shown in Fig.20 using the X-ray diffraction apparatus. It can be seen from this figure that crystals manufactured in this example is uranium dioxide having a fluorite crystal structure.

Fig. 22 is a result obtained by analyzing the crystal shown in Fig.20 using energy dispersive X-ray apparatus. It can be seen from this figure that uranium dioxide contains uranium and oxygen, and also contains few impurities.

In the example 8, 2mmol of guanidine carbonate is added to uranyl nitrate containing 0.5mmol of uranium, and distilled water is further added to the mixture of the ammonium carbonate and the uranyl nitrate to prepare 2.7mL of an uranyl nitrate aqueous solution. Then 0.3mL of glucose is added to prepare 3mL of the aqueous solution. This aqueous solution is housed in the cell, and the cell is sealed by covering the opening of the cell of the reactor 100. Then, the temperature controller 20 of the reaction apparatus 100 controls the heating rods, 14a, 14b, 14c, 14d to have 450 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected. It can be seen that the collected solid phase are analyzed using electron microscopy, energy dispersive X-ray apparatus, and x- ray diffraction apparatus and it can be seen that the collected solid phase are crystals of uranium dioxide. Further, manufactured particles of uranium dioxide have approximately 2.04 of the uranium atom-to-oxygen ratio.

Fig. 23 is a diagram illustrating a photo taken with the scanning electron microscope (SEM), in the method of the first embodiment according to the present invention, illustrating a sphere shaped crystal is obtained by adding ammonium carbonate and glucose to an uranyl nitrate solution and placing the uranyl nitrate solution with ammonium carbonate and glucose in the autoclave in which the temperature is at 450 degrees Celsius for 30 minutes.

Fig. 24 is a result obtained by analyzing the crystal shown in Fig.23 using the X-ray diffraction apparatus. It can be seen from this figure that crystals manufactured in this example is uranium dioxide having a fluorite crystal structure. Further, manufactured particles of uranium dioxide have approximately 2.04 of the uranium atom-to-oxygen ratio.

Fig. 25 is a result obtained by analyzing the crystal shown in Fig.23 using energy dispersive X-ray apparatus. It can be seen from this figure that uranium dioxide contains uranium and oxygen, and also contains few impurities.

In the examples 1 to 8 wherein crystals are obtained by adding an organic material to an uranyl nitrate solution and placing the uranyl nitrate solution with ammonium carbonate and glucose in the autoclave in which the temperature is at 450 degrees Celsius for 30 minutes. the shape and the size of the uranium dioxide due to differences in the added organic material will be summarized as follows.

**[Table 1]**

| Eample | Added organic material | Shape of Size of uranium dioxide uranium (average value) dioxide |
|---|---|---|
| 1 | etanol + ammonium carbonate | rectangular 1,51µm in a longer axis parallelepiped 0.59µm in a shorter axis shape |
| 2 | etanol + hexyl aldehyde | Spherical 0,22µm in diameter shape |
| 3 | etanol + hexylamine | cubical shape 0.58µm in diameter |
| 4 | 2-propanol + ammonium carbonate | rectangular 2,25µm in a longer axis parallelepiped 0.74µm in a shorter axis shape |
| 5 | propionaldehyde + ammonium carbonate | Spherical 0.22µm in diameter shape |
| 6 | etanol + ammonium carbonate | rectangular 1.70µm in a longer axis parallelepiped 0,81µm in a shorter axis shape |
| 7 | etanol+guanidine carbonate | rectangular 1.63µm in a longer axis parallelepiped 0.88µm in a shorter axis shape |
| 8 | ammonium carbonate + glucose | fine |

### (Example 9)

Referring to Figs. 26 to 28, an example of the method for manufacturing uranium dioxide particles having a cubical shape, according to a first embodiment of the present invention will be explained.

In this example, at S100, 2mmol of hexylamine is added to uranyl nitrate containing 0.5mmol of uranium, and distilled water is further added to the mixture of the ammonium carbonate and the uranyl nitrate to prepare 2.7mL of an uranyl nitrate aqueous solution. Then at S102, 0.3mL of methanolis added to prepare 3mL of the aqueous solution. At S104, this aqueous solution is housed in the cell, and the cell is sealed by covering the opening of the cell of the reactor 100. Then, at S106, the temperature controller 20 of the reaction apparatus 100 controls the heating rods, 14a, 14b, 14c, 14d to have 390 degrees Celsius. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.
While in the example 3, the temperature controller 20 of the reaction apparatus 100 controls the heating rods, 14a, 14b, 14c, 14d to have 450 degrees Celsius, in the present example, the temperature controller 20 of the reaction apparatus 100 controls the heating rods, 14a, 14b, 14c, 14d to have 390 degrees Celsius.

Fig. 26 is a diagram illustrating a photo taken with the scanning electron microscope (SEM), in the method of the first embodiment according to the present invention, illustrating a sphere shaped crystal is obtained by adding hexylamine to an uranyl nitrate solution and placing the uranyl nitrate solution with methanol in the autoclave in which the temperature is at 390 degrees Celsius for 30 methanol minutes.
More specifically, the photo in Fig. 4 is obtained by taking the dried solid collected at S112 with an electron microscope. Magnification of the electron microscopy is 10,000.
It can be seen that in this example, the particles having a cubical shape can be obtained.

More specifically, the photo in Fig. 4 is obtained by taking the dried solid collected at S112 with an electron microscope. Magnification of the electron microscopy is 10,000.
It can be seen that in this example, the particles having a cubical shape can be obtained.

Fig. 27 is a diagram illustrating an analytical result of the dried solid collected at S112 using the X-ray diffraction method. It can be seen that in this example, the crystals shown in Fig. 26 is particles of uranium dioxide having a fluorite crystal structure, and the particles of uranium dioxide have approximately 2.04 of the uranium atom-to-oxygen ratio.

Fig. 28 is diagrams illustrating that 10 sampled particles randomly selected from the particles shown in Fig. 26 have nearly an average constant diameter of 0.44µm.

### (Example 10)

Referring to Figs. 29 to 31B, an example of the method for manufacturing uranium dioxide particles having a rectangular parallelepiped shape, according to a first embodiment of the present invention will be explained.

In this example, at S100, 2mmol of ammonium carbonate is added to uranyl nitrate containing 0.5mmol of uranium, and distilled water is further added to the mixture of the ammonium carbonate and the uranyl nitrate to prepare 2.7mL of an uranyl nitrate aqueous solution. Then at S102, 0.3mL of 2-propanol is added to prepare 3mL of the aqueous solution. At S104, this aqueous solution is housed in the cell, and the cell is sealed by covering the opening of the cell of the reactor 100. Then, at S106, the temperature controller 20 of the reaction apparatus 100 controls the heating rods, 14a, 14b, 14c, 14d to have 390 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.

Fig. 29 is a diagram illustrating a photo taken with the scanning electron microscope (SEM), in the method of the first embodiment according to the present invention, illustrating a rectangular shaped crystal is obtained by adding methanol to an uranyl nitrate solution and placing the uranyl nitrate solution with 2-propanol in the autoclave in which the temperature is at 390 degrees Celsius for 30 minutes.

More specifically, the photo in Fig. 16 is obtained by taking the dried solid collected at S112 with an electron microscope. Magnification of the electron microscopy is 10,000.
It can be seen that in this example, the particles having a rectangular parallelepiped shape can be obtained.

Fig. 30 is a diagram illustrating an analytical result of the dried solid collected at S112 using the X-ray diffraction method. It can be seen that in this example, the crystals shown in Fig. 29 is particles of uranium dioxide having a fluorite crystal structure.

Fig. 31A and Fig. 31B are diagrams illustrating that 10 sampled particles randomly selected from the particles shown in Fig. 16 have nearly an average constant diameter of 1.97µm in a longer axis and have a nearly constant average diameter of 0.96µm in a shorter axis, respectively.

In the examples 1 to 10 discussed above, the actinide aqueous solution is heated to 390 degrees Celsius in the cell 12 of the reactor 10.
If the oxidation number of actinide oxide is greater than 4, in addition to a hydrothermal synthesis reaction represented as chemical reaction equations (14)-(16) or a hydrothermal synthesis reaction represented as chemical reaction equations (17)-(19), a process for reducing to a tetravalent actinide may be needed. In the examples discussed above, when in aqueous solution, an actinide has the number of oxidation greater than 4 and actinide oxide MOz- (z=1 for pentavalent actinides, and z=2 for hexavalent actinoids) are formed, a reduction reaction represented by chemical reaction equation (20) may be needed to proceed prior to the hydrothermal synthesis reaction represented as the chemical reaction equations (14)-(16) or the hydrothermal synthesis reaction represented as the chemical reaction equations (17)-(19).
Therefore, regardless of the oxidation number of actinide in the actinide aqueous solution, 3mL of an actinide aqueous solution is housed in the cell 12 of the reactor 10 having 10mL of capacity and heated to a temperature higher than the critical temperature of water, i.e., 390 degrees Celsius so that the hydrothermal synthesis reaction represented as the chemical reaction equations (14)-(16) may proceed. Further because the organic material may work as an additive agent or a surface modifier during the hydrothermal reaction, it is possible to selectively manufacture crystals of actinide oxide or an actinide oxide particle having the fluorite crystal structure.

### (Example 11)

Referring to Figs. 32 to 35, an example of the method for manufacturing uranium dioxide particles having a spehrical shape, according to a first embodiment of the present invention will be explained.

In this example, at S100, uranium solution containing 0.5mmol of tetravalent uranium is prepared. Then 0.3mL of propionaldehyde is added to prepare 3mL of the aqueous solution. This aqueous solution is housed in the cell, and the cell is sealed by covering the opening of the cell of the reactor 100. Then, the temperature controller 20 of the reaction apparatus 100 controls the heating rods, 14a, 14b, 14c, 14d to have 300 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.

In this example, in contrast to examples 1 to 10, uranium solution containing 0.5mmol of tetravalent uranium is prepared at S100. Therefore, hydrothermal reaction including hydrolysis reaction (14), the oxide reaction (15) and dehydration reaction (16) proceed at S108.

Fig. 32 is a diagram illustrating a photo taken with the scanning electron microscope (SEM), in the method of the first embodiment according to the present invention, illustrating a sphere shaped crystal is obtained by adding propionaldehyde to an uranium solution containing 0.5mmol of tetravalent uranium and placing the uranium solution with propionaldehyde in the autoclave in which the temperature is at 300 degrees Celsius for 30 minutes.

More specifically, the photo in Fig. 4 is obtained by taking the dried solid collected at S112 with an electron microscope. Magnification of the electron microscopy is 10,000.
It can be seen that in this example, the particles having a spherical shape can be obtained.

Fig. 33 is a diagram illustrating an analytical result of the dried solid collected at S112 using the X-ray diffraction method. It can be seen that in this example, the crystals shown in Fig. 32 is particles of uranium dioxide having a fluorite crystal structure. Further, uranium dioxide shown in Fig. 32 have approximately 2.04 of the uranium atom-to-oxygen ratio.

Fig. 34 is a diagram illustrating an analytical result of the dried solid collected at S112 obtained by using an energy dispersive X-ray equipment. contains uranium and oxygen, and also contains few impurities. It can be seen that uranium dioxide shown in Fig. 32 contains uranium and oxygen, and also contains few impurities.

Fig. 34 is diagrams illustrating that 10 sampled particles randomly selected from the particles shown in Fig. 32 have nearly an average constant diameter of 1.07µm.

### (Example 12)

Referring to Figs. 36, an example of the method for manufacturing uranium dioxide particles having a spherical shape, according to a first embodiment of the present invention will be explained.

In this example, at S100, uranium solution containing 0.5mmol of tetravalent uranium is prepared. Then 0.3mL of propionaldehyde is added to prepare 3mL of the aqueous solution. This aqueous solution is housed in the cell, and the cell is sealed by covering the opening of the cell of the reactor 100. Then, the temperature controller 20 of the reaction apparatus 100 controls the heating rods, 14a, 14b, 14c, 14d to have 200 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.

In this example, in contrast to examples 1 to 10, uranium solution containing 0.5mmol of tetravalent uranium is prepared at S100. Therefore, hydrothermal reaction including hydrolysis reaction (14), the oxide reaction (15) and dehydration reaction (16) proceed at S108.

Fig. 32 is a diagram illustrating a photo taken with the scanning electron microscope (SEM), in the method of the first embodiment according to the present invention, illustrating a sphere shaped crystal is obtained by adding propionaldehyde to an uranium solution containing 0.5mmol of tetravalent uranium and placing the uranium solution with propionaldehyde in the autoclave in which the temperature is at 200 degrees Celsius for 30 minutes.

### (Example 13)

Referring to Figs. 36, an example of the method for manufacturing uranium dioxide particles having a spherical shape, according to a first embodiment of the present invention will be explained.

In this example, at S100, uranium solution containing 0.5mmol of tetravalent uranium is prepared. Then 0.3mL of propionaldehyde is added to prepare 3mL of the aqueous solution. This aqueous solution is housed in the cell, and the cell is sealed by covering the opening of the cell of the reactor 100. Then, the temperature controller 20 of the reaction apparatus 100 controls the heating rods, 14a, 14b, 14c, 14d to have 100 degrees Celsius of the temperature. Next, at S108, the state reached at the S106 is maintained for 30 minutes. At S110, the temperature of the reactor 10 is cooled quickly and the pressure of the reactor 10 is lowered such that the condition in the cell 12 becomes to be a low temperature and low pressure condition. And at S112, the solid phase is collected.

In this example, in contrast to examples 1 to 10, uranium solution containing 0.5mmol of tetravalent uranium is prepared at S100. Therefore, hydrothermal reaction including hydrolysis reaction (14), the oxide reaction (15) and dehydration reaction (16) proceed at S108. When the oxidation number of the actinide is larger than 4, the actinide can be reduced to be tetravalent by progress of the reduction reaction represented by chemical reaction equation (10).

Fig. 37 is a diagram illustrating a photo taken with the scanning electron microscope (SEM), in the method of the first embodiment according to the present invention, illustrating a sphere shaped crystal is obtained by adding propionaldehyde to an uranium solution containing 0.5mmol of tetravalent uranium and placing the uranium solution with propionaldehyde in the autoclave in which the temperature is at 100 degrees Celsius for 30 minutes.

Fig. 38 is a diagram explaining a abstract of the principle in which, in a method for manufacturing an actinide oxide particle having a fluorite crystal structure and having a predetermined shape and a predetermined size, a crystal of actinide oxide having the predetermined shape and size.

The water shows a large dielectric constant such as of 78 at room temperature. The dielectric constant is generally a dominant factor for the phase behavior, equilibrium reactions, reaction rate, and solubility, and water acts as a high dielectric constant polar media because water has a large dielectric constant. One of the reasons is that water forms hydrogen bonds between molecules, and forms the structure of large clusters. As increasing temperature, the greater the kinetic energy of water thereby molecules cluster structure of liquid water is broken, and the dielectric constant decreases. The dielectric constant of hot water including supercritical water may be about 2 to 10, which are the same order with the polar organic solvent. This large decrease in the dielectric constant, may lead to a high rate of hydrolysis reaction.
Meanwhile, the movement of molecules in the liquid state may be in a relatively free state in which molecules can move free in time and spatially, despite the force due to interaction with other molecules. Whether or not a molecule can be dissolved in water may be determined from whether the molecules can relatively move free and can diffuse with each other while a molecules may be subjected from intermolecular interaction between molecules as solute and molecules of water as solvent. When water is heated to have a high temperature and pressurized to have a high pressure to increase the contribution of intermolecular interactions in comparison with the kinetic energy of each molecule increases, the solubility of water in general solute may be increased.
In a high temperature and high pressure environment, while showing a high solubility for the solute in general, lower solubility of metal oxides is shown by a smaller dielectric constant and it may possible to produce the metal oxide particles.

Further, under a high temperature and high pressure environment, dissociation of water is significantly increased such as water acts as a strong acid to an aqueous solution of a metal salt, the metathesis reaction of the metal salt or hydrolysis reaction of metal salt may proceed very readily. In addition, under the subcritical or supercritical conditions, fluid properties such as the ionic product, the dielectric constant, the diffusion rate, the thermal conductivity may change significantly, and it is possible to easily control the size and/or the shape of the metal oxide particle may be controlled by controlling the reaction pathways and kinetics. In addition, under the subcritical or supercritical conditions, because the thermal conductivity may be large compared to the gas phase, it is possible that the diffusion coefficient can become to be quite large when compared to the liquid phase. Therefore, it is possible to realize an uniform reaction condition in the reactor, and it is possible to suppress the broadening of the distribution and the variations of the distribution of particle shape and size due to the temperature gradient, pressure gradient, the variations in concentration.

In general, an actinide can have the oxidation number different from 4. For example, if the actinides uranium, in addition to uranium dioxide, uranium trioxide, triuranium octoxide and etc. may exist.
In general, actinide such as thorium, protactinium, uranium, neptunium, plutonium, americium, curium can form actinide dioxide having a fluorite crystal structure. Accordingly, herein, "actinide oxides having a fluorite crystal structure" may include the actinide dioxide.

However, a hydrothermal synthesis reaction may proceed in an actinide aqueous solution by mixing an organic material into the actinide solution and placing the actinide solution with the organic material under high temperature and high pressure environment, so that crystal of actinide oxide having a fluorite crystal structure can be selectively manufactured.

When the hydrothermal reaction mentioned above is progressed in the actinide solution containing organic material, a size and/or shape of a product, that is, crystal of actinide oxide can be controlled because the organic material may work as surface modifier.
That is, the organic matter can be chemically bonded to the surface of the nucleus of the oxide actinide, wherein the nucleus may be produced as the outcome of the nucleation process in actinide aqueous solution, and the size and shape of the crystal of actinide oxide can be controlled in the crystal growth process occurring subsequent to the nucleation process.
Of course, the size and shape of the crystal of actinide oxide that are generated as a result of hydrothermal reaction may depend on not only the type of organic material to be added, but also other condition such as the acidity of the aqueous actinides (the value of pH).

According to this embodiment, the hydrothermal synthesis reaction represented as the chemical reaction equations (14)-(16) or (17)-(19) should be progressed by adding an organic material in tot an actinide aqueous solution and placing the actinide solution with the organic material under a high temperature and high pressure environment whose temperature higher than or equal to 100 degrees Celsius.
Preferably, the hydrothermal synthesis reaction represented as the chemical reaction equations (14)-(16) or (17)-(19) should be progressed by placing the actinide solution with the organic material in an autoclave and adjusting the temperature in the autoclave to a temperature higher than or equal to 100 degrees Celsius. It is possible to selectively manufacture an crystal of actinide oxide or an actinide oxide particle having the fluorite crystal structure and having a predetermined size and a predetermined shape not only by placing the actinide solution with the organic material in an autoclave and adjusting the temperature in the autoclave to a temperature higher than or equal to 100 degrees Celsius, but also by placing the actinide solution with the organic material under a high temperature and high pressure environment which may depend on the volume of the autoclave and the volume of the solution to ensure that the hydrothermal reaction may proceed.

According to such a method, the hydrothermal synthesis reaction should be progressed while the organic material may work as an additive agent or a surface modifier during the hydrothermal reaction by mixing an actinide solution and an organic material and placing the uranium solution with the organic material, so that it is possible to selectively manufacture an crystal of actinide oxide or an actinide oxide particle having the fluorite crystal structure and having a predetermined size and a predetermined shape.
In particular, according to such a method, it can be provided a method and apparatus for manufacturing the crystal of the actinide oxide as a fuel for nuclear fission in nuclear power generation, wherein the crystal of the actinide oxide has the fluorite crystal structure and the predetermined size and shape, and to provide the crystal of the actinide oxide has the fluorite crystal structure and the predetermined size and shape using the method and the apparatus.

### (Second Embodiment)

Referring to Figure 39-40, a second embodiment of the invention will be explained.
In the present embodiment, it can be provided a method for separating a fission product, the method including mixing an organic material and actinide solution containing impurities that is not precipitated as carbonate precipitation or hydroxide salt among the nuclei of the nucleus split during the nuclear fission of the fuel in nuclear power generation in hydroxide aqueous solution, and placing the actinide solution with the organic material under high temperature and high pressure environment to retrieve a crystal of actinide oxide as solid phase.

### (General description of the second embodiment)

Fig. 39 is a diagram illustrating a flowchart of a method according to a second embodiment of the present invention for separating a fission product, the method including mixing an organic material and actinide solution containing impurities that is not precipitated as carbonate precipitation or hydroxide salt in hydroxide aqueous solution, and placing the actinide solution with the organic material under high temperature and high pressure environment to retrieve a crystal of actinide oxide as solid phase.

First, at S200, an actinide aqueous solution containing impurities is prepared. Then the process proceeds to S102. The impurity may include as examples, one of alkali metals such as cesium, rubidium, sodium and etc.. In particular, the impurity may refer to fission products other than rare earth metals such as lanthanum, cerium, lutetium, scandium, and yttrium, and platinum group metals such as ruthenium, rhodium, palladium, osmium, iridium, and platinum, alkaline earth metals such as calcium, strontium and barium, which may be dissolved in carbonate aqueous solution and precipitated as hydroxide salt or carbonate salt among the nuclei of the nucleus split during the nuclear fission of the fuel in nuclear power generation.

At S202, an organic material is added to the actinide aqueous solution prepared at S200.

At S204, the actinide aqueous solution containing the organic material is housed in the cell 12 of the reactor 100 shown in Fig. 1, and the opening of the cell 12 is covered by the cover plate 16 to seal the cell 12. Then the process proceeds to S206.

At S206, the actinide aqueous solution containing the organic material is heated and pressurized to change it to a high temperature and high pressure state. Then the process proceeds to S208.

At S208, the state reached at the S106 is maintained for a predetermined time. Then the process proceeds to S210.

At S210, the temperature of the reactor 10 is cooled quickly and the pressure of the reactor 10 is lowered such that the condition in the cell 12 becomes to be a low temperature and low pressure condition. A room temperature and atmospheric condition may be exemplified as the low temperature and low pressure condition. Then the process proceeds to S212.

At S212, the solid and liquid phases are collected, respectively. Uranium dioxide or cerium dioxide is deposited on the solid phase.

That is, according to this embodiment, a method for separating a fission product, the method including mixing an organic material and actinide solution containing impurities that is not precipitated as carbonate precipitation or hydroxide salt among the nuclei of the nucleus split during the nuclear fission of the fuel in nuclear power generation in hydroxide aqueous solution, and placing the actinide solution with the organic material under high temperature and high pressure environment to retrieve a crystal of actinide oxide as solid phase, the method including:
(a) preparing the actinide solution including impurities;
(b) mixing an additive that includes the organic material into the actinide solution including impurities;
(c) adding water into the actinide solution including the additive to generate an additive-included actinide solution;
(d) placing the additive-included actinide solution in an autoclave;
(e) increasing the temperature in the autoclave in which the additive-included actinide solution is placed to a predetermined value;
(f) quenching the temperature in the autoclave in which the additive-included actinide solution is placed to a room temperature;
(g) collecting a solid phase in the additive-included actinide solution; and
(h) drying the collected solid phase under reduced pressure to retrieve a the crystal of the actinide oxide.
Here, the actinide aqueous solution preferably is an actinide carbonate aqueous solution.

In general, when spent fuel of nuclear power generation is dissolved in aqueous carbonate, while many fission products such as rare earth metals, platinum group metals, alkaline earth metals and etc., may be precipitated as hydroxide precipitation or carbonate precipitation, a specific carbonate complex corresponding to an actinide is formed and dissolved in the actinide solution, and an alkali metal such as sodium, cesium, rubidium, and etc., may also be dissolved similar to the actinide.
According to this embodiment, by utilizing the difference between solubilities of the actinide oxide and alkali metals in the high temperature and high pressure fluid, crystal of the actinide oxide having a predetermined shape and predetermined size, and having a fluorite crystal structure can be retrieved and alkali metal can be still dissolved in the solution, and it is possible to separate alkali metal form an aqueous solution in which rare earth metals, platinum group metals, alkaline earth metals and etc. have been separated from spent nuclear fuel of nuclear power generation, so that fission products (FP) separation can be performed simply and efficiently.

In general, when spent nuclear fuel of nuclear power is dissolved in a carbonic acid solution, many species of fission products such as rare earths, platinum group metals, and alkaline earth metals may be deposited as hydroxide precipitate or carbonate, and may be dissolved in solution by forming a specific actinide carbonate complexes. However, it has been known that, alkali metals such as cesium, rubidium, and sodium can be dissolved in solution, similar to the case of actinide.

According to this embodiment, by utilizing the difference between solubilities of the actinide oxide and alkali metals in the high temperature and high pressure fluid, crystal of the actinide oxide having a predetermined shape and predetermined size, and having a fluorite crystal structure can be retrieved and alkali metal can be still dissolved in the solution, and it is possible to separate alkali metal form an aqueous solution in which rare earth metals, platinum group metals, alkaline earth metals and etc. have been separated from spent nuclear fuel of nuclear power generation.

Hereinafter, referring to the drawings, a method according to a second embodiment of the present invention for separating a fission product, the method including mixing an organic material and actinide solution containing impurities that is not precipitated as carbonate precipitation or hydroxide salt in hydroxide aqueous solution, and placing the actinide solution with the organic material under high temperature and high pressure environment to retrieve a crystal of actinide oxide as solid phase will be explained

### (Example 14)

In this example, the sodium-22 and cesium-137 are separated by adding ethanol to the uranyl nitrate solution containing the cesium-137 and extracting the uranium dioxide as a solid phase.

At S200, 0.5mL of a uranyl nitrate solution including 1.0mol of uranyl nitrate, and further including about 0.25MBq of sodium-22, and about 0.24MBq cesium-137 is prepared. Then the process proceeds to S202.

At S202, 0.85mL of a mixed aqueous solution including 1.8mol of sodium carbonate and sodium bicarbonate is added to the uranyl nitrate solution prepared at S200. Further, an ethanol aqueous solution including 10 vol% of ethanol is added to the uranyl nitrate solution prepared at S202 to prepare 2.9mL of the solution. Further, 0.02mL of a sodium nitrate aqueous solution and 0.06mL of a cesium nitrate aqueous solution are added to the uranyl nitrate solution to prepare 3.0mL of the solution. The sodium nitrate aqueous solution and the cesium nitrate aqueous solution include carrier-free radioactive isotopes. Then the process proceeds to S204.

At S204, the actinide aqueous solution containing the organic material is housed in the cell 12 of the reactor100 shown in Fig. 1, and the opening of the cell 12 is covered by the cover plate 16 to seal the cell 12. Then the process proceeds to S206.

At S206, the actinide aqueous solution containing the organic material is heated and pressurized to change it to a high temperature and high pressure state. Specifically, the temperature controller 20 of the reaction apparatus 100 controls the heating rods, 14a, 14b, 14c, 14d to have, for example, 450 degrees Celsius of the temperature so that the aqueous solution in the cell 12 becomes to be hot. When the aqueous solution is evaporated as the temperature of the aqueous solution becomes hot such that steam is generated and the steam applies pressure on a interface between the aqueous solution and the vapor, it is possible to increase the partial pressure of the aqueous solution by the vapor. Then the process proceeds to S208.

At S208, the state reached at the S106 is maintained for a predetermined time, for example, 30 minutes. Then the process proceeds to S210.

At S210, the temperature of the reactor 10 is cooled quickly and the pressure of the reactor 10 is lowered such that the condition in the cell 12 becomes to be a low temperature and low pressure condition. A room temperature and atmospheric condition may be exemplified as the low temperature and low pressure condition Then the process proceeds to S212.

At S212, the solid and liquid phases are collected, respectively.

Fig. 40 is a diagram illustrating a result of measuring y-rays of crystal of actinide oxide retrieved as the solid phase at S212 by a Ge detector.

In general, the decontamination factor (DF) is defined as a value that is obtained by dividing the radioactivity of an aqueous solution before placing it under high temperature and high pressure environment, the aqueous solution being obtained by mixing an actinide aqueous solution and an organic material, by the radioactivity of solid phase of the aqueous solution after placing it under high temperature and high pressure environment, in the method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material. That is, DF is defined as
DF=(radioactivity in the precipitate)/(radioactivity in the precipitate + radioactivity in the aqueous solution).
In other words, in this embodiment, it is assumed that the volume spent nuclear fuel decontamination before treatment equals to the volume of the solid oxide obtained in S212.

When the DF value is estimated from Fig. 40, it may be found that the DF of sodium-22 is 22.3 and the DF of cesium-137 is a value as high as 278. Therefore, according to the present embodiment, the method including mixing an organic material and actinide solution containing fission product, and placing the actinide solution with the organic material under high temperature and high pressure environment to retrieve a crystal of actinide oxide as solid phase while the fission product remains in the liquid phase. In other words, it is possible to separate the fission product.

### (Examples 15 to 17)

In the example 15, except that 20 vol% of ethanol is added at S202 instead of 10 vol%, experimental conditions are the same with those in the example 14.

When the DF value is estimated in this case, it may be found that the DF of sodium-22 is 35.8 and the DF of cesium-137 is a value as high as 426.

In example 16, except that the heating rods, 14a, 14b, 14c, 14d are heated to have 500 degrees Celsius instead of 450 degrees Celsius at S206, experimental conditions are the same with those in the example 14.

When the DF value is estimated in this case, it may be found that the DF of sodium-22 is 72.7 and the DF of cesium-137 is 198.

In example 17, except that the heating rods, 14a, 14b, 14c, 14d are heated to have 390 degrees Celsius instead of 450 degrees Celsius at S206, experimental conditions are the same with those in the example 14.

When the DF value is estimated in this case, it may be found that the DF of sodium-22 is 10.9 and the DF of cesium-137 is 195.

The results of examples 14 to 17 above can be summarized in following
table.

**[Table 2]**

| | DF of cesium-137 | | DF of sodium-22 is 10.9 | |
|---|---|---|---|---|
| Reaction temp, (Celsius) | amount of ethanol | | amount of ethanol | |
| | 10vol% | 20vol% | 10vol% | 20viol% |
| 390 | 195 | | 10.9 | |
| 450 | 278 | 426 | 22.3 | 35,8 |
| 500 | 198 | | 72.7 | |

According to table 2, the method including mixing an organic material and actinide solution containing fission product, and placing the actinide solution with the organic material under high temperature and high pressure environment to retrieve a crystal of actinide oxide as solid phase while the fission product remains in the liquid phase. In other words, it is possible to separate the fission product.

### (Examples 18 to 21)

In the example 18, except that ammonium carbonate is added at S202 instead of sodium carbonate, experimental conditions are the same with those in the example 14.

When the DF value is estimated in this case, it may be found that the DF of sodium-22 is 3.64 the DF of cesium-137 is a value as high as 44.4.

In the example 19 except that 20vol% of ethanol is added at S202 instead of 10ol%, experimental conditions are the same with those in the example 18.

When the DF value is estimated in this case, it may be found that the DF of sodium-22 is 2.92 the DF of cesium-137 is 39.3.

In example 20, except that the heating rods, 14a, 14b, 14c, 14d are heated to have 390 degrees Celsius instead of 500 degrees Celsius at S206, experimental conditions are the same with those in the example 18.

When the DF value is estimated in this case, it may be found that the DF of sodium-22 is 3.11 the DF of cesium-137 is 31.2.

In example 21, except that the heating rods, 14a, 14b, 14c, 14d are heated to have 390 degrees Celsius instead of 450 degrees Celsius at S206 in the example 18, experimental conditions are the same with those in the example 18.

When the DF value is estimated in this case, it may be found that the DF of sodium-22 is 5.19 the DF of cesium-137 is 302.

The results of examples 14 to 17 above can be summarized in following table.

**[Table 3]**

| Reaction temp. (Celsius) | DF of cesium-137 | | DF of sodium-22 is 10.9 | |
|---|---|---|---|---|
| | amount of ethanol | | amount of ethanol | |
| | 10vol% | 20vol% | 10vol% | 20vol% |
| 390 | 302 | | 5.19 | |
| 450 | 44.4 | 39.3 | 3.64 | 2.92 |
| 500 | 31.2 | | 3.11 | |

According to table 3, the method including mixing an organic material and actinide solution containing fission product, and placing the actinide solution with the organic material under high temperature and high pressure environment to retrieve a crystal of actinide oxide as solid phase while the fission product remains in the liquid phase. In other words, it is possible to separate the fission product.

When the results shown in table 3 obtained by using ammonium carbonate as an additive are compared with the results shown in table 2 obtained by using sodium carbonate as an additive, in general, the results obtained by using ammonium carbonate as an additive have higher value of the DF. Therefore, sodium carbonate is preferable as the additive.

According to such a method, it is possible to selectively manufacture an crystal of actinide oxide or an actinide oxide particle having the fluorite crystal structure according to the present invention, the method including mixing the actinide solution and an organic material; placing the actinide solution mixed with the organic material under high temperature and high pressure environment to progress the hydrothermal reaction while the organic material may work as an additive agent or a surface modifier during the hydrothermal reaction; and cooling the actinide solution mixed with the organic material, wherein the actinide oxide particle having a fluorite crystal structure has at least one of a predetermined size and a predetermined shape.
In particular,according to such a method, it can be provided a method and apparatus for manufacturing the crystal of the actinide oxide as a fuel for nuclear fission in nuclear power generation, wherein the crystal of the actinide oxide has the fluorite crystal structure and the predetermined size and shape, and to provide the crystal of the actinide oxide has the fluorite crystal structure and the predetermined size and shape using the method and the apparatus.

According to other embodiment of a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material, wherein a value of decontamination factor (DF) that is defined a value obtained by dividing a first radioactivity of an aqueous solution that is obtained by mixing the actinide solution that includes the impurity and the organic material before placing the aqueous solution under the high temperature and high pressure environment, by a second radioactivity of a solid phase in the aqueous solution after placing the aqueous solution under the high temperature and high pressure environment, depend on a temperature at which the aqueous solution that is obtained by mixing the actinide solution that includes the impurity and the organic material is placed. Therefore, the value of DF can be increased by controlling temperature at which the aqueous solution that is obtained by mixing the actinide solution that includes the impurity and the organic material is placed.

Moreover, in this embodiment, it is possible to obtain the same effects and advantages as those obtained in the first embodiment.

### (Third Embodiment)

Referring to Figs. 41-56, a method for manufacturing actinide oxide crystals or actinide oxide particles having a fluorite crystal structure continuously will be explained.
In this embodiment, it is provided a method for manufacturing actinide oxide crystals or actinide oxide particles having the fluorite crystal structure and the predetermined size and shape and having a fluorite crystal structure and continuously, including mixing a solution obtained by adding propionaldehyde in a solution uranium solution containing tetravalent uranium.

### (General description of the third embodiment)

Fig. 41 is a diagram illustrating a flow-type apparatus 200 that is used in a method for manufacturing an actinide oxide particle having a fluorite crystal structure and having a predetermined shape and a predetermined size, a crystal of actinide oxide having the predetermined shape and size.

The flow-type actinide oxide particles manufacturing apparatus 200 includes a first and second pump 122, 112, a heater 124, a mixing nozzle 130, a cooler 140, particulate filter 150, and a back pressure valve 160.

The first pump 122 drifts and pressurize distilled water,and the pressurized distilled water is heated to supply it to the mixing nozzle 130.

The heater 124 heats the pressurized distilled water supplied form the first pump 122 to supply it to the mixing nozzle 130. The flow rate continuously supplied to the mixing nozzle 130 by the first pump 122 is 2.5mL per minute, for example.

On the other hand, the second pump 112 drifts and pressurize actinide solution, and the pressurized actinide solution is supplied to the mixing nozzle 130. The flow rate continuously supplied to the mixing nozzle 130 by the second pump 112 is 2.5mL per minute, for example.

The mixing nozzle 130 includes a first and second inlet and am outlet. The distilled water that is a high temperature and high pressure water obtained by heating and pressurizing distilled water using the first pump 122 and the heater 124 is introduced at the first inlet. The pressurized actinide solution that is obtained by pressurizing actinide solution using the second pump 112 is introduced. The inside of the mixing nozzle 130 is configured such that fluids introduced from the first and second inlet are mixed and directed to the outlet.

The outlet of the mixing nozzle 130 connects to one end of the pipe 135. The other end of the pipe 135 is connected to the cooler 140. The actinide solution mixed and the high temperature and high pressure water mixed with each other at the mixing nozzle 130 are introduced to the cooler 140 while reactions proceed in the pipe 135. The pipe 135 includes incubating means configured to not change the temperature of the fluid passing through its interior.

The mixing nozzle 130 may comprise a thermometer to measure the temperature of the fluid through it.

In the cooler 140, a mixed fluid that is formed by mixing the high temperature and high pressure water and the actinide solution flowing through the pipe 135 is quenched (cooled quickly) to at least room temperature. The cooled fluid is fed into the particle filter 150.

The particle filter 150 captures the solid contained in the cooled fluid, and the liquid passes through the particulate filter 150 and fed into the back pressure valve 150.

The back pressure valve 150 controls the pressure in the path between the first and second pumps 122, 112, and the back pressure valve 150. Specifically, the pressure in the path between the first and second pumps 122, 112, and the back pressure valve 150 can be controlled to be 30MPa.

In the flow-type actinide oxide particles manufacturing apparatus 200 configured as mentioned above, distilled water is heated and pressurized by the first and second pumps 122, 112 and heater 124 to become subcritical or supercritical water.

Moreover, by configuring the flow-type actinide oxide particles manufacturing apparatus 200 as mentioned above, it is possible to independently control the temperature and pressure of distilled water.

Further, it is preferable that an angle between a fluid velocity vector of the high temperature and high pressure fluid introduced from the first inlet and a fluid velocity vector of an actinide aqueous solution introduced from the second inlet is an obtuse angle.
The word "an angle between a fluid velocity vector of the high temperature and high pressure fluid introduced from the first inlet and a fluid velocity vector of an actinide aqueous solution introduced from the second inlet" ay have a following means. That is, because the high temperature and high pressure water and the actinide aqueous solution are met in the mixing nozzle, the end points of the fluid velocity vector of the high temperature and high pressure fluid and the fluid velocity vector of the actinide aqueous solution are coincided with each other, and the fluid velocity vector of the high temperature and high pressure fluid and the fluid velocity vector of the actinide aqueous solution may define a plane on which the angle therebetween can be defined. Hence, the above word means that in this plane, the angle between the fluid velocity vector of the high temperature and high pressure fluid and the fluid velocity vector of the actinide aqueous solution is an obtuse angle.

When the mixing nozzle 130 is configured as described above, a fluid mixture formed by mixing a high temperature and high pressure water and an actinide solution can have a low Reynolds number. The density of the high temperature and high pressure water may be for example, about 350kg/m3, and the density of the actinide aqueous solution may be for example, about 1000kg/m3. Although a fluid mixture formed by mixing such fluids is easy to form a turbulent state, the mixing nozzle 130 configured as described above can ensure to mix the high temperature and high pressure water and the actinide aqueous solution surely because laminar flow may be formed instead of turbulence.

The actinide aqueous solution with the organic material can be heated by mixing with the high temperature and high pressure water. Further, if the oxidation number of actinide oxide is smaller than or equal to 4, when the actinide aqueous solution with the organic material and the high temperature and high pressure water are mixed, the temperature and/or pressure of the fluid mixture can be easily controlled such that the hydrothermal synthesis reaction represented as chemical reaction equations (14)-(16) or chemical reaction equations (17)-(19) may proceed selectively.

The distance L between a point where high temperature and high pressure water and an actinide aqueous solution may be met and the cooler 140 in which the fluid mixture formed by mixing the high temperature and high pressure water and the actinide aqueous solution may be cooled can vary as the length of the pipe 135 varies. This means that by varying the length of 135 pipe, the reaction time of the hydrothermal synthesis reaction represented as chemical reaction equations (14)-(16) or (17)-(19) can be controlled.
Therefore, because the hydrothermal reaction to proceed continuously, it is possible to manufacture actinide oxide crystals or actinide oxide particles having the fluorite crystal structure and the predetermined size and shape and having a fluorite crystal structure selectively and continuously.

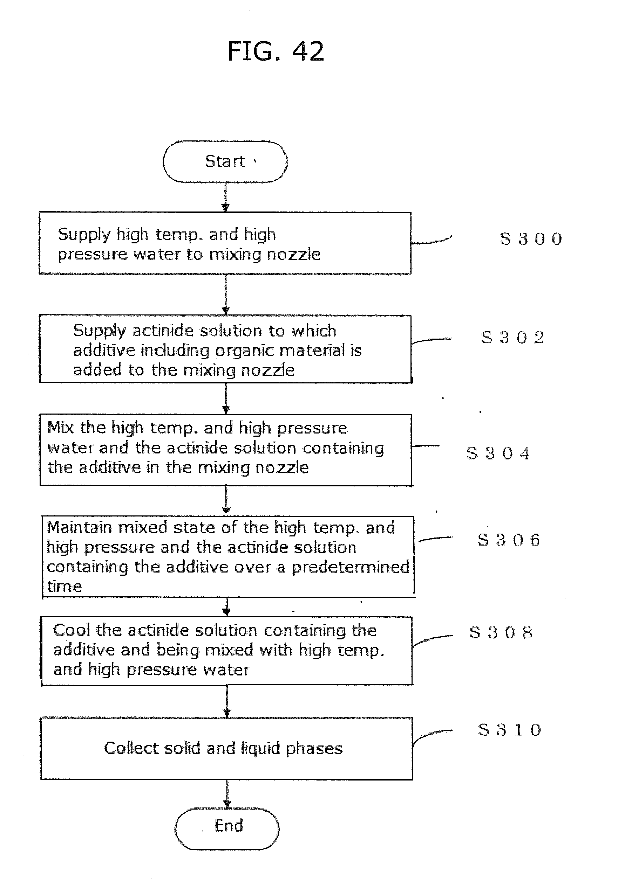

Fig. 42 is a diagram showing a flowchart of the process according to the third embodiment of the invention. The steps shown in Fig. 42 may be performed by using the flow-type actinide oxide particles manufacturing apparatus 200.

At S300, high temperature and high pressure water is continuously supplied to the mixing nozzle 130. In more detail, using the flow-type actinide oxide particles manufacturing apparatus 200, prepared distilled water is passed through the first pump and the heater 124 to become high temperature and high pressure water and the high temperature and high pressure water is continuously supplied to the mixing nozzle 130. The temperature of distilled water can be adjusted to a desired value independent of the pressure by controlling the heater 124.

At S302, the prepared actinide aqueous solution containing an additive including an organic material is supplied to the mixing nozzle 130 via the second pipe.

S302 and S300 may be progressing in parallel.

At this time, the back pressure valve 160 is controlled to control the high temperature and high pressure water and the actinide aqueous solution.

At S304, the high temperature and high pressure water supplied to the mixing nozzle 130 continuously at S300 and the actinide aqueous solution supplied to the mixing nozzle continuously at S302 are mixed to generate a fluid mixture. And then, the process proceeds to S306. The actinide aqueous solution is placed under a high temperature and high pressure environment after it is mixed with the high temperature and high pressure water.

At S306, the fluid mixture formed at S304 is held under the high temperature and high pressure environment over a predetermined amount of time. The amount of time over which the fluid mixture is placed under the high temperature and high pressure environment can be controlled by varying the distance L and the fluid velocity, the distance L being defined as a distance between a point where high temperature and high pressure water and an actinide aqueous solution may be met and the cooler 140 in which the fluid mixture formed by mixing the high temperature and high pressure water and the actinide aqueous solution may be cooled. While the velocity of fluid mixture may depend on the performance of the first and second pumps, the structure of the mixing nozzle, and the area of the cross section of the pipe 135, and etc., once these are determined, it is possible to control the amount of time over which the fluid mixture is placed under the high temperature and high pressure environment. And then the process proceeds to S308.

At S310, the fluid mixture formed from the high temperature and high pressure water and the actinide aqueous solution is cooled. The cooling of the fluid mixture may be performed using the cooler 140. And then the process proceeds to S310.

At S310, the solid and liquid phases are collected. The cooled fluid mixture may pass through the particle filter 150 to collect the solid phase. The remaining fluid after the fluid mixture passes through the particle filter 150 may be the liquid phase.

That is, a method for manufacturing an actinide oxide particle having a fluorite crystal structure according to the invention, the method including mixing an actinide solution and an organic material; placing the actinide solution mixed with the organic material under high temperature and high pressure environment; and cooling the actinide solution mixed with the organic material includes:
(i) preparing the actinide solution that includes actinide salt or actinide complex;
(ii) mixing the organic material into the actinide solution;
(iii) preparing water;
(iv) pressurizing actinide solution containing the organic material;
(v) heating and pressurizing water to generate high temperature and high pressure water;
(vi) mixing the high temperature and high pressure water and the pressurized actinide solution that includes actinide salt or actinide complex;
(vii) cooling the high temperature and high pressure water mixed with the pressurized actinide solution that includes actinide salt or actinide complex;
(viii) collecting a solid phase in the actinide solution including the organic material; and
(ix) drying the collected solid phase under reduced pressure to retrieve a the crystal of the actinide oxide.
According to such a method, when an actinide aqueous solution containing an organic material and high temperatures and pressure water are continuously supplied, crystals of actinide oxide having a fluorite crystal structure can be continuously manufactured.

Furthermore, according to such a method, it is possible to continuously and selectively manufacture crystals of actinide oxide having a fluorite crystal structure and having a predetermined size and/or a predetermined shape by controlling hydrothermal synthesis conditions such as the temperature and the pressure of a high temperature and high pressure water and fluid conditions such as flow amount, flow rate.

Hence, because the hydrothermal reaction proceeded by adding an organic material into the aqueous actinide solution in which the actinide is tetravalent and placing the actinide solution with the organic material under a high temperature and high pressure environment while the organic material may work as an additive agent or a surface modifier during the hydrothermal reaction, it is possible to selectively manufacture an crystal of actinide oxide or an actinide oxide particle having the fluorite crystal structure and having a predetermined size and a predetermined shape.

Hereinafter, referring to Figs 43-56, a method according to the third embodiment of the present invention for manufacturing actinide oxide crystals or actinide oxide particles having a fluorite crystal structure continuously will be explained

### (Example 22)

Referring to Figs. 43-45, using he method according to the third embodiment, an example for manufacturing crystals each having 0.14µm of the crystal size, including mixing a solution obtained by adding propionaldehyde to uranium solution containing tetravalent uranium and a surepcritical water such that the hydrothermal reaction proceeded proceeds over about 3.5 seconds.

In this example, the flow-type actinide oxide particles manufacturing apparatus 200 is configured such that the diameter of the pipe 135 is 0.12cm, and the distance L being defined as a distance between a point where high temperature and high pressure water and an actinide aqueous solution may be met and the cooler 140 in which the fluid mixture formed by mixing the high temperature and high pressure water and the actinide aqueous solution may be cooled is 10.5cm, and the fluid velocity of the fluid mixture along the longer axis of the pipe 135 is 8.5mL/minute.

In this example, at S300, supercritical water having 390 degrees Celsius and 30Mpa is supplied to the mixing nozzle 130 continuously. At S302, propionaldehyde having the density 5.7mol/L is added to uranium solution having the tetravalent uranium density 50mmol/L, and the uranium solution containing the organic material is supplied to the mixing nozzle 130 continuously. The fluid mixture formed by mixing the high temperature and high pressure water and the uranium solution containing the organic material in the mixing nozzle at S304 is held at a high temperature and high pressure condition over 3.4 seconds in the pipe 135 at S306. The, at S306, the fluid mixture is cooled using the cooler 140. At S310, the fluid mixture cooled at S306 passes through the particle filter 150 and the solid phase and the liquid phase are collected separately.

Fig. 43 is a diagram illustrating a photo of the particle collected as the solid phase at S310 taken with the scanning electron microscope (SEM). Magnification of the electron microscopy is 10,000.
It can be seen that fine particles are produced based on this figure.

Fig. 44 is a diagram illustrating an analytical result of the dried solid collected at S310 obtained by using an energy dispersive X-ray apparatus. It can be seen that uranium dioxide shown in Fig. 43 contains uranium and oxygen, and also contains few impurities.

Fig. 45 is a diagram illustrating an evidence that the diameter of the particles shown in Fig. 43 has substantially constant value, i.e., 0.14µm.

### (Example 23 to 25)

The configurations of flow-type actinide oxide particles manufacturing apparatuses 200 used in the examples 23-25 are compared and summarized in the following table 4.

**[Table 4]**

| Example | Inner diameter of pipe 135 [cm] | Distance L [cm] | Fluid velocity of fluid mixture in pipe 135 [cm/min.] | Reaction time [sec] | Figs. illustrating, results |
|---|---|---|---|---|---|
| 22 | 0.12 | 10.5 | 8.5 | 3.4 | Figs. 43-45 |
| 23 | 0.12 | 60,5 | 8.5 | 19.3 | Figs. 46-48 |
| 24 | 0.12 | 60.5 | 5 | 32.8 | Figs. 49-51 |
| 25 | 0.12 | 120 | 5 | 65.1 | Figs. 52-54 |

Figs 46-48 show results of the example 23.
Fig. 46 is a diagram illustrating a photo taken with the scanning electron microscope (SEM), in the method of the third embodiment according to the present invention, illustrating that fine particles can be manufactured by mixing supercritical water and a solution in which propionaldehyde is added to an uranium solution containing tetravalent uranium to progress a hydrothermal reaction over 19.3 seconds.
Fig. 47 is a diagram illustrating results from the energy dispersive x-ray spectroscopy method showing the fine particles shown in Fig. 46 contain uranium and oxygen, and also contain few impurities.
Fig. 48 is a diagram illustrating results from the energy dispersive x-ray spectroscopy method showing the particles shown in Fig. 46 have a nearly constant average diameter of 0.15µm.

Figs 49-51 show the results of the example 24.
Fig. 49 is a diagram illustrating a photo taken with the scanning electron microscope (SEM), in the method of the third embodiment according to the present invention, illustrating that fine particles can be manufactured by mixing supercritical water and a solution in which propionaldehyde is added to an uranium solution containing tetravalent uranium to progress a hydrothermal reaction over about 32.8 seconds.
Fig. 50 is a diagram illustrating results from the energy dispersive x-ray spectroscopy method showing the fine particles shown in Fig. 49 contain uranium and oxygen, and also contain few impurities.
Fig. 51 is a diagram illustrating results from the energy dispersive x-ray spectroscopy method showing the particles shown in Fig. 49 have a nearly constant average diameter of 0.15µm.

Figs 52-54 show the results of the example 24.
Fig. 52 is a diagram illustrating a photo taken with the scanning electron microscope (SEM), in the method of the third embodiment according to the present invention, illustrating that fine particles can be manufactured by mixing supercritical water and a solution in which propionaldehyde is added to an uranium solution containing tetravalent uranium to progress a hydrothermal reaction over about 65.1 seconds.
Fig. 53 is a diagram illustrating results from the energy dispersive x-ray spectroscopy method showing the fine particles shown in Fig. 52 contain uranium and oxygen, and also contain few impurities.
Fig. 54 is a diagram illustrating results from the energy dispersive x-ray spectroscopy method showing the particles shown in Fig. 49 have a nearly constant average diameter of 0.14µm.

Fig. 55 is a diagram illustrating a result obtained by the X-ray diffraction method, in the method of the third embodiment according to the present invention, illustrating that particles which are obtained by a mixing supercritical water and a solution in which propionaldehyde is added to an uranium solution containing tetravalent uranium, include uranium dioxide (UO2) and triuranium octoxide (U3O8), and more than 90% of the products is actinide dioxide when an operation time of the hydrothermal reaction exceed to 65 seconds
In the figure illustrating results of x-ray diffraction method, a peak at 21 degrees is of crystals of triuranium octoxide, and a peak at 28 degrees is of uranium dioxide. The percentage of uranium dioxide contained in the solid phase collected at S310 can be calculated by comparing the areas of the peaks and will be shown in the following table 5.

**[Table 5]**

| Example | Particle size [µm] | Parcentage of uranium dioxide [%] | Maintaining time [sec] |
|---|---|---|---|
| 22 | 0.135 | 37 | 3.4 |
| 23 | 0.145 | 48 | 19.3 |
| 24 | 0.137 | 76 | 32.8 |
| 25 | 0.134 | 92 | 65.1 |

Fig. 56 is a diagram illustrating, in the method of the third embodiment according to the present invention, a percentage of uranium dioxide over the operation time of the hydrothermal reaction in uranium oxide particles which are obtained by a mixing supercritical water and a solution in which propionaldehyde is added to an uranium solution containing tetravalent uranium

According to Fig. 56, it can be understood that one of the controlling factors for manufacturing uranium dioxide continuously mat be the amount of time over which uranium solution containing an organic material is continued to be placed under a high temperature and high pressure environment.

According to such a method, the actinide aqueous solution with the organic material can be heated by mixing with the high temperature and high pressure water, and if the oxidation number of actinide oxide is smaller than or equal to 4, the hydrothermal synthesis reaction represented as chemical reaction equations (14)-(16) may proceed.

According to such a method, the actinide aqueous solution with the organic material can be heated by mixing with the high temperature and high pressure water, and if if the oxidation number of actinide oxide is greater than 4, in addition to a hydrothermal synthesis reaction represented as chemical reaction equations (14)-(16), it is needed that the reduction reaction represented by the chemical equation (20) should proceed.

Furthermore, according to such a method, when an actinide aqueous solution containing an organic material and high temperatures and pressure water are continuously supplied, crystals of actinide oxide having a fluorite crystal structure can be continuously manufactured.

Furthermore, according to such a method, it is possible to manufacture crystals of actinide oxide having a fluorite crystal structure and having a predetermined size and/or a predetermined shape by controlling hydrothermal synthesis conditions such as the temperature and the pressure of a high temperature and high pressure water and fluid conditions such as flow amount, flow rate.

Therefore, according to this embodiment, hydrothermal reaction proceeded by adding an organic material into the aqueous actinide solution in which the actinide is tetravalent and placing the actinide solution with the organic material under a high temperature and high pressure environment while the organic material may work as an additive agent or a surface modifier during the hydrothermal reaction, so that it is possible to selectively manufacture an crystal of actinide oxide or an actinide oxide particle having the fluorite crystal structure and having a predetermined size and a predetermined shape.
In particular, according to such a method, it can be provided a method and apparatus for manufacturing the crystal of the actinide oxide as a fuel for nuclear fission in nuclear power generation, wherein the crystal of the actinide oxide has the fluorite crystal structure and the predetermined size and shape, and to provide the crystal of the actinide oxide has the fluorite crystal structure and the predetermined size and shape using the method and the apparatus.

Moreover, in this embodiment, it is possible to obtain the same effects and advantages as those obtained in the first and second embodiments.

## Claims

1. A method for manufacturing an actinide oxide particle having a fluorite crystal structure, comprising steps of:
mixing actinide solution and an organic material;
placing the actinide solution mixed with the organic material under high temperature and high pressure environment; and
cooling the actinide solution mixed with the organic material.

2. The method according to claim 1, wherein the actinide oxide particle has at least one of a predetermined size and a predetermined shape.

3. The method according to claim 1 or 2, wherein an actinide atom-oxygen ratio in the actinide oxide particle is a predetermined value.

4. The method according to any one of claims 1 to 3, wherein the crystal of the actinide oxide is used as fuel for nuclear fission in nuclear power generation.

5. The method according to any one of claims 1 to 4, wherein the actinide solution mixed with the organic material is mixed with a high temperature and high pressure water to place the actinide solution mixed with the organic material under high temperature and high pressure environment.

6. The method according to any one of claims 1 to 5, wherein the actinide solution is one of thorium aqueous solution, uranium aqueous solution, neptunium aqueous solution, plutonium aqueous solution, americium aqueous solution, curium aqueous solution or a mixture thereof.

7. The method according to any one of claims 1 to 6, wherein the organic material is selected from an alcohol derivative, an aldehyde derivative, a carboxylic acid derivative, an amine derivative, an amino acid derivative, an imine derivative, an amide derivative, a nitrile derivative, and a suger derivative.

8. The method according to any one of claims 2 to 7, wherein the shape of the crystals of actinide oxides depends on the organic material.

9. The method according to any one of claims 2 to 8, wherein the shape of the actinide oxide crystal is one of sphere, cube, rectangular including a plate, oval, polyhedron, bell shaped.

10. The method according to any one of claims 2 to 9, wherein the size of the crystal of the actinide oxide particle is of a fine particle of micrometer order.

11. The method according to any one of claims 1 to 10, wherein the actinide solution contains an impurity, and the crystal of the actinide oxide particle is taken out as a solid crystal.

12. The method according to claim 11, the impurity is an alkali metal and the alkali metal is taken out as a liquid.

13. The method according to claim 11 or 12, wherein the impurity being the alkali metal is one of cesium, rubidium and sodium or mixture thereof.

14. The method according to any one of claims 11 to 13, wherein a value of decontamination factor (DF) that is defined a value obtained by dividing a first radioactivity of an aqueous solution that is obtained by mixing the actinide solution that includes the impurity and the organic material before placing the aqueous solution under the high temperature and high pressure environment, by a second radioactivity of a solid phase in the aqueous solution after placing the aqueous solution under the high temperature and high pressure environment, depend on a temperature at which the aqueous solution that is obtained by mixing the actinide solution that includes the impurity and the organic material is placed.

15. The method according to any one of claims 1 to 14, wherein the actinide solution includes carbonate.

16. The method according to any one of claims 1 to 15, wherein the actinide in the actinide solution is actinide or actinide complexes having a positive oxidation number smaller than or equal to 4, and a hydrothermal synthesis reaction of the actinide oxide proceeds by placing the actinide solution mixed with the organic material.

17. The method according to any one of claims 1 to 15, wherein the actinide in the actinide solution is actinide or actinide complexes having a positive oxidation number larger than 4, and a reduction reaction of the actinide oxide and a following hydrothermal synthesis reaction of the actinide oxide proceed by placing the actinide solution mixed with the organic material.

18. The method according to claim 16 or 17, wherein the hydrothermal synthesis reaction of the actinide oxide proceeds at a temperature higher than or equal to 100 degrees Celsius.

19. The method according to any one of claims 16 to 18, wherein the hydrothermal synthesis reaction of the actinide oxide proceeds at a temperature higher than or equal to 200 degrees Celsius.

20. The method according to any one of claims 16 to 19, wherein the hydrothermal synthesis reaction of the actinide oxide and the reduction reaction of the actinide oxide proceed under a high temperature and high pressure environment in which water is in supercritical or subcritical condition.

21. The method according to any one of claims 1 to 20, wherein an actinide or actinide complex in the actinide solution is uranium ion or uranium complex, and uranium dioxide to be manufactured has an uranium atom-to-oxygen ratio of approximately 2.04.

22. The method according to any one of claims 1 to 4 and 6 to 21, further comprising steps of:
preparing the actinide solution;
mixing an additive that includes the organic material into the actinide solution;
adding water into the actinide solution including the additive to generate an additive-included actinide solution;
placing the additive-included actinide solution in an autoclave;
increasing the temperature in the autoclave in which the additive-included actinide solution is placed to a predetermined value;
quenching the temperature in the autoclave in which the additive-included actinide solution is placed to a room temperature;
collecting a solid phase in the additive-included actinide solution; and
drying the collected solid phase under reduced pressure to retrieve a the crystal of the actinide oxide.

23. The method according to any one of claims 5 to 21, further comprising steps of:
preparing the actinide solution that includes actinide salt or actinide complex;
mixing the organic material into the actinide solution;
preparing water;
heating and pressurizing water to generate high temperature and high pressure water;
mixing the high temperature and high pressure water and the pressurized actinide solution that includes actinide salt or actinide complex;
cooling the high temperature and high pressure water mixed with the pressurized actinide solution that includes actinide salt or actinide complex;
collecting a solid phase in the actinide solution including the organic material; and
drying the collected solid phase under reduced pressure to retrieve a the crystal of the actinide oxide.

24. The method according to claim 23, wherein the high temperature and high pressure water that is obtained by heating and pressurizing water is supercritical water or subcritical water.

25. The method according to claim 23 or 24, wherein the actinide in the actinide solution is actinide or actinide complexes having a positive oxidation number smaller than or equal to 4, and a hydrothermal synthesis reaction of the actinide oxide proceeds by placing the actinide solution mixed with the organic material.
